# EUROPÄISCHE PATENTSCHRIFT

(11) **EP 3 108 339 B1**
(45) Veröffentlichungstag und Bekanntmachung des Hinweises auf die Patenterteilung: **18.03.2020**
(21) Anmeldenummer: 15707871.8
(22) Anmeldetag: 23.02.2015
(51) Int. Cl.: G06F 3/0362, H03K 17/965

(54) **SCHALTVORRICHTUNG, VERWENDUNG DER SCHALTVORRICHTUNG, ARBEITSSYSTEM SOWIE ARBEITSVERFAHREN**
SWITCH DEVICE, USE OF THE SWITCH DEVICE, OPERATING SYSTEM, AND OPERATING METHOD
DISPOSITIF DE COMMUTATION, UTILISATION DU DISPOSITIF DE COMMUTATION, SYSTÈME DE TRAVAIL AINSI QUE PROCÉDÉ DE TRAVAIL

(30) Priorität: 21.02.2014 DE 102014002534; 24.02.2014 DE 102014002382
(43) Veröffentlichungstag der Anmeldung: 28.12.2016
(73) Patentinhaber: Fraunhofer-Gesellschaft zur Förderung der angewandten Forschung e.V., 80686 München (DE)
(72) Erfinder: EMMERICH, Jan Sören, 42719 Solingen (DE); HOMPEL, Michael Ten, 44229 Dortmund (DE)
(74) Vertreter: Schatt, Markus F.
(86) Internationale Anmeldenummer: PCT/EP2015/000408
(87) Internationale Veröffentlichungsnummer: WO 2015/124319

(56) Entgegenhaltungen:
- EP-A1- 1 691 263
- DE-A1-102004 017 579
- US-A1- 2009 296 341

## Beschreibung

Die Erfindung betrifft eine Verwendung einer Schaltvorrichtung, ein Arbeitssystem sowie Arbeitsverfahren.

Aus der DE 10 2004 017 579 A1 ist eine Kommissionieranlage für Medikamente und ein Verfahren zum Kommissionieren bekannt, bei dem eine mobile Handheld-Anzeige verwendet wird.

Aus der EP 1 691 263 A1, der US 2009/0296341 A1 und der DE 20 2006 001 717 U1 sind mobile Handgeräte bekannt.

Aufgabe der vorliegenden Erfindung ist, die Verwendung einer elektrischen Schaltvorrichtung, eine Arbeitssystem und ein Arbeitsverfahren bereitzustellen, bei der bzw. bei dem diese auf effiziente Weise als Eingabevorrichtung verwendbar ist.

Diese Aufgabe wird mit den Merkmalen der unabhängigen Ansprüche gelöst. Weitere Ausführungsformen sind in den auf diesen jeweils rückbezogenen Unteransprüchen angegeben.

Nach der Erfindung ist insbesondere eine Schaltvorrichtung vorgesehen, die von einer Betätigungsseite her bedienbar ist, wobei die Schaltvorrichtung aufweist:
- einen plattenförmigen Grundkörper mit einer Anschluss-Oberfläche, die der Betätigungsseite der elektrischen Schaltvorrichtung zugewandt ist,
- ein in einer Dickenrichtung gesehen auf dieser angeordnetes plattenförmiges Betätigungsteil mit einer der der Betätigungsseite zugewandten Betätigungsoberfläche und einer entgegen gesetzt zu dieser gelegenen Anschluss-Oberfläche,
- eine Verbindungsvorrichtung aus einem aus einem elastischen Material, das an einem inneren Bereich der Anschluss-Oberfläche des Betätigungsteils und mit einer zweiten Oberfläche an einem inneren Bereich der Anschluss-Oberfläche des Grundkörpers befestigt ist,
- zumindest ein Sensor, der zwischen dem Grundkörper und dem Betätigungsteil gelegen sowie in der Dickenrichtung gesehen seitlich der Verbindungsvorrichtung gelegen sind, so dass mit jedem Sensor jeweils eine Position eines jeweils an diesem gelegenen Bereichs der zweiten Oberfläche in der Dickenrichtung erfasst werden kann.

Nach einer Ausführungsform der Schaltvorrichtung kann das Betätigungsteil ein Display aufweisen, das in einem in der Dickenrichtung gesehen inneren Bereich der Betätigungsoberfläche des Betätigungsteils gelegen ist.

Durch das Vorsehen der Verbindungsvorrichtung wird Befestigung am Grundkörper erreicht sowie eine lokale Veränderung der Position eines Bereichs des Betätigungsteils relativ zu einem an diesem Bereich jeweils gelegenen Sensor.

Durch die Verbindungsvorrichtung aus elastischem Material wird eine Rückstellfähigkeit der Verbindungsvorrichtung erreicht.

Nach einem Aspekt ist eine Schaltvorrichtung, die von einer Betätigungsseite (S1) her bedienbar ist, vorgesehen, die Schaltvorrichtung (1) aufweisend:
- einen plattenförmigen Grundkörper (10) mit einer Anschluss-Oberfläche (10a), die der Betätigungsseite (S1) der elektrischen Schaltvorrichtung (1) zugewandt ist,
- ein in einer Dickenrichtung (Z) gesehen auf dieser angeordnetes plattenförmiges Betätigungsteil (20) mit einer der der Betätigungsseite (S1) zugewandten Betätigungsoberfläche (20a) und einer entgegen gesetzt zu dieser gelegenen Anschluss-Oberfläche (20b),
- eine Verbindungsvorrichtung (30) mit wenigstens einer Verbindungsschicht (31) aus einem aus einem elastischen Material, das an einem inneren Bereich (20c) der Anschluss-Oberfläche (20b) des Betätigungsteils (20) und mit einer zweiten Oberfläche (30b) an einem inneren Bereich (11) der Anschluss-Oberfläche (10a) des Grundkörpers (10) befestigt ist,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.

Nach einer Ausführungsform der Schaltvorrichtung ist vorgesehen, dass die Verbindungsvorrichtung (30) aus wenigstens einer Verbindungsschicht (31) besteht.

Nach einem weiteren Aspekt ist eine Schaltvorrichtung (1), die von einer Betätigungsseite (S1) her bedienbar ist, vorgesehen, wobei die Schaltvorrichtung (1) aufweist:
- einen plattenförmigen Grundkörper (10) mit einer Anschluss-Oberfläche (10a), die der Betätigungsseite (S1) der elektrischen Schaltvorrichtung (1) zugewandt ist,
- ein in einer Dickenrichtung (Z) gesehen auf dieser angeordnetes plattenförmiges Betätigungsteil (20) mit einer der der Betätigungsseite (S1) zugewandten Betätigungsoberfläche (20a) und einer entgegen gesetzt zu dieser gelegenen Anschluss-Oberfläche (20b),
- eine Verbindungsvorrichtung (30) mit wenigstens einer Verbindungsschicht (31) aus einem aus einem elastischen Material, das an einem äußeren Bereich der Anschluss-Oberfläche (20b) des Betätigungsteils (20) und mit einer zweiten Oberfläche (30b) an einem äußeren Bereich der Anschluss-Oberfläche (10a) des Grundkörpers (10) befestigt ist,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.

Nach einer Ausführungsform der Schaltvorrichtung ist vorgesehen, dass die Verbindungsvorrichtung (30) aus wenigstens einer Verbindungsschicht (31) besteht.

Nach einem weiteren Aspekt ist eine Schaltvorrichtung vorgesehen, die aufweist:
- eine Gehäusevorrichtung (H) mit einem plattenförmigen Grundkörper (10) mit einer Anschluss-Oberfläche(10a), die einer Betätigungsseite (S1) der elektrischen Schaltvorrichtung (1) zugewandt ist, und mit einem Gehäuseteil (H1),
- ein in einer Dickenrichtung (Z) gesehen auf dieser angeordnetes plattenförmiges Betätigungsteil (20) mit einer der der Betätigungsseite (S1) zugewandten Betätigungsoberfläche (20a) und einer entgegen gesetzt zu dieser gelegenen Anschluss-Oberfläche (20b),
- ein in dem Betätigungsteil (20) integriertes Display (80) zur Anzeige von Darstellungen auf der Betätigungsseite (S1), wobei das Gehäuseteil (H1) aufweist: eine Seitenwand (H4), die die Verbindungsvorrichtung (30) und das Betätigungsteil (20) in der Dickenrichtung (Z) gesehen zumindest abschnittsweise umgibt, und ein Randabschnitt (H5), der sich zu der Betätigungsseite (S1) hin an der Seitenwand (H4) anschließt und eine zentrale Öffnung (H7) ausbildet, in der sich zumindest abschnittsweise das Display (80) erstreckt,
- eine Verbindungsvorrichtung (30) mit wenigstens einer Verbindungsschicht (31) aus einem aus einem elastischen Material, das an einem inneren Bereich (20c) der Anschluss-Oberfläche (20b) des Betätigungsteils (20) und mit einer zweiten Oberfläche (30b) an einem inneren Bereich (11) der Anschluss-Oberfläche (10a) des Grundkörpers (10) befestigt ist,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.

Dabei kann die Verbindungsvorrichtung (30) aus wenigstens einer Verbindungsschicht (31) bestehen.

Nach einem weiteren Aspekt ist eine Schaltvorrichtung vorgesehen, die aufweist:
- eine Gehäusevorrichtung (G) mit einem plattenförmigen Grundkörper (10) mit einer Anschluss-Oberfläche (10a), die der Betätigungsseite (S1) der elektrischen Schaltvorrichtung (1) zugewandt ist, und mit einem Gehäuseteil (G1),
- ein in einer Dickenrichtung (Z) gesehen auf dieser angeordnetes plattenförmiges Betätigungsteil (20) mit einer einer Betätigungsseite (S1) zugewandten Betätigungsoberfläche (20a) und einer entgegen gesetzt zu dieser gelegenen Anschluss-Oberfläche (20b),
- ein in dem Betätigungsteil (20) integriertes Display (80) zur Anzeige von Darstellungen auf der Betätigungsseite (S1), wobei das Gehäuseteil (H1) aufweist: eine sich von dem Grundkörper (10) aus erstreckende Seitenwand (H4), die das Betätigungsteil (20) in der Dickenrichtung (Z) gesehen zumindest abschnittsweise umgibt, und ein Randabschnitt (H5), der sich zu der Betätigungsseite (S1) hin an der Seitenwand (H4) anschließt und eine zentrale Öffnung (H7) ausbildet, in der sich zumindest abschnittsweise das Display (80) erstreckt,
- eine Verbindungsvorrichtung (30) mit wenigstens einer Verbindungsschicht (31) aus einem aus einem elastischen Material, das an einem äußeren Bereich der Anschluss-Oberfläche (20b) des Betätigungsteils (20) und mit einer zweiten Oberfläche (30b) an einem äußeren Bereich der Anschluss-Oberfläche (10a) des Grundkörpers (10) befestigt ist,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.

Dabei kann die Verbindungsvorrichtung (30) aus wenigstens einer Verbindungsschicht (31) bestehen.

Nach einem weiteren Aspekt ist eine Schaltvorrichtung vorgesehen, die aufweist:
- einen plattenförmigen Grundkörper (10) mit einer Anschluss-Oberfläche (10a), die der Betätigungsseite (S1) der elektrischen Schaltvorrichtung (1) zugewandt ist,
- ein in einer Dickenrichtung (Z) gesehen auf dieser angeordnetes plattenförmiges Betätigungsteil (20) mit einer einer Betätigungsseite (S1) zugewandten Betätigungsoberfläche (20a) und einer entgegen gesetzt zu dieser gelegenen Anschluss-Oberfläche (20b),
- ein in dem Betätigungsteil (20) integriertes Display (80) zur Anzeige von Darstellungen auf der Betätigungsseite (S1), wobei das Gehäuseteil (H1) aufweist: eine sich von dem Grundkörper (10) aus erstreckende Seitenwand (H4), die das Betätigungsteil (20) in der Dickenrichtung (Z) gesehen zumindest abschnittsweise umgibt, und ein Randabschnitt (H5), der sich zu der Betätigungsseite (S1) hin an der Seitenwand (H4) anschließt, der zumindest abschnittsweise entlang des Umfangs des Betätigungsteils (20) mit diesem verbunden ist und der eine zentrale Öffnung (H7) ausbildet, in der sich zumindest abschnittsweise das Display (80) erstreckt,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.

Nach einer Ausführungsform der Schaltvorrichtung ist vorgesehen,
- dass das Betätigungsteil (20) ein Display (80) aufweist, das in einem in der Dickenrichtung (Z) gesehen inneren Bereich (20e) der Betätigungsoberfläche (20a) des Betätigungsteils (20) gelegen ist.
- dass der innere Display-Bereich (20e) als an der Betätigungsoberfläche (20a) geformte Vertiefung ausgeführt ist und das Display (80) in der Dickenrichtung (Z) gesehenen zumindest teilweise in der Vertiefung gelegen ist.

Nach einer Ausführungsform der Schaltvorrichtung ist vorgesehen, dass das Betätigungsteil (20) zumindest in Flächenanteilen optisch durchsichtig ist und wobei der Grundkörper (10) einen in der Dickenrichtung (Z) gesehen inneren Display-Bereich (10e) aufweist, in dem das Display (80) angeordnet ist, wobei die Lage des inneren Display-Bereichs (10e) nach einem der folgenden Alternativen definiert ist:
- der Display-Bereich (20e) in der Dickenrichtung (Z) gesehen innerhalb eines von den Sensoren (41, 42, 43, 44) aufgespannten Bereichs oder zwischen Sensoren (41, 42, 43, 44) und in der Dickenrichtung (Z) gesehen außerhalb der zumindest einen Verbindungsschicht (31) liegt,
- der Display-Bereich (20e) in der Dickenrichtung (Z) gesehen innerhalb eines von den Sensoren (41, 42, 43, 44) aufgespannten Bereichs oder zwischen Sensoren (41, 42, 43, 44) und in der Dickenrichtung (Z) gesehen zumindest teilweise innerhalb zumindest einer der zumindest einen Verbindungsschicht (31) liegt, wobei die zumindest eine Verbindungsschicht, innerhalb der der Display-Bereich (20e) gelegen ist, optisch durchsichtig ist.

Nach einer Ausführungsform der Schaltvorrichtung ist vorgesehen, dass der innere Display-Bereich (10e) als an der Anschluss-Oberfläche (10a) geformte Vertiefung ausgeführt ist und das Display (80) in der Dickenrichtung (Z) gesehenen zumindest teilweise in der Vertiefung gelegen ist.

Nach einer Ausführungsform der Schaltvorrichtung ist vorgesehen, dass das plattenförmige Betätigungsteil (20) als starres Teil ausgeführt ist.

Nach einer Ausführungsform der Schaltvorrichtung ist vorgesehen, dass das plattenförmige Betätigungsteil (20) als biege-elastisches Teil ausgeführt ist.

Nach einer Ausführungsform der Schaltvorrichtung ist vorgesehen, dass die Schaltvorrichtung (1) jeweils zwei Sensoren (41, 42, 43, 44) aufweist, von denen jeweils zwei in Bezug auf den Flächenschwerpunkt (FS) der Betätigungsoberfläche (20a) einander gegenüber liegend angeordnet sind.

Nach einer Ausführungsform der Schaltvorrichtung ist vorgesehen, dass der zumindest eine Sensor (41, 42, 43, 44) derart ausgeführt ist, dass dieser jeweils berührungslos den Abstand von demselben zu der diesem gegenüber liegenden Stelle der Anschluss-Oberfläche (20b) des Betätigungsteils (20) erfasst.

Nach einer Ausführungsform der Schaltvorrichtung ist vorgesehen, dass der zumindest eine Sensor (41, 42, 43, 44) als optischer Sensor ausgeführt ist.

Nach einer Ausführungsform der Schaltvorrichtung ist vorgesehen, dass der zumindest eine Sensor (41, 42, 43, 44) als induktiver Sensor ausgeführt ist.

Nach einer Ausführungsform der Schaltvorrichtung ist vorgesehen, dass der zumindest eine Sensor (41, 42, 43, 44) als mechanischer Sensoren mit einer Schaltkomponente ausgeführt ist.

Nach einer Ausführungsform der Schaltvorrichtung ist vorgesehen, dass die Schaltvorrichtung eine Anbindung (z. B. über WLAN) an ein Datennetzwerk aufweist,

Nach einer Ausführungsform der Schaltvorrichtung ist vorgesehen, dass über die Datennetzanbindung, nach Auswertung der über die Sensoren (41 bis 44) erfolgten Eingaben einsatzbezogene Dateninhalte (z. B. in Form von Apps) aus einer zentralen Datenbank herunterladbar und auf dem Display 80 darstellbar sind.

Nach einem weiteren Aspekt ist eine Verwendung einer Ausführungsform der Schaltvorrichtung als Vorrichtung zur Eingabe von logistischen Daten in einem Lagerbereich vorgesehen.

Nach einem weiteren Aspekt ist eine Verwendung einer Ausführungsform der Schaltvorrichtung als Vorrichtung zur Eingabe von logistischen Daten und zur Ausgabe von logistischen Daten jeweils in einem Lagerbereich.

Nach einem weiteren Aspekt ist eine Verwendung einer Ausführungsform der Schaltvorrichtung mit einem Display als interaktive Mensch-Maschine-Schnittstelle in der Logistik und anderen industriellen Anwendungen, insbesondere in der Lagerbewirtschaftung und anderen Materialflusssystemen,
- wobei auf dem Display eine Anzahl aufgabenbezogener Alternativen anzeigbar ist,
- wobei über eine Eingabe des Benutzers, die auf Sensoren (41 bis 44) wirkt, eine Auswahl aus den angezeigten Alternativen erfolgt, worauf über die WLAN-Anbindung aus der zentralen Datenbank die nächste Aktion bzw. die nächste zu treffende Auswahl angezeigt wird.

Nach einem weiteren Aspekt ist eine Verwendung einer Ausführungsform der Schaltvorrichtung mit einem Display zur menügeführten Auswahl einer Aufgabe in der Lagerlogistik und in anderen industriellen Anwendungen vorgesehen,
- wobei in der zentralen Datenbank für eine Mehrzahl von Aufgaben Apps verfügbar gehalten werden, die über die Netzwerkanbindung auf dem Display wiedergebbaren Handlungsabfolgen, Alternativen zur aufgabenbezogenen Auswahl und/oder zu notwendigen Eingaben von Informationen anzeigbar machen,
- wobei der Benutzer die zur anstehenden Aufgabe entsprechende App auswählt und diese interaktiv unter Verwendung der Eingabemöglichkeiten über die Sensoren 41 bis 44 sowie unter Beachtung der Darstellungen auf dem Display (80) abarbeitet.

Nach einem weiteren Aspekt ist eine Verwendung einer Schaltvorrichtung mit Eingabemitteln und einem Display zur menügeführten Auswahl einer Aufgabe in einem Arbeitssystem (S) und insbesondere in einer Lagersystem oder einer Produktionsanlage oder anderen industriellen Anwendungen vorgesehen, wobei in einer zentralen Datenbank für eine Mehrzahl von Aufgaben Anwendungsfunktionen (App) verfügbar gehalten werden, die über eine Netzwerkanbindung auf dem Display (80) wiedergebbare Handlungsabfolgen, Alternativen zur aufgabenbezogene Auswahl und/oder zu notwendigen Eingaben von Informationen anzeigbar machen, wobei der Benutzer die zur anstehenden Aufgabe entsprechende Anwendungsfunktionen (App) auswählt und diese interaktiv unter Verwendung der Eingabemittel sowie unter Beachtung der Darstellungen auf dem Display (80) abarbeitet.

Nach einem weiteren Aspekt ist ein Arbeitssystem mit zumindest einer Ausführungsform der Schaltvorrichtung, einem Zentralsystem und mehreren Arbeitsbereich-Teilnehmern vorgesehen, wobei die Schaltvorrichtung (1) eine Ausgangs-Schnittstelle (93) aufweist, über aufgrund der Bereitstellung zumindest eines Steuerungsfelds mittels eines Menü-Steuerungsmodul (96) Aufgabenerfüllungs-Kommandos erzeugt und wahlweise
- an das Zentralsystem (Z),
- sämtlichen der mehreren Arbeitsbereich-Teilnehmern (T),
- einzelnen der mehreren Arbeitsbereich-Teilnehmern (T)
übermittelt werden können.

Nach einem Aspekt ist ein Arbeitsverfahren mit einer mobilen Schaltvorrichtung (1), das als Handgerät ausgeführt ist und Eingabemitteln und ein Display zur menügeführten Auswahl und Ausführung einer Aufgabe in einem industriellen Arbeitssystem (S) aufweist, ist vorgesehen:
- Bereitstellung einer Mehrzahl von Aufgaben-Anwendungsfunktionen (App) in einer zentralen Datenbank,
- über eine Netzwerkanbindung auf dem Display (80) der Schaltvorrichtung (1) Anzeige von wiedergebbaren Handlungsabfolgen Teilnehmer-Aufgaben und/oder Alternativen zur aufgabenbezogene Auswahl und/oder zu notwendigen Eingaben von Informationen,
- durch einen Benutzer Auswahl von zur anstehenden Aufgabe entsprechenden Anwendungsfunktionen (App),
- Abarbeitung dieser Aufgaben interaktiv unter Verwendung der Eingabemittel sowie unter Beachtung der Darstellungen auf dem Display (80).

Nach einer Ausführungsform des Arbeitsverfahrens ist vorgesehen, dass
dass in der ausgewählten Anwendungsfunktion (App) zumindest eine von einem oder mehreren Teilnehmern (T; T1, T2, T3) des Arbeitssystems (S) zu erfüllende Teilnehmer-Aufgabe auf dem Display (80) auswählbar ist,
dass nach Auswahl einer Teilnehmer-Aufgabe eine Übermittlung einer ausgewählten Teilnehmer-Aufgabe durch Betätigung der Schaltvorrichtung (1) an mehrere Teilnehmer (T; T1, T2, T3) erfolgt,
dass bei den Teilnehmer (T; T1, T2, T3) jeweils eine Priorisierung der über einen vorgegebenen Arbeitszeitraum mittels Aufgabendurchführungs-Kommandos empfangenen Teilnehmer-Aufgaben erfolgt,
dass eine Konsistenzprüfung und ein Abgleich der Teilnehmer-Aufgaben zwischen den Teilnehmern (T; T1, T2, T3) derart erfolgt, dass vermieden wird, dass derselben Aufgabe die oberste Priorität zugewiesen wird,
dass eine Abarbeitung der Aufgabe jeweils oberster Priorität durch den jeweiligen Teilnehmer (T; T1, T2, T3) erfolgt, so dass jeder Teilnehmer (T; T1, T2, T3) eine Aufgabe oberster Priorität erfüllt.

Dabei kann insbesondere vorgesehen sein, dass das industrielle Arbeitssystem (S) ein Lagersystem ist und wobei zumindest zwei Teilnehmer (T; T1, T2, T3) Lagerbediengeräte sind.

Nach einer Ausführungsform des Arbeitsverfahrens ist vorgesehen, dass über eine Ausgangs-Schnittstelle (93) der Schaltvorrichtung (1) in durch Betätigung der Schaltvorrichtung (1)auswählbaren Menüformaten Steuerungsfelder bereit gestellt werden, mittels eines Menü-Steuerungsmodul (96) Aufgabendurchführungs-Kommandos erzeugt werden und wahlweise
- an das Zentralsystem (Z),
- sämtlichen der mehreren Arbeitsbereich-Teilnehmern (T),
- einzelnen der mehreren Arbeitsbereich-Teilnehmern (T)
übermittelt werden.

Nach einer Ausführungsform des Arbeitsverfahrens ist vorgesehen, dass die Schaltvorrichtung (1) nach einer hierin beschriebenen Asuführungsform ausgeführt ist.

Der Ausdruck "entlang" kann hierin im Zusammenhang mit den hierin genannten Richtungsangaben, die den Verlauf einer Konturlinie oder einer Oberfläche betreffen können, oder die eine Richtung einer mechanischen Komponente wie einer Achse oder Welle betreffen können, insbesondere bedeuten, dass die Tangente an die jeweilige Konturlinie oder an die jeweilige Oberfläche in deren Verlauf gemäß der Richtungsangabe bzw. die Längserstreckung und z.B. Mittelachse der mechanischen Komponente lokal mit einem Winkel von maximal 45 Grad und vorzugsweise von maximal 30 Grad von einer Bezugsrichtung oder Bezugsachse abweicht, auf die bzw. der die jeweilige Richtungsangabe bezogen ist.

Der Ausdruck "quer" kann hierin im Zusammenhang mit den hierin genannten Richtungsangaben, die den Verlauf einer Konturlinie oder einer Oberfläche betreffen können, oder die eine Richtung einer mechanischen Komponente wie einer Achse oder Welle betreffen können, insbesondere bedeuten, dass die Tangente an die jeweilige Konturlinie oder an die jeweilige Oberfläche in deren Verlauf gemäß der Richtungsangabe bzw. die Längserstreckung und z.B. Mittelachse der mechanischen Komponente lokal mit einem Winkel von minimal 45 Grad und vorzugsweise von minimal 30 Grad von einer Bezugsrichtung oder Bezugsachse abweicht, auf die bzw. der die jeweilige Richtungsangabe bezogen ist.

Der Ausdruck "in der Dickenrichtung Z gesehen" bedeutet hierin zur Bezeichnung einer relativen Lage von angesprochene Merkmale oder Komponenten eine Blickrichtung, aufgrund einer Lage der angesprochenen Merkmale oder Komponenten angegeben werden.

Nach einem Aspekt der Erfindung ist eine Verwendung der Schaltvorrichtung als Vorrichtung zur Eingabe von logistischen Daten auf dem gesamten Gebiet der Logistik und industrieller Anwendungen, beispielsweise in einem Lagerbereich oder in der Produktion vorgesehen.

Nach einem weiteren Aspekt der Erfindung ist eine Verwendung der Schaltvorrichtung in der Ausführung mit einem Display als Vorrichtung zur Eingabe von logistischen Daten und zur Ausgabe von logistischen Daten auf dem gesamten Gebiet der Logistik und industrieller Anwendungen, beispielsweise jeweils in einem Lagerbereich oder in der Produktion vorgesehen.

Nach einer Variante der Erfindung ist auch eine Verwendung von Schaltvorrichtungen nach dem Stand der Technik in einer Ausführung mit einem Display als Vorrichtung zur Eingabe von logistischen Daten und zur Ausgabe von logistischen Daten auf dem gesamten Gebiet der Logistik und industrieller Anwendungen, beispielsweise jeweils in einem Lagerbereich oder in der Produktion vorgesehen.

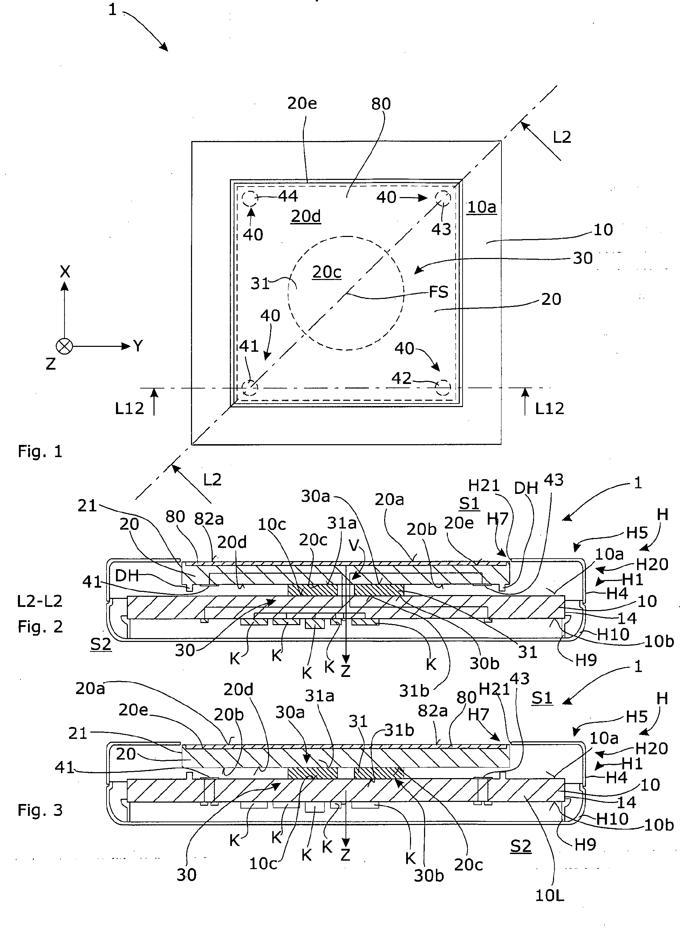

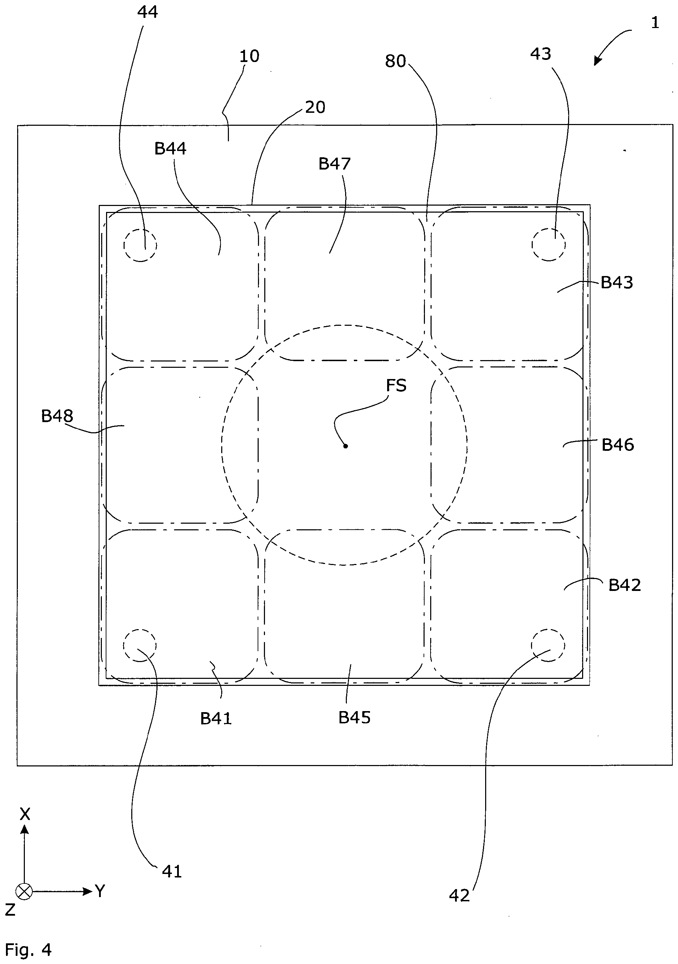

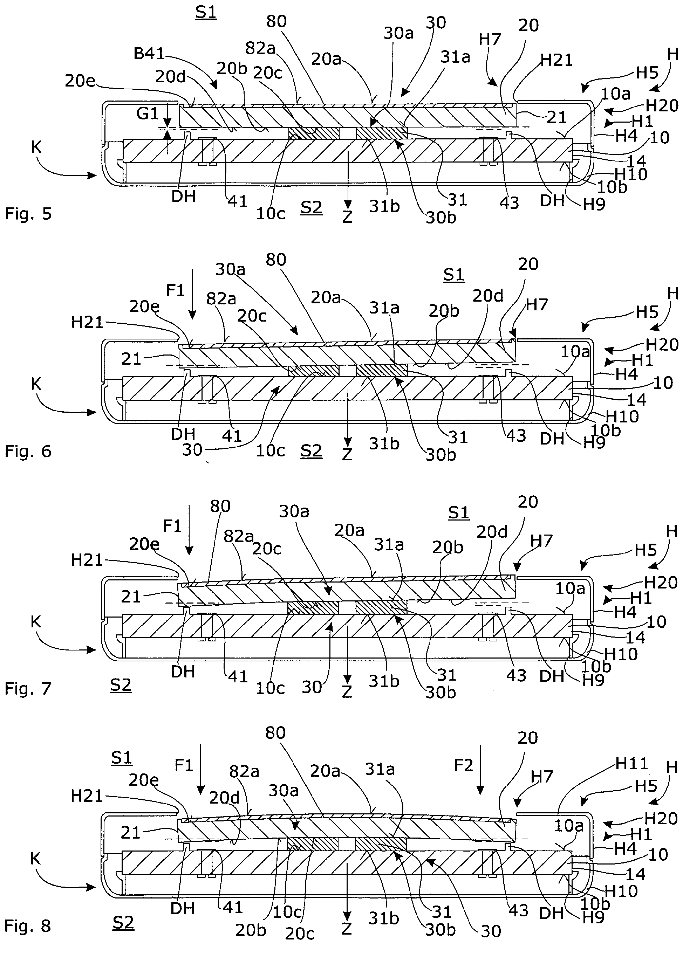

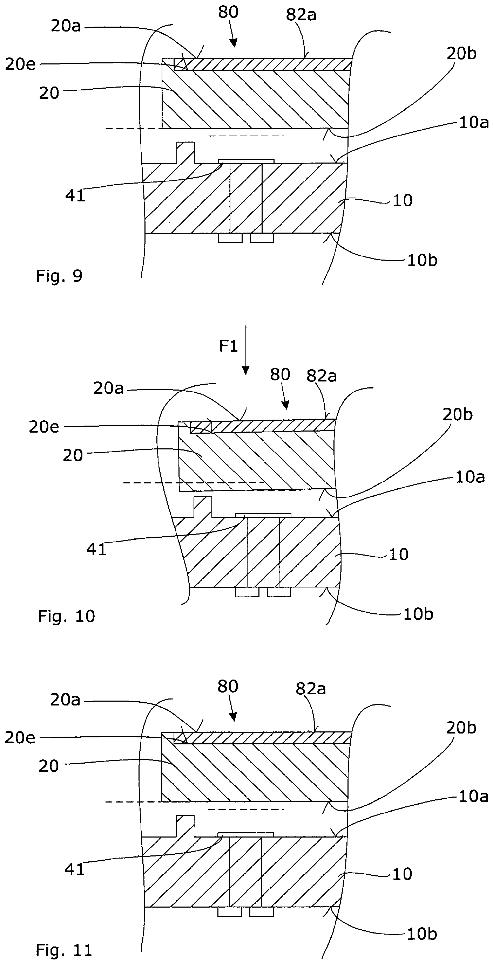

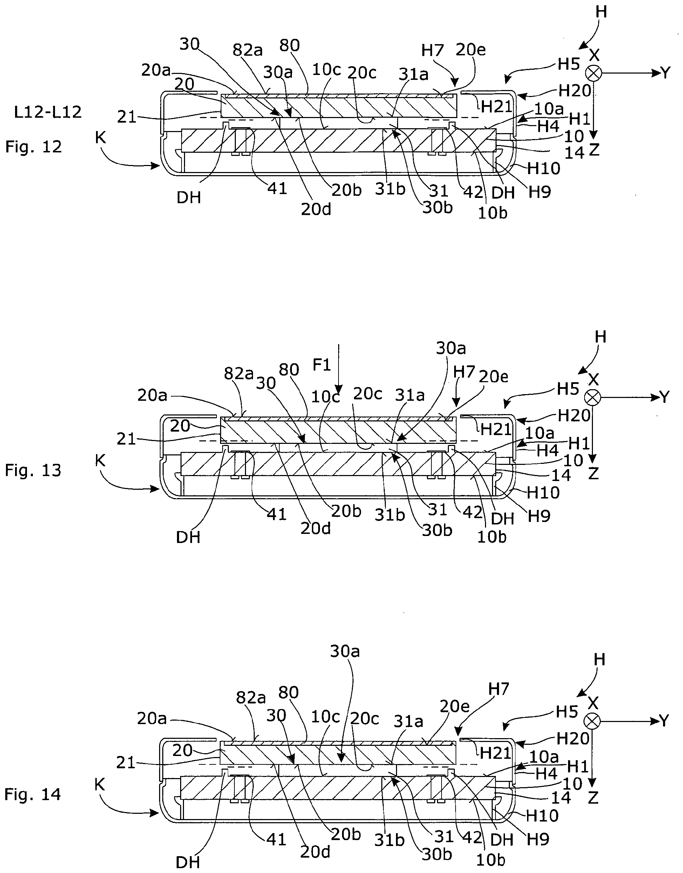

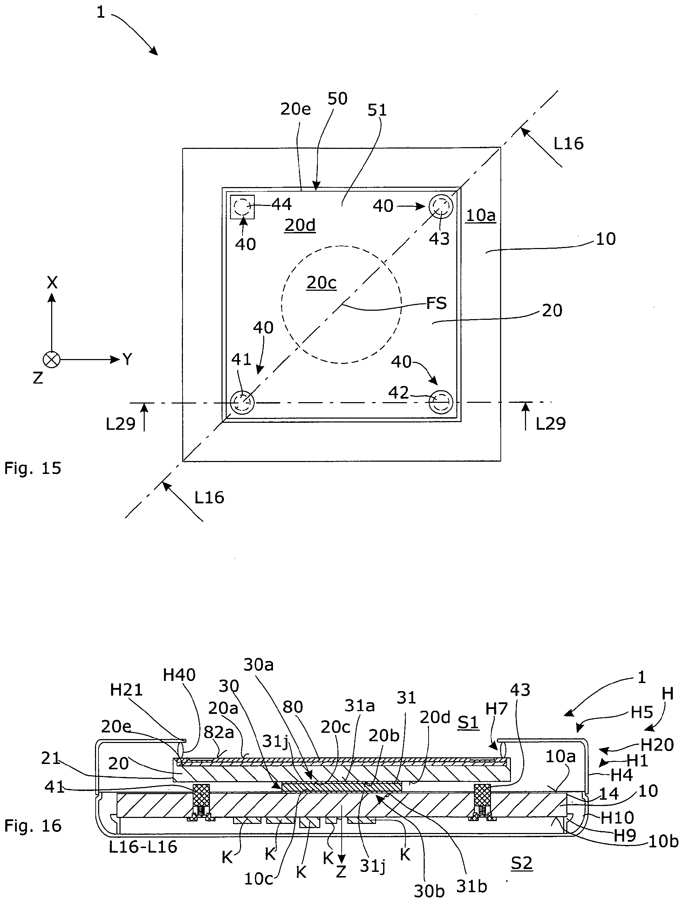

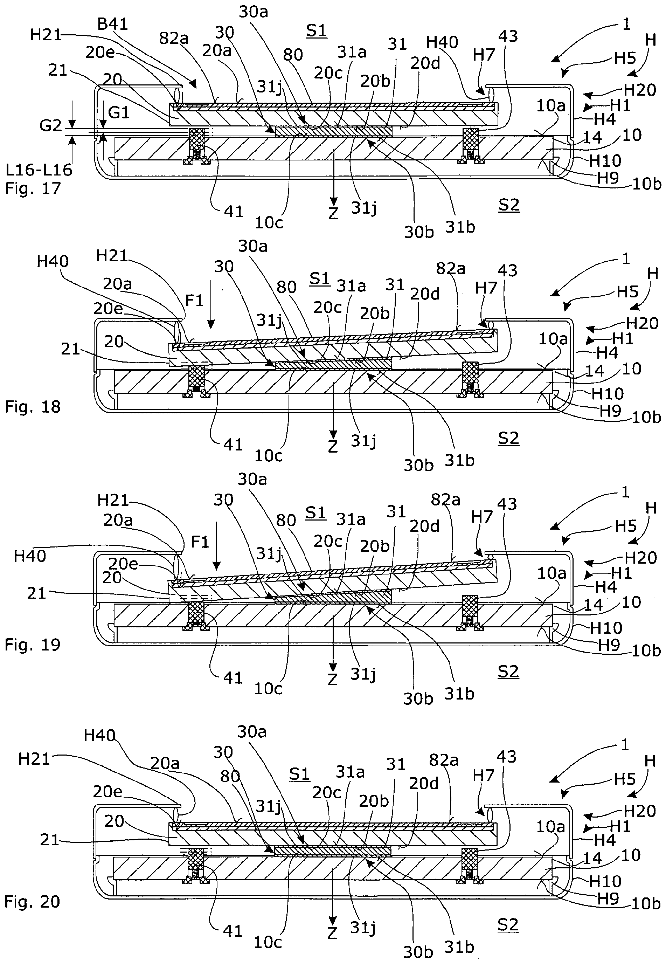

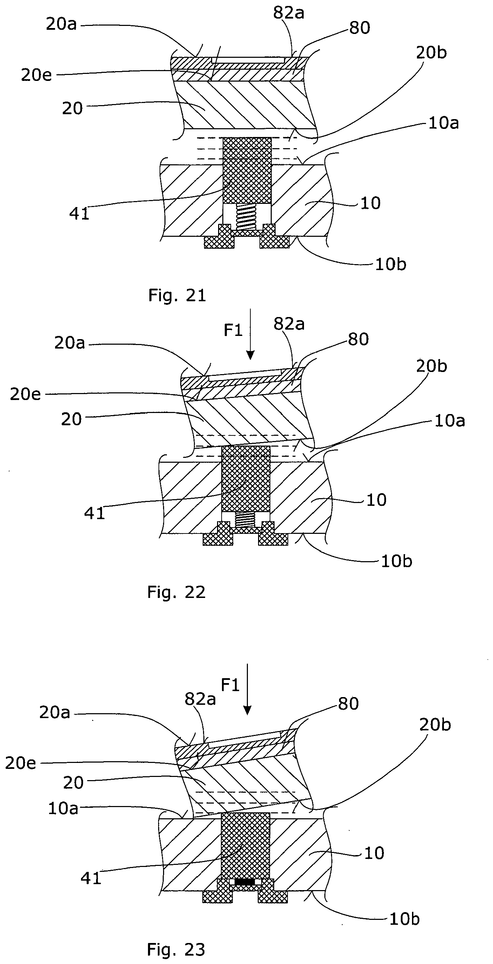

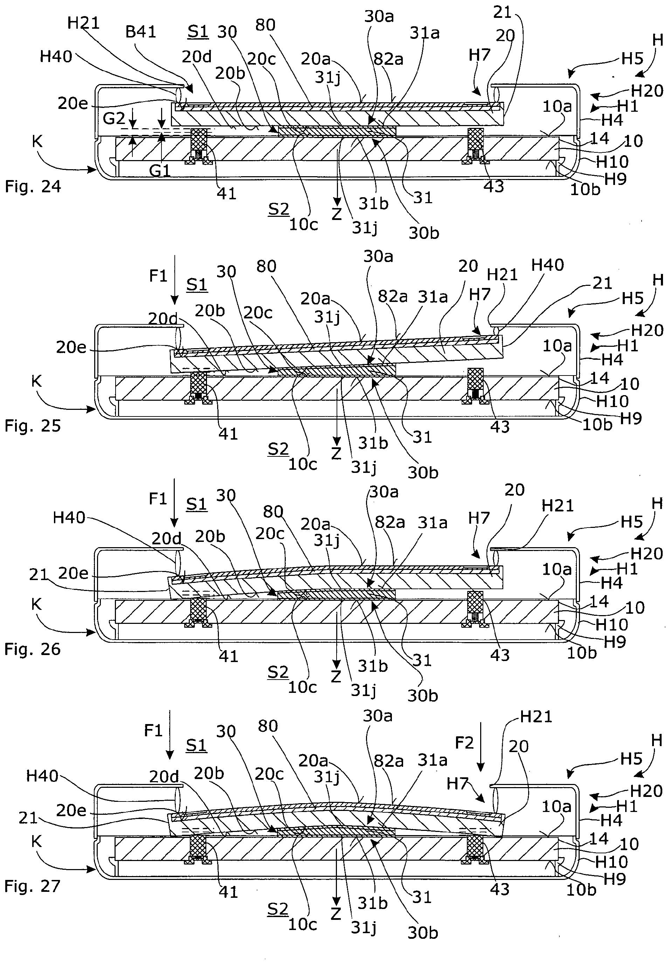

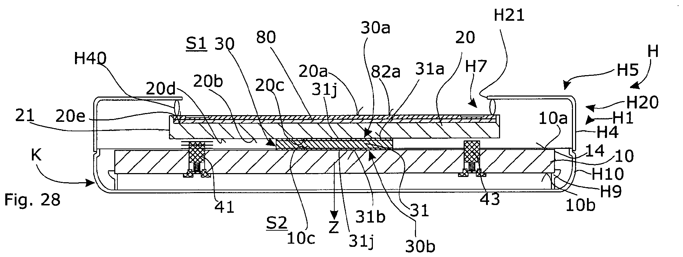

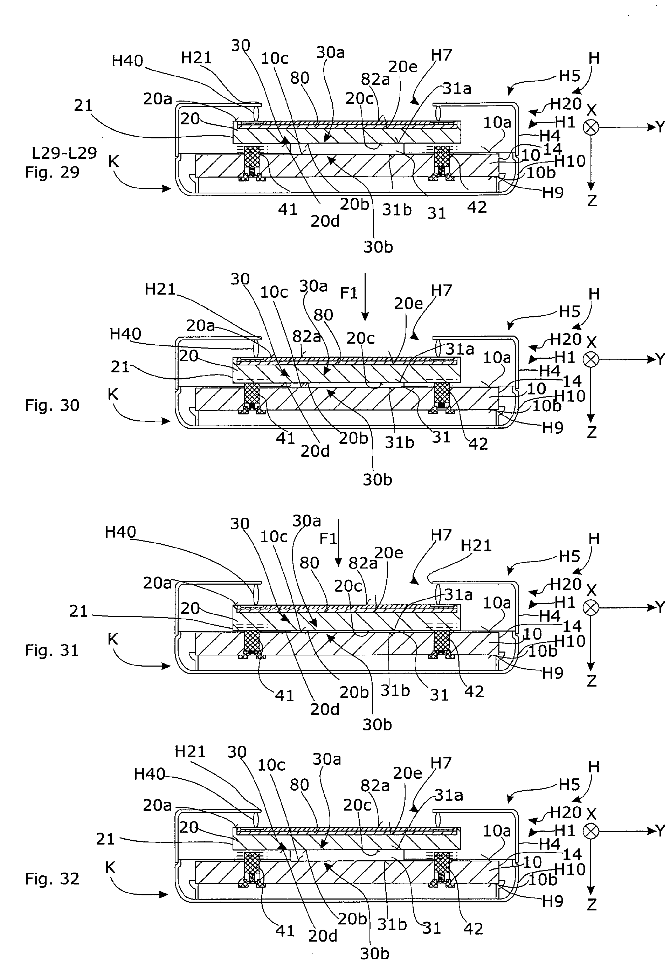

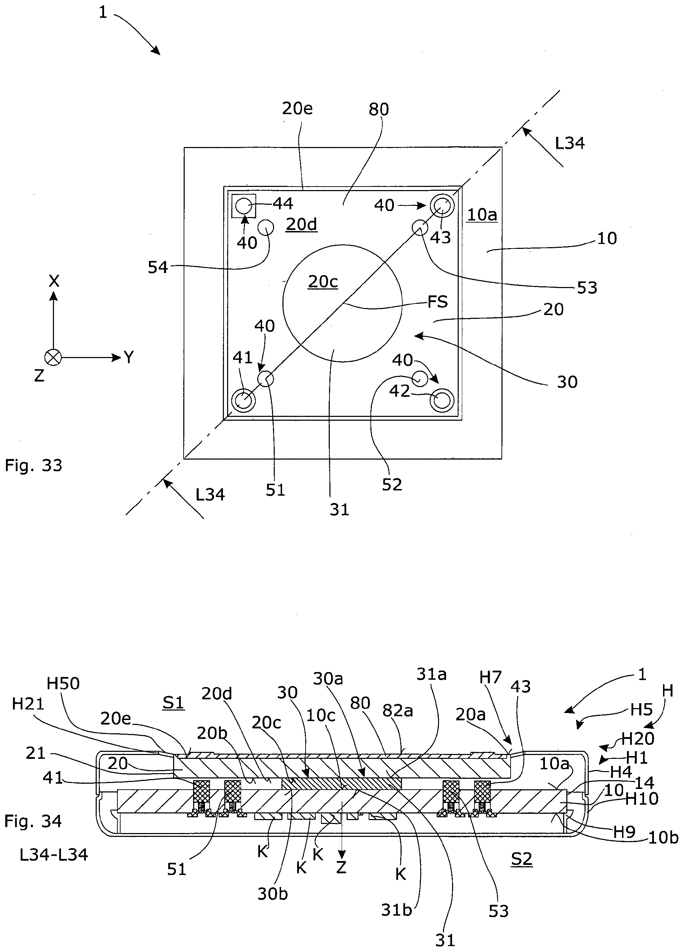

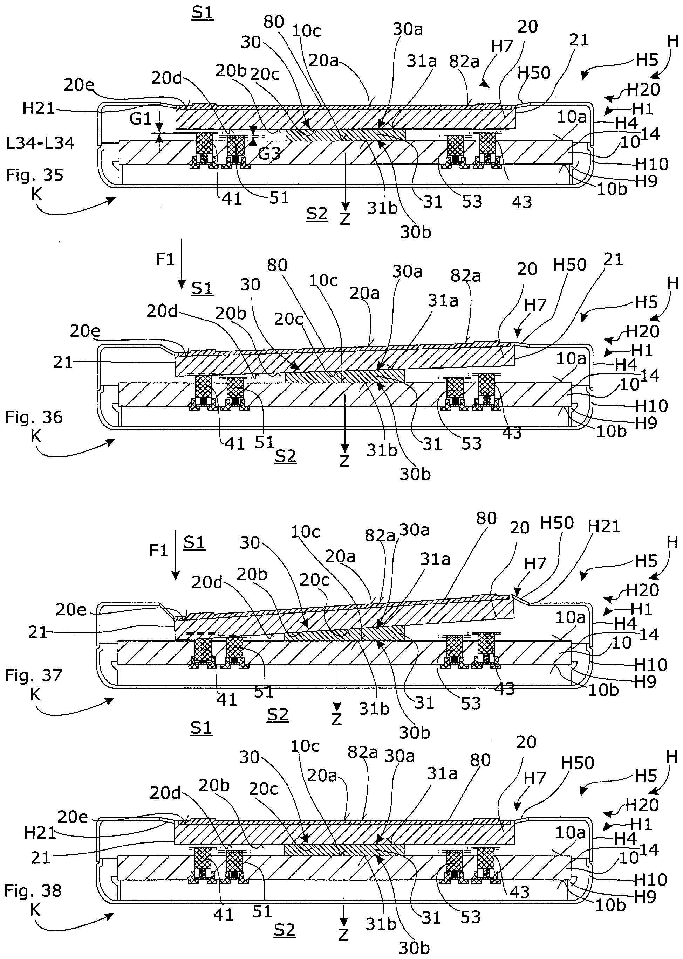

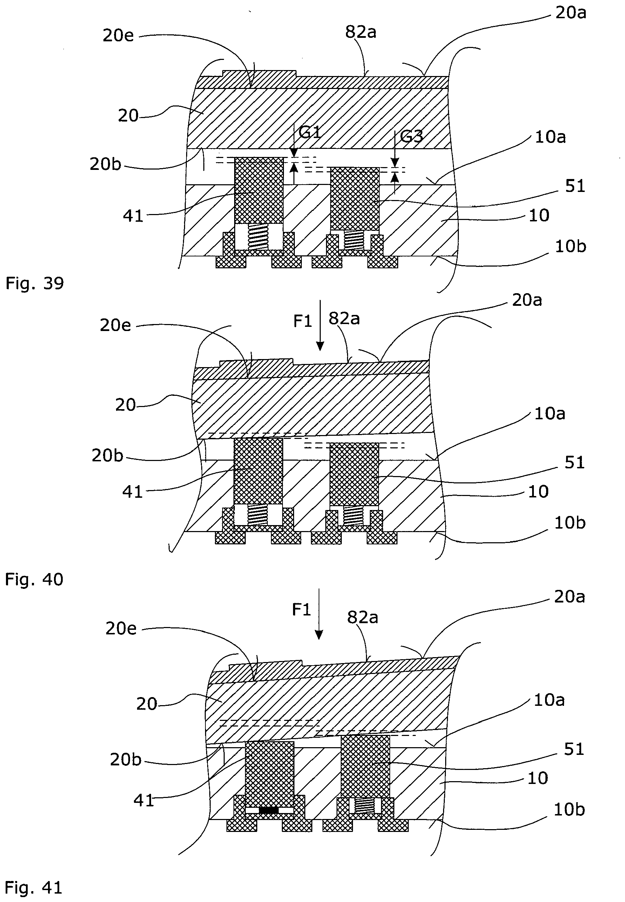

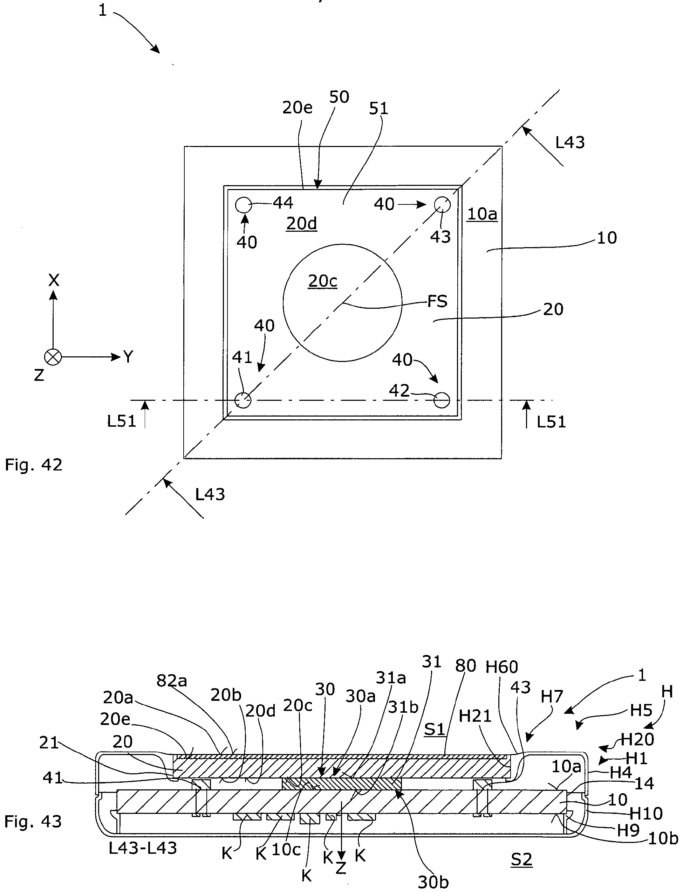

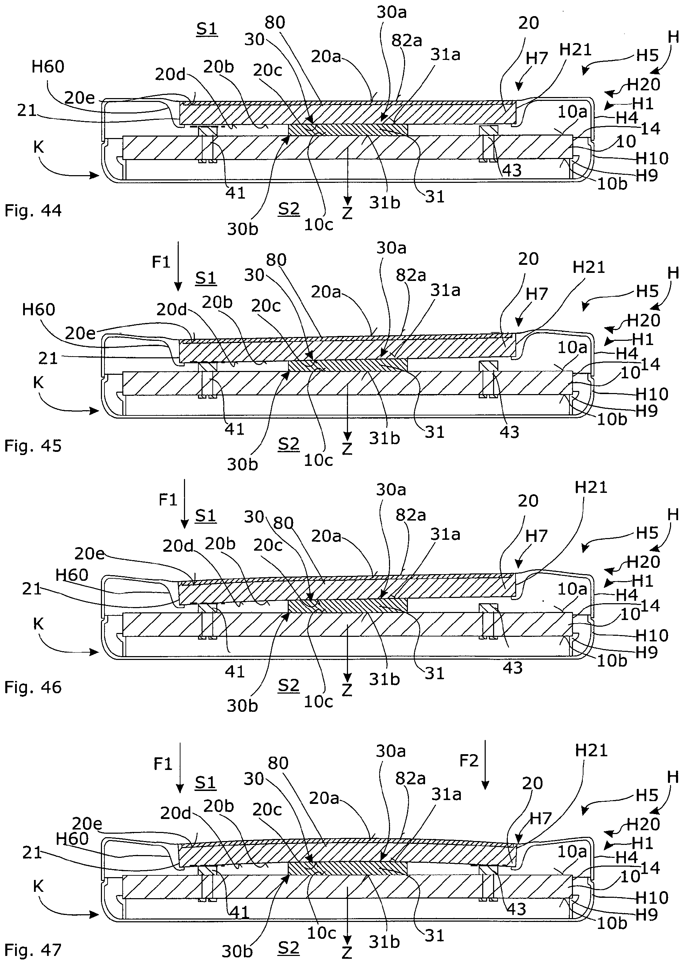

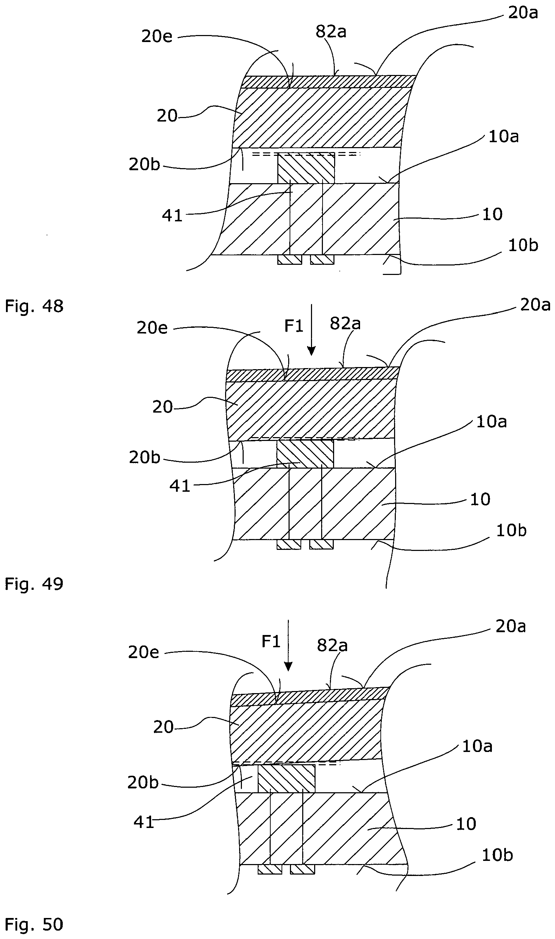

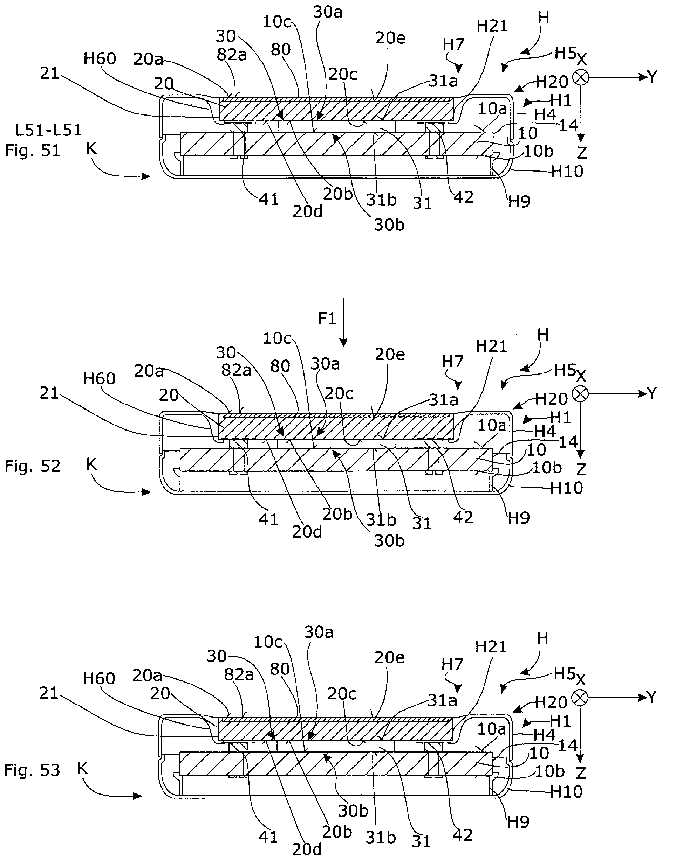

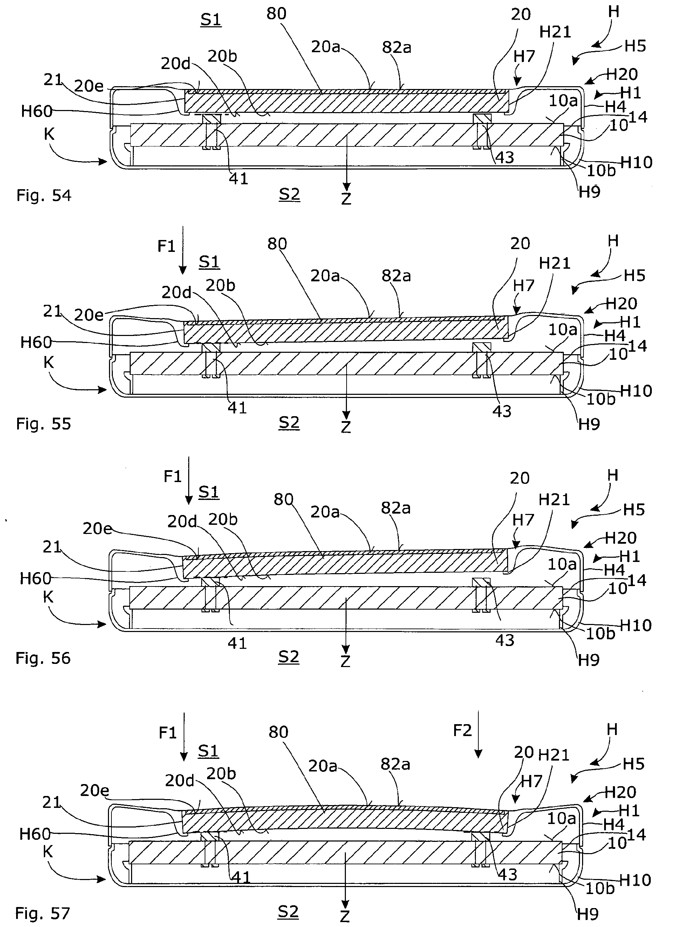

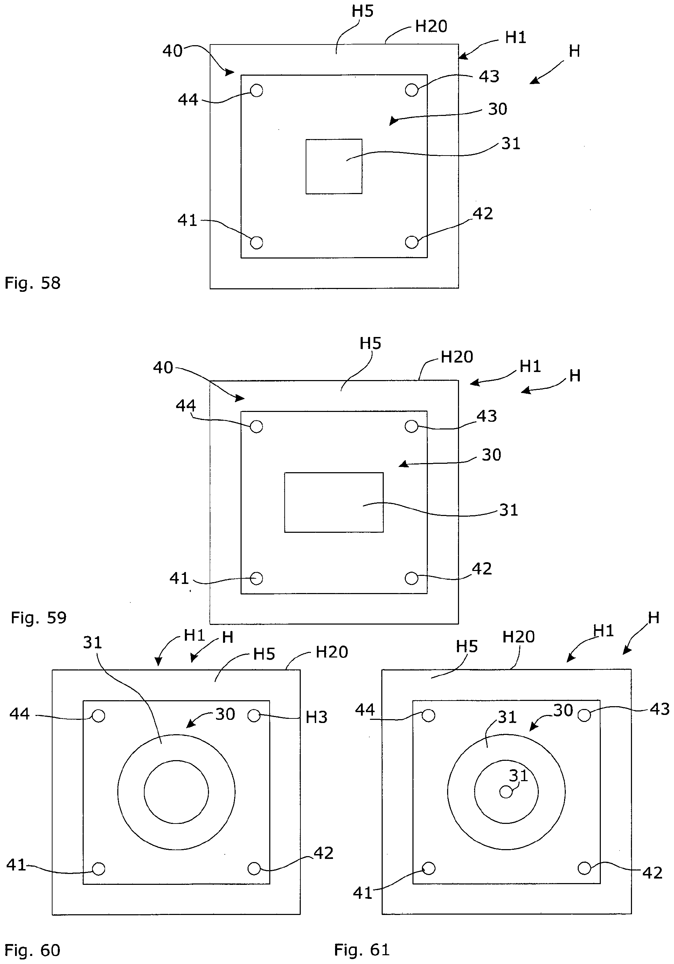

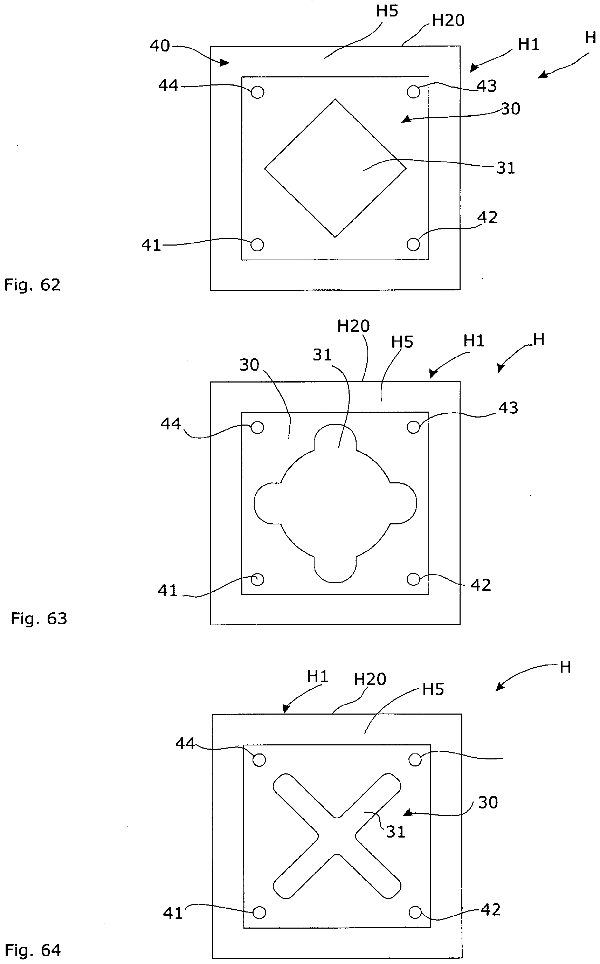

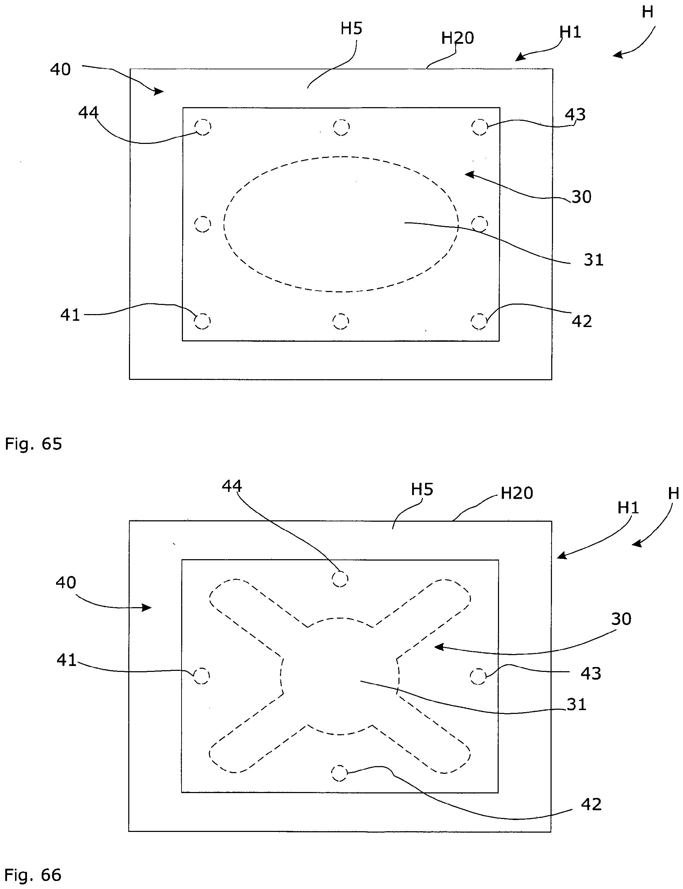

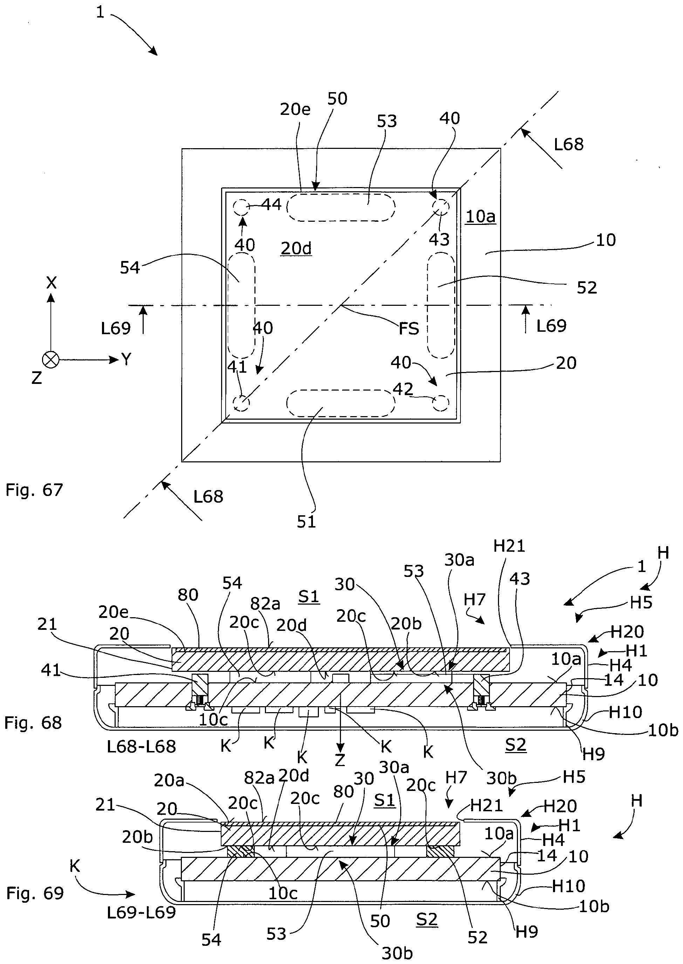

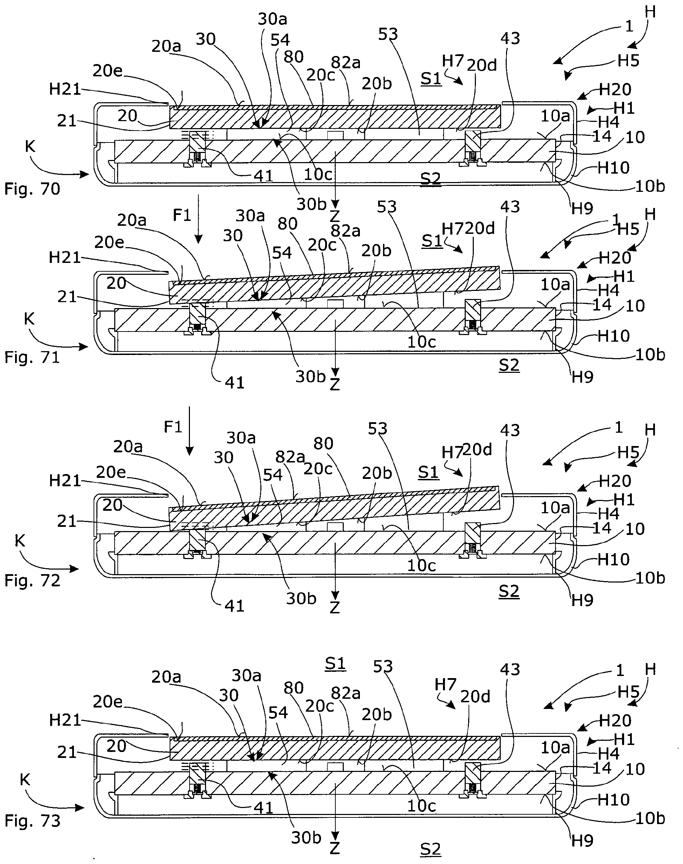

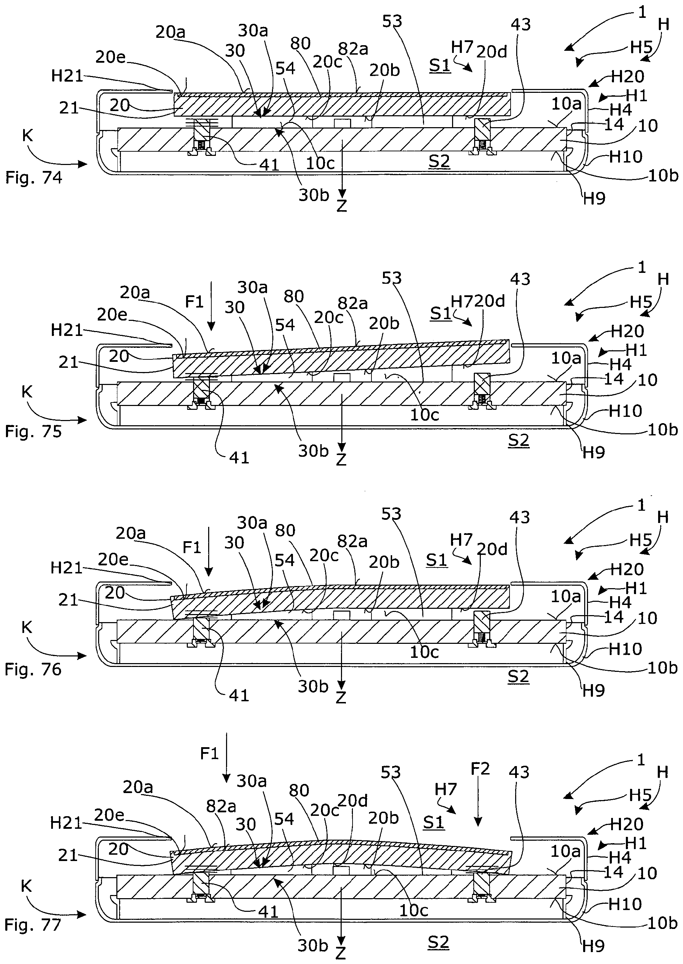

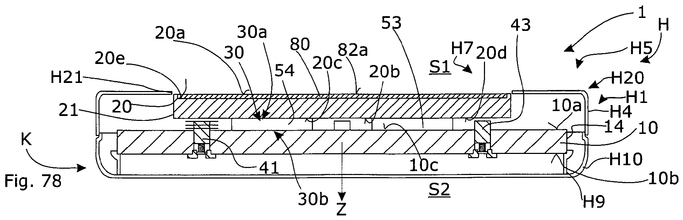

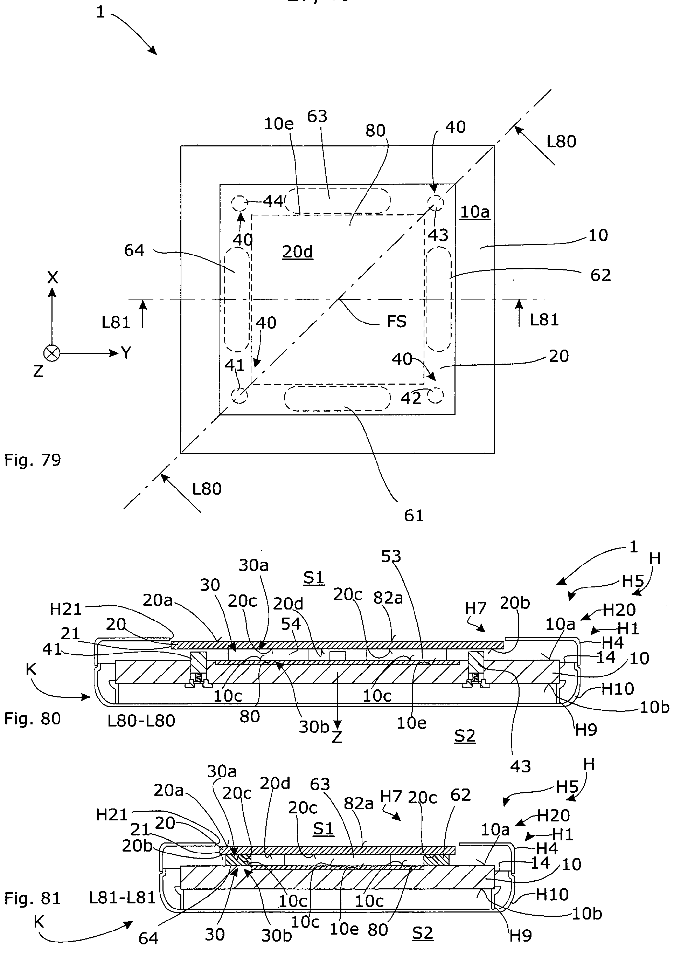

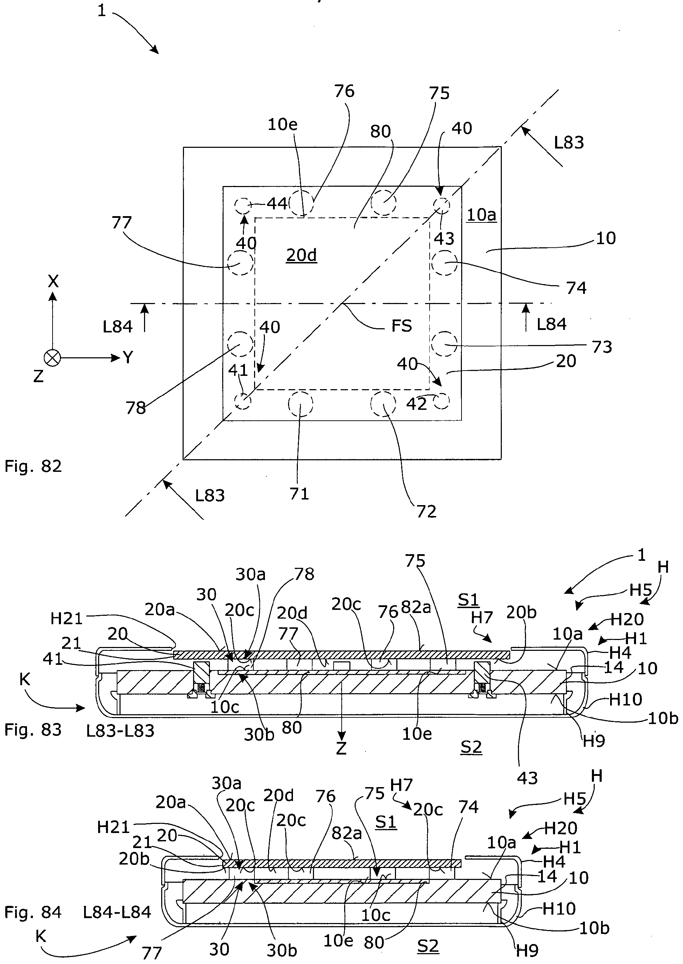

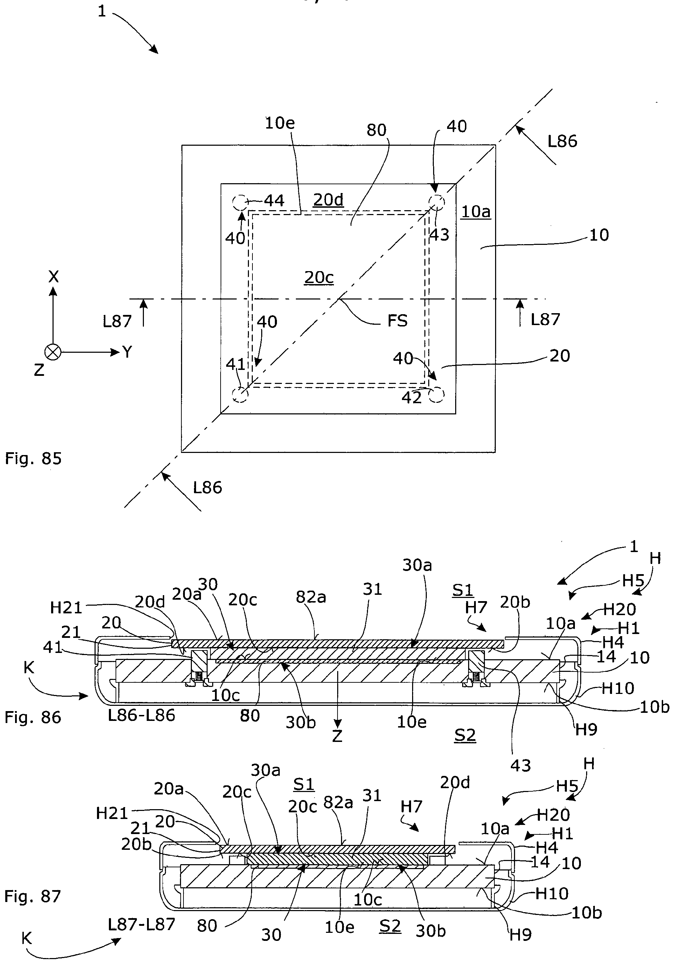

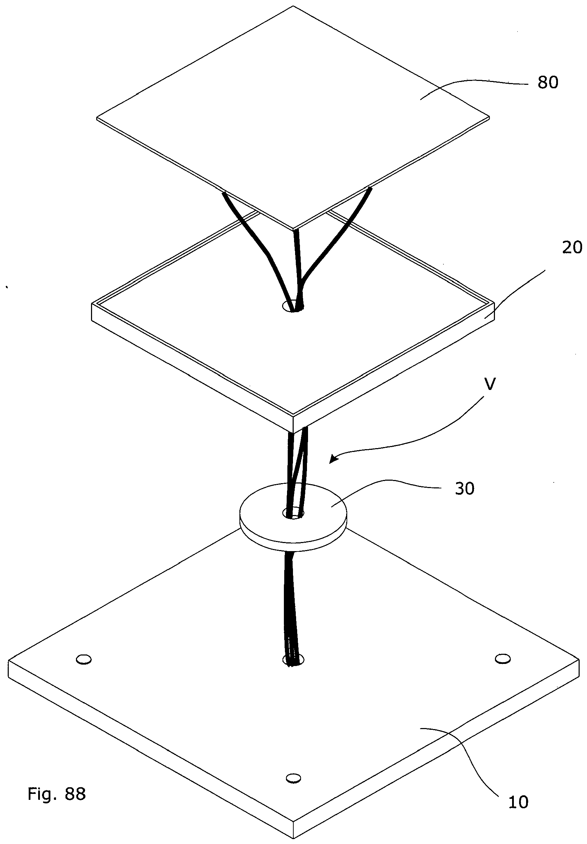

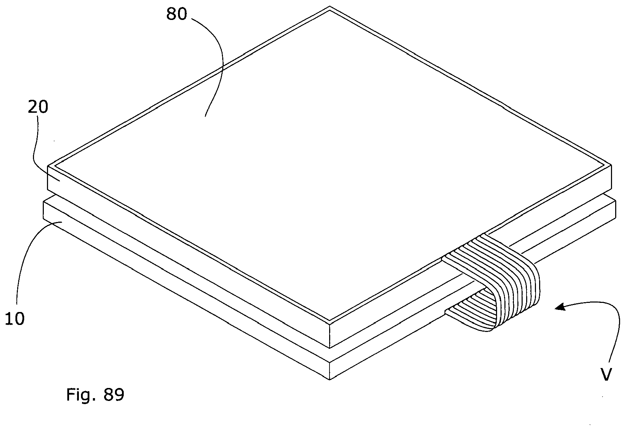

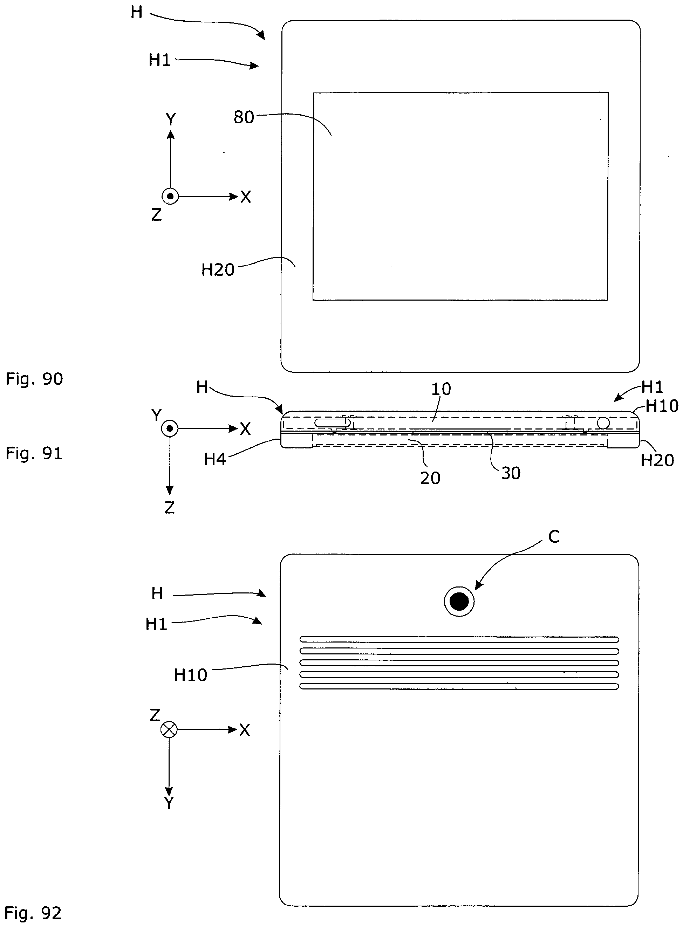

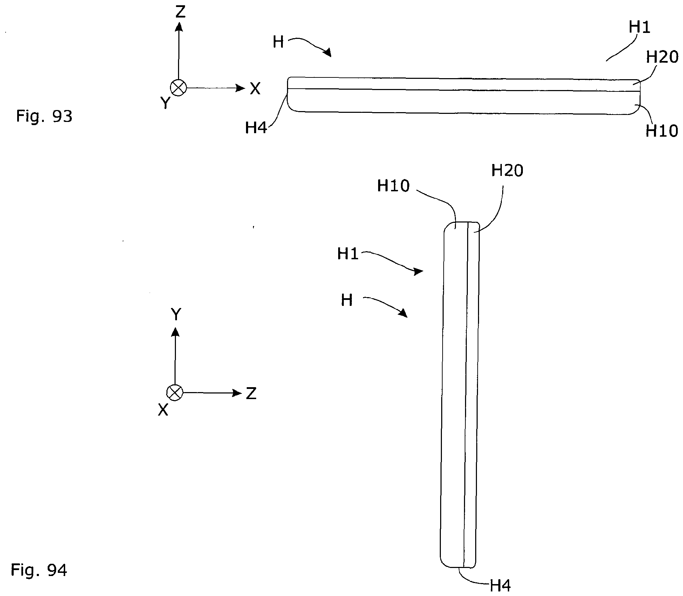

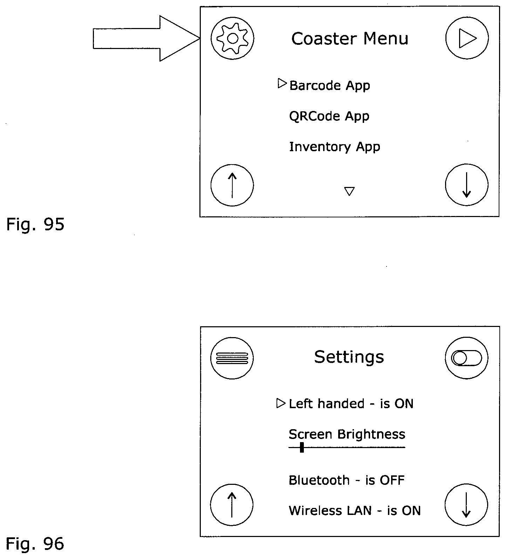

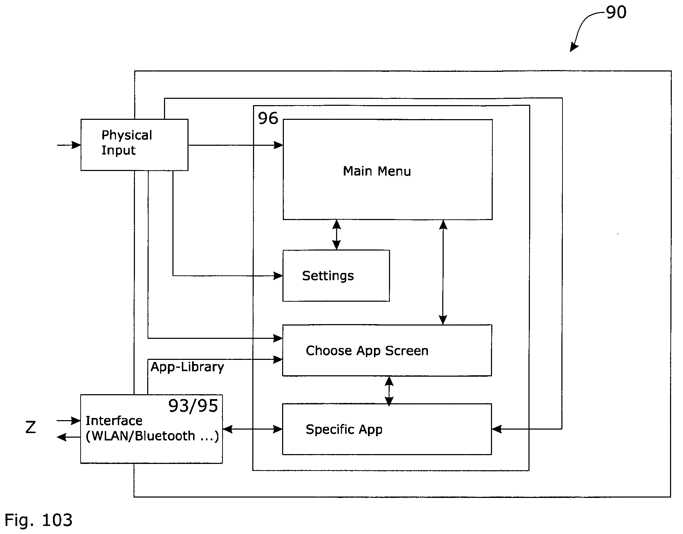

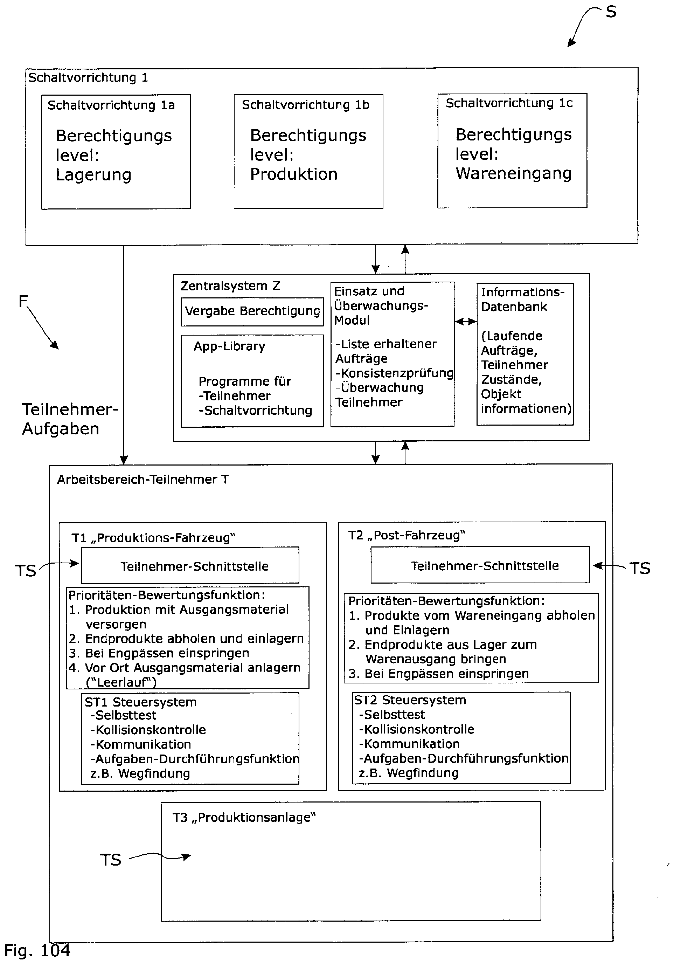

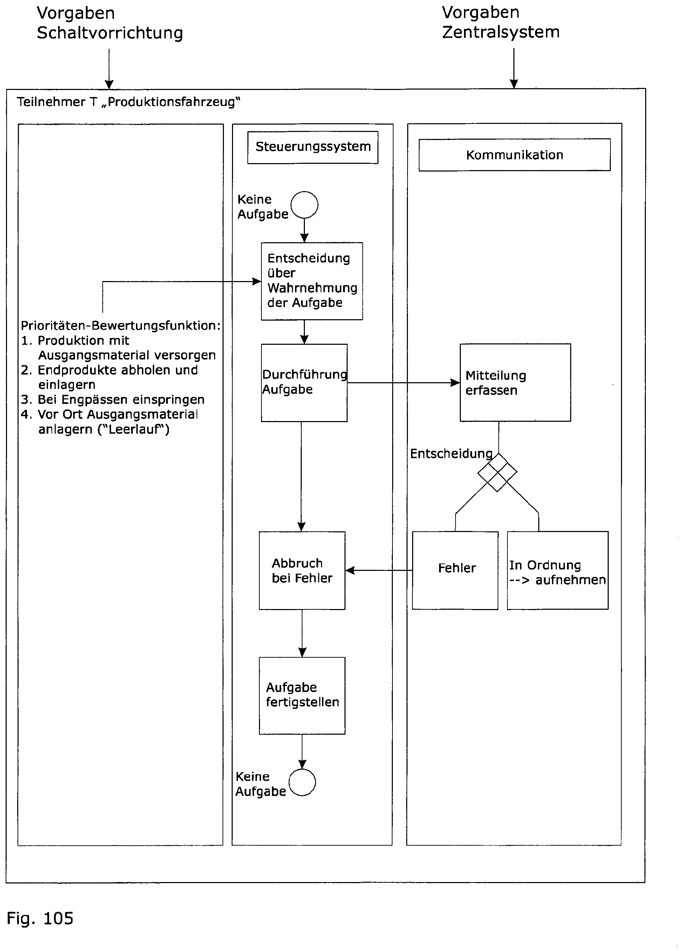

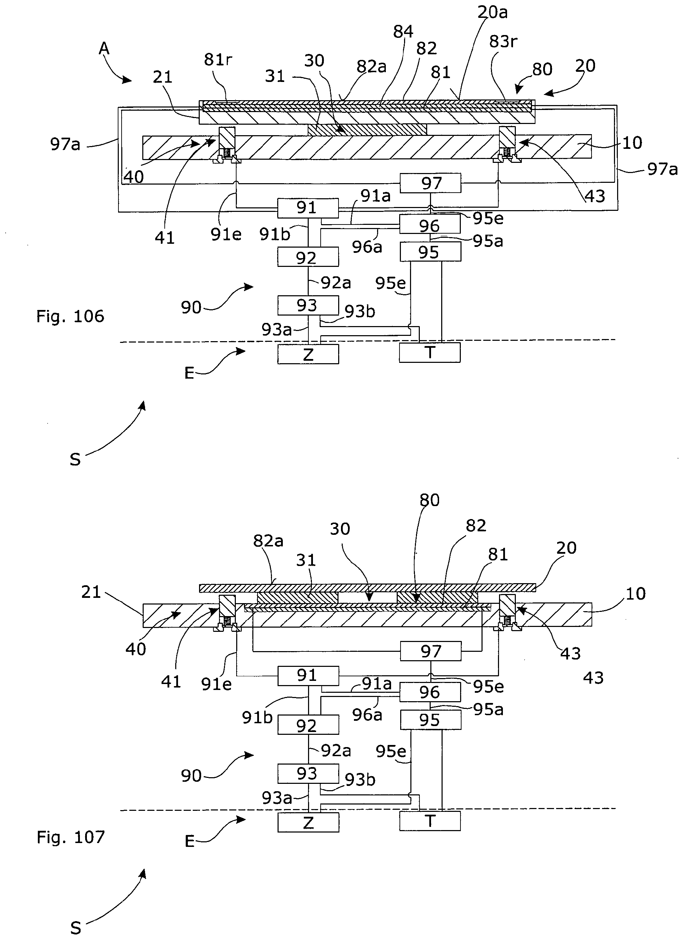

Im Folgenden werden Ausführungsformen der Erfindung an Hand der beiliegenden Figuren beschrieben, die zeigen:
▪ Figur 1 eine Draufsicht einer Ausführungsform der elektrischen Schaltvorrichtung mit einem Gehäuse, einem darin angeordneten Grundkörper, einem Betätigungsteil und einer zwischen diesen gelegenen Verbindungsvorrichtung sowie Sensoren, wobei die Sensoren als in der Draufsicht verdeckte Teile gestrichelt dargestellt sind,
▪ Figur 2 eine Schnittdarstellung der Ausführungsform der elektrischen Schaltvorrichtung nach der Figur 1 entlang der in der Figur 1 eingetragenen Linie L2-L2, wobei berührungslose Sensoren in Form von optischen Sensoren verwendet werden,
▪ Figur 3 eine Schnittdarstellung der Ausführungsform der elektrischen Schaltvorrichtung nach der Figur 1 entlang der in der Figur 1 eingetragenen Linie L2-L2, wobei berührungslose Sensoren in Form von induktiven Sensoren verwendet werden,
▪ Figur 4 eine weitere Draufsicht der Ausführungsform der elektrischen Schaltvorrichtung nach der Figur 1, in der Bereiche des Betätigungsteils gestrichelt dargestellt sind,
▪ Figur 5 als erster Schritt einer Schrittfolge die Schnittdarstellung der Ausführungsform der elektrischen Schaltvorrichtung nach der Figur 1 entlang der in der Figur 1 eingetragenen Linie L2-L2, wobei die Schaltvorrichtung in einer Ausgangsstellung gezeigt ist,
▪ Figur 6 die Ausführungsform der elektrischen Schaltvorrichtung nach der Figur 1 in der Darstellung der Figur 5, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 7 die Ausführungsform der elektrischen Schaltvorrichtung nach der Figur 1 in der Darstellung der Figur 5, wobei eine gegenüber der Figur 6 größere äußere Druckkraft ausgeübt wird,
▪ Figur 8 die Ausführungsform der elektrischen Schaltvorrichtung nach der Figur 1 in der Darstellung der Figur 5, gegenüber der Figur 7 eine weitere äußere Druckkraft an einem zweiten seitlichen Randabschnitt des Betätigungsteils ausgeübt wird, der entgegen gesetzt zu dem ersten seitlichen Randabschnitt gelegen ist,
▪ Figur 9 eine Detaildarstellung der Ausführungsform der elektrischen Schaltvorrichtung nach der Figur 1 mit dem ersten seitlichen Randabschnitt des Betätigungsteils, wobei sich die Schaltvorrichtung in dem in der Figur 5 gezeigten Ausgangszustand befindet,
▪ Figur 10 die Detaildarstellung der Figur 9, wobei sich die Schaltvorrichtung in dem in der Figur 6 gezeigten Betätigungszustand befindet,
▪ Figur 11 die Detaildarstellung der Figur 9, wobei sich die Schaltvorrichtung in dem in der Figur 7 gezeigten Betätigungszustand befindet,
▪ Figur 12 als erster Schritt einer Schrittfolge von drei Schritten eine Schnittdarstellung der Ausführungsform der elektrischen Schaltvorrichtung nach der Figur 1 entlang der in der Figur 1 eingetragenen Linie L12-L12, wobei die Schaltvorrichtung in einer Ausgangsstellung gezeigt ist,
▪ Figur 13 die Schnittdarstellung der Ausführungsform der elektrischen Schaltvorrichtung nach der Figur 1 in der Darstellung der Figur 12, wobei die Schaltvorrichtung in einem Betätigungszustand gezeigt ist,
▪ Figur 14 die Schnittdarstellung der Ausführungsform der elektrischen Schaltvorrichtung nach der Figur 1 in der Darstellung der Figur 12, wobei die Schaltvorrichtung in einem gegenüber der Figur 13 weiteren Betätigungszustand gezeigt ist,
▪ Figur 15 eine Draufsicht einer weiteren Ausführungsform der elektrischen Schaltvorrichtung, wobei die Sensoren als in der Draufsicht verdeckte Teile gestrichelt dargestellt sind,
▪ Figur 16 eine Schnittdarstellung der Ausführungsform der elektrischen Schaltvorrichtung nach der Figur 15 entlang der in der Figur 15 eingetragenen Linie L16-L16,
▪ Figur 17 als erster Schritt einer Schrittfolge von vier Schritten die Schnittdarstellung der Ausführungsform der elektrischen Schaltvorrichtung nach der Figur 15 entlang der in der Figur 15 eingetragenen Linie L16-L16, wobei die Schaltvorrichtung in einer Ausgangsstellung gezeigt ist und wobei die dargestellte Ausführungsform der Schaltvorrichtung ein flexibles Betätigungsteil aufweist,
▪ Figur 18 die Ausführungsform der elektrischen Schaltvorrichtung nach der Figur 15 in der Darstellung der Figur 17, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 19 die Ausführungsform der elektrischen Schaltvorrichtung nach der Figur 1 in der Darstellung der Figur 17, wobei eine gegenüber der Figur 18 größere äußere Druckkraft ausgeübt wird,
▪ Figur 20 die Ausführungsform der elektrischen Schaltvorrichtung nach der Figur 1 in der Darstellung der Figur 17, gegenüber der Figur 19 eine weitere äußere Druckkraft an einem zweiten seitlichen Randabschnitt des Betätigungsteils ausgeübt wird, der entgegen gesetzt zu dem ersten seitlichen Randabschnitt gelegen ist,
▪ Figur 21 eine Detaildarstellung der Ausführungsform der elektrischen Schaltvorrichtung nach der Figur 14 mit dem ersten seitlichen Randabschnitt des Betätigungsteils, wobei sich die Schaltvorrichtung in dem in der Figur 16 gezeigten Ausgangszustand befindet,
▪ Figur 22 die Detaildarstellung der Figur 20, wobei sich die Schaltvorrichtung in dem in der Figur 17 gezeigten Betätigungszustand befindet,
▪ Figur 23 die Detaildarstellung der Figur 20, wobei sich die Schaltvorrichtung in dem in der Figur 18 gezeigten Betätigungszustand befindet,
▪ Figur 24 als erster Schritt einer Schrittfolge von fünf Schritten die Schnittdarstellung der Ausführungsform der elektrischen Schaltvorrichtung nach der Figur 15 entlang der in der Figur 15 eingetragenen Linie L16-L16, wobei die Schaltvorrichtung in einer Ausgangsstellung gezeigt ist und wobei die dargestellte Ausführungsform der Schaltvorrichtung ein starres Betätigungsteil aufweist,
▪ Figur 25 die Ausführungsform der elektrischen Schaltvorrichtung nach der Figur 15 in der Darstellung der Figur 24, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 26 die Ausführungsform der elektrischen Schaltvorrichtung nach der Figur 15 in der Darstellung der Figur 24, wobei eine gegenüber der Figur 25 größere äußere Druckkraft ausgeübt wird,
▪ Figur 27 die Ausführungsform der elektrischen Schaltvorrichtung nach der Figur 15 in der Darstellung der Figur 24, wobei gegenüber der Figur 25 eine weitere äußere Druckkraft an einem zweiten seitlichen Randabschnitt des Betätigungsteils ausgeübt wird, der entgegen gesetzt zu dem ersten seitlichen Randabschnitt gelegen ist,
▪ Figur 28 die Ausführungsform der elektrischen Schaltvorrichtung nach der Figur 15 in der Darstellung der Figur 24, wobei gegenüber der Figur 27 bei einem weiteren Betriebszustand keine äußere Druckkraft an einem seitlichen Randabschnitt des Betätigungsteils ausgeübt wird,
▪ Figur 29 als erster Schritt einer Schrittfolge von vier Schritten eine Schnittdarstellung der Ausführungsform der elektrischen Schaltvorrichtung nach der Figur 15 entlang der in der Figur 15 eingetragenen Linie L29-L29, wobei die Schaltvorrichtung in einer Ausgangsstellung gezeigt ist und wobei die dargestellte Ausführungsform der Schaltvorrichtung ein starres Betätigungsteil aufweist,
▪ Figur 30 die Ausführungsform der elektrischen Schaltvorrichtung nach der Figur 15 in der Darstellung der Figur 29, wobei die Schaltvorrichtung in einer Betätigungsstellung gezeigt ist, bei der äußere Druckkräfte auf entgegen gesetzt zueinander gelegenen seitlichen Randabschnitten des Betätigungsteils von der Betätigungsseite her ausgeübt wird,
▪ Figur 31 die Ausführungsform der elektrischen Schaltvorrichtung nach der Figur 15 in der Darstellung der Figur 29, wobei eine gegenüber der Figur 25 größere äußere Druckkräfte ausgeübt wird,
▪ Figur 32 die Ausführungsform der elektrischen Schaltvorrichtung nach der Figur 14 in der Darstellung der Figur 29, wobei gegenüber der Figur 31 bei einem weiteren Betriebszustand wiederum keine äußere Druckkraft an einem seitlichen Randabschnitt des Betätigungsteils ausgeübt wird,
▪ Figur 33 eine Draufsicht einer weiteren Ausführungsform der elektrischen Schaltvorrichtung, wobei die Sensoren als in der Draufsicht verdeckte Teile gestrichelt dargestellt sind,
▪ Figur 34 eine Schnittdarstellung der Ausführungsform der elektrischen Schaltvorrichtung nach der Figur 33 entlang der in der Figur 33 eingetragenen Linie L34-L34,
▪ Figur 35 als erster Schritt einer Schrittfolge von vier Schritten die Schnittdarstellung der Ausführungsform der elektrischen Schaltvorrichtung nach der Figur 33 entlang der in der Figur 33 eingetragenen Linie L34-L34, wobei die Schaltvorrichtung in einer Ausgangsstellung gezeigt ist und wobei die dargestellte Ausführungsform der Schaltvorrichtung ein starres Betätigungsteil aufweist,
▪ Figur 36 die Ausführungsform der elektrischen Schaltvorrichtung nach der Figur 33 in der Darstellung der Figur 35, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 37 die Ausführungsform der elektrischen Schaltvorrichtung nach der Figur 33 in der Darstellung der Figur 35, wobei eine gegenüber der Figur 36 größere äußere Druckkraft ausgeübt wird,
▪ Figur 38 die Ausführungsform der elektrischen Schaltvorrichtung nach der Figur 33 in der Darstellung der Figur 35, wobei gegenüber der Figur 37 keine äußere Druckkraft an seitlichen Randabschnitten des Betätigungsteils ausgeübt wird,
▪ Figur 39 eine Detaildarstellung der Ausführungsform der elektrischen Schaltvorrichtung nach der Figur 34 mit dem ersten seitlichen Randabschnitt des Betätigungsteils, wobei sich die Schaltvorrichtung in dem in der Figur 34 gezeigten Ausgangszustand befindet,
▪ Figur 40 die Detaildarstellung der Figur 35, wobei sich die Schaltvorrichtung in dem in der Figur 35 gezeigten Betätigungszustand befindet,
▪ Figur 41 die Detaildarstellung der Figur 36, wobei sich die Schaltvorrichtung in dem in der Figur 36 gezeigten Betätigungszustand befindet,
▪ Figur 42 eine Draufsicht einer weiteren Ausführungsform der elektrischen Schaltvorrichtung, wobei die Sensoren als in der Draufsicht verdeckte Teile gestrichelt dargestellt sind,
▪ Figur 43 eine Schnittdarstellung der Ausführungsform der elektrischen Schaltvorrichtung nach der Figur 42 entlang der in der Figur 42 eingetragenen Linie L43-L43,
▪ Figur 44 als erster Schritt einer Schrittfolge von vier Schritten die Schnittdarstellung der Ausführungsform der elektrischen Schaltvorrichtung nach der Figur 42 entlang der in der Figur 42 eingetragenen Linie L43-L43, wobei die Schaltvorrichtung in einer Ausgangsstellung gezeigt ist,
▪ Figur 45 die Ausführungsform der elektrischen Schaltvorrichtung nach der Figur 42 in der Darstellung der Figur 44, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 46 die Ausführungsform der elektrischen Schaltvorrichtung nach der Figur 42 in der Darstellung der Figur 44, wobei eine gegenüber der Figur 45 größere äußere Druckkraft ausgeübt wird,
▪ Figur 47 die Ausführungsform der elektrischen Schaltvorrichtung nach der Figur 42 in der Darstellung der Figur 44, gegenüber der Figur 46 eine weitere äußere Druckkraft an einem zweiten seitlichen Randabschnitt des Betätigungsteils ausgeübt wird, der entgegen gesetzt zu dem ersten seitlichen Randabschnitt gelegen ist,
▪ Figur 48 eine Detaildarstellung der Ausführungsform der elektrischen Schaltvorrichtung nach der Figur 42 mit dem ersten seitlichen Randabschnitt des Betätigungsteils, wobei sich die Schaltvorrichtung in dem in der Figur 44 gezeigten Ausgangszustand befindet,
▪ Figur 49 die Detaildarstellung der Figur 45, wobei sich die Schaltvorrichtung in dem in der Figur 45 gezeigten Betätigungszustand befindet,
▪ Figur 50 die Detaildarstellung der Figur 46, wobei sich die Schaltvorrichtung in dem in der Figur 46 gezeigten Betätigungszustand befindet,
▪ Figur 51 als erster Schritt einer Schrittfolge von drei Schritten eine Schnittdarstellung der Ausführungsform der elektrischen Schaltvorrichtung nach der Figur 42 entlang der in der Figur 42 eingetragenen Linie L51-L51, wobei die Schaltvorrichtung in einer Ausgangsstellung gezeigt ist,
▪ Figur 52 die Schnittdarstellung der Ausführungsform der elektrischen Schaltvorrichtung nach der Figur 42 in der Darstellung der Figur 42, wobei die Schaltvorrichtung in einem Betätigungszustand gezeigt ist,
▪ Figur 53 die Schnittdarstellung der Ausführungsform der elektrischen Schaltvorrichtung nach der Figur 42 in der Darstellung der Figur 42, wobei die Schaltvorrichtung in einem gegenüber der Figur 52 weiteren Betätigungszustand gezeigt ist,
▪ Figuren 54 bis 57 Darstellungen von Betriebszuständen einer weiteren Ausführungsform der der elektrischen Schaltvorrichtung, wobei die Schaltvorrichtung keine Verbindungsschicht aufweist und ein umlaufender Randabschnitt des Gehäuseteils mit dem Betätigungsteil verbunden ist, wobei die Betriebszustände analog der in den Figuren 44 bis 47 gezeigten Betriebszuständen sind,
▪ Figuren 58 bis 66 Darstellungen von verschiedenen Ausführungsformen der Verbindungsvorrichtung,
▪ Figur 67 eine Draufsicht einer weiteren Ausführungsform der elektrischen Schaltvorrichtung, wobei die Sensoren als in der Draufsicht verdeckte Teile gestrichelt dargestellt sind,
▪ Figur 68 eine Schnittdarstellung der Ausführungsform der elektrischen Schaltvorrichtung nach der Figur 67 entlang der in der Figur 67 eingetragenen Linie L68-L68,
▪ Figur 69 eine Schnittdarstellung der Ausführungsform der elektrischen Schaltvorrichtung nach der Figur 67 entlang der in der Figur 67 eingetragenen Linie L69-L69,
▪ Figur 70 als erster Schritt einer Schrittfolge von vier Schritten und bei einer Ausführungsform mit einem starren Betätigungsteil die Schnittdarstellung der Ausführungsform der elektrischen Schaltvorrichtung nach der Figur 67 entlang der in der Figur 67 eingetragenen Linie L68-L68, wobei die Schaltvorrichtung in einer Ausgangsstellung gezeigt ist,
▪ Figur 71 die Ausführungsform der elektrischen Schaltvorrichtung nach der Figur 67 in der Darstellung der Figur 67, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 72 die Ausführungsform der elektrischen Schaltvorrichtung nach der Figur 42 in der Darstellung der Figur 67, wobei eine gegenüber der Figur 45 größere äußere Druckkraft ausgeübt wird,
▪ Figur 73 die Ausführungsform der elektrischen Schaltvorrichtung nach der Figur 42 in der Darstellung der Figur 63, wobei sich die Schaltvorrichtung in dem in der Figur 44 gezeigten Ausgangszustand befindet,
▪ Figur 74 als erster Schritt einer Schrittfolge von fünf Schritten und bei einer Ausführungsform mit einem flexiblen Betätigungsteil die Schnittdarstellung der Ausführungsform der elektrischen Schaltvorrichtung nach der Figur 68 entlang der in der Figur 67 eingetragenen Linie L68-L68, wobei die Schaltvorrichtung in einer Ausgangsstellung gezeigt ist und wobei die dargestellte Ausführungsform der Schaltvorrichtung ein starres Betätigungsteil aufweist,
▪ Figur 75 die Ausführungsform der elektrischen Schaltvorrichtung nach der Figur 68 in der Darstellung der Figur 68, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
▪ Figur 76 die Ausführungsform der elektrischen Schaltvorrichtung nach der Figur 68 in der Darstellung der Figur 68, wobei eine gegenüber der Figur 75 größere äußere Druckkraft ausgeübt wird,
▪ Figur 77 die Ausführungsform der elektrischen Schaltvorrichtung nach der Figur 68 in der Darstellung der Figur 68, wobei gegenüber der Figur 76 eine weitere äußere Druckkraft an einem zweiten seitlichen Randabschnitt des Betätigungsteils ausgeübt wird, der entgegen gesetzt zu dem ersten seitlichen Randabschnitt gelegen ist,
▪ Figur 78 die Ausführungsform der elektrischen Schaltvorrichtung nach der Figur 64 in der Darstellung der Figur 68, wobei gegenüber der Figur 77 bei einem weiteren Betriebszustand keine äußere Druckkraft an einem seitlichen Randabschnitt des Betätigungsteils ausgeübt wird,
▪ Figur 79 eine Draufsicht einer weiteren Ausführungsform der elektrischen Schaltvorrichtung, wobei die Sensoren als in der Draufsicht verdeckte Teile gestrichelt dargestellt sind, wobei die Verbindungsvorrichtung anders als in den vorangehenden Figuren ausgebildet ist und wobei ein Display im Grundkörper integriert ist,
▪ Figur 80 eine Schnittdarstellung der Ausführungsform der elektrischen Schaltvorrichtung nach der Figur 79 entlang der in der Figur 79 eingetragenen Linie L80-L80,
▪ Figur 81 eine Schnittdarstellung der Ausführungsform der elektrischen Schaltvorrichtung nach der Figur 79 entlang der in der Figur 79 eingetragenen Linie L81-L81,
▪ Figur 82 eine Draufsicht einer weiteren Ausführungsform der elektrischen Schaltvorrichtung, wobei die Sensoren als in der Draufsicht verdeckte Teile gestrichelt dargestellt sind, wobei die Verbindungsvorrichtung anders als in den vorangehenden Figuren und mehrteilig ausgebildet ist und wobei ein Display im Grundkörper integriert ist,
▪ Figur 83 eine Schnittdarstellung der Ausführungsform der elektrischen Schaltvorrichtung nach der Figur 82 entlang der in der Figur 82 eingetragenen Linie L83-L83,
▪ Figur 84 eine Schnittdarstellung der Ausführungsform der elektrischen Schaltvorrichtung nach der Figur 82 entlang der in der Figur 82 eingetragenen Linie L84-L84,
▪ Figur 85 eine Draufsicht einer weiteren Ausführungsform der elektrischen Schaltvorrichtung, wobei die Sensoren als in der Draufsicht verdeckte Teile gestrichelt dargestellt sind, wobei die Verbindungsvorrichtung anders als in den vorangehenden Figuren und als transparente Schicht ausgebildet ist und wobei ein Display im Grundkörper integriert ist,
▪ Figur 86 eine Schnittdarstellung der Ausführungsform der elektrischen Schaltvorrichtung nach der Figur 85 entlang der in der Figur 85 eingetragenen Linie L86-L86,
▪ Figur 87 eine Schnittdarstellung der Ausführungsform der elektrischen Schaltvorrichtung nach der Figur 85 entlang der in der Figur 85 eingetragenen Linie L87-L87,
▪ Figur 88 eine perspektivische Explosionsdarstellung einer Ausführungsform der elektrischen Schaltvorrichtung mit einer Darstellung der elektrischen Anbindung eines in dem Betätigungsteil integrierten Displays an elektrische Komponenten des Grundkörpers,
▪ Figur 89 eine perspektivische Darstellung einer gegenüber der Darstellung der Figur 88 weiteren Ausführungsform der elektrischen Schaltvorrichtung mit einer Darstellung der elektrischen Anbindung eines in dem Betätigungsteil integrierten Display,
▪ Figuren 90 bis 94 Darstellungen einer weiteren Ausführungsform der elektrischen Schaltvorrichtung mit einem Gehäuse,
▪ Figuren 95 bis 102 Darstellungsformate eines in Ausführungsformen der Schaltvorrichtung verwendeten Displays,
▪ Figur 103 ein Ablauf-Diagramm für ein Logistikverfahren, das mit Ausführungsformen der Schaltvorrichtung mit einem Display ausführbar ist,
▪ Figur 104 eine Darstellung der Menüsteuerung, mit der Menüdarstellungen mit zu erfüllenden Aufgaben in einem Display einer Ausführungsform einer Schaltvorrichtung sichtbar bereit gestellt wird,
▪ Figur 105 eine funktionale Darstellung einer Ausführungsform eines Arbeitssystems,
▪ Figur 106 eine funktionale Darstellung einer Ausführungsform der Schaltvorrichtung mit einem Display und einer Verarbeitungsvorrichtung sowie einer externen Arbeitseinrichtung mit einem Zentralsystem und externen Teilnehmern, wobei das Display im Betätigungsteil angeordnet ist,
▪ Figur 107 eine funktionale Darstellung einer Ausführungsform der Schaltvorrichtung mit einem Display und einer Verarbeitungsvorrichtung sowie einer externen Arbeitseinrichtung mit einem Zentralsystem und externen Teilnehmern, wobei das Display im Grundkörper angeordnet ist.

Nach der Erfindung ist eine elektrische Schaltvorrichtung 1 zur Erzeugung von mehreren Schaltzuständen vorgesehen, die über elektrische Leitungen oder einen elektrischen Kontakt von einer Ansteuerungsvorrichtung insbesondere zur Erzeugung von Stellkommandos für eine Stellvorrichtung abgreifbar sind. Zur Erzeugung der Schaltzustände wird die elektrische Schaltvorrichtung 1 auf einer Betätigungsseite S1 desselben betätigt. In den Figurendarstellungen ist ein kartesisches Koordinatensystem mit einer X-Achse, einer Y-Achse oder Dickenrichtung Z und einer z-Achse eingetragen. Die Z-Achse verläuft in der Dickenrichtung Z der elektrischen Schaltvorrichtung 1. In Bezug auf die Dickenrichtung Z der elektrischen Schaltvorrichtung 1 ist in der Z-Richtung entgegen gesetzt zu der Betätigungsseite S1 eine Rückseite S2 der elektrischen Schaltvorrichtung 1 desselben gelegen.

Mit der Schaltvorrichtung 1 kann eine von einem oder mehreren Teilnehmern T bzw. T1, T2, T3 des Arbeitssystems S zu erfüllende Teilnehmer-Aufgabe ermittelt, gegebenenfalls zur Anzeige gebracht werden, und als Aufgabendurchführungs-Kommando über einen Übertragungsweg 93a an das Zentralsystem Z oder einem oder mehreren Teilnehmern T bzw. T1, T2, T3 des Arbeitssystems S, das ein industrielles Arbeitssystem S und insbesondere ein Lagersystem oder eine Produktionsanlage sein kann, übermittelt werden.

Die elektrische Schaltvorrichtung 1 weist einen Grundkörper 10 mit einer ersten oder oberen Oberfläche oder Anschluss-Oberfläche 10a auf, die der Betätigungsseite S1 der elektrischen Schaltvorrichtung 1 zugewandt ist, und eine zweite oder untere Oberfläche 10b auf, die entgegen gesetzt zu der oberen Oberfläche 10a gelegen ist. Der Grundkörper 10 kann insbesondere plattenförmig und dabei insbesondere rechteckförmig gestaltet sein. Die flächige Erstreckung des Grundkörpers 10 verläuft dabei quer zur Dickenrichtung Z und entlang der X-Koordinate und der Y-Koordinate. Die X-Koordinate kann insbesondere definiert sein als eine mittlere Verbindungslinie der Flächenschwerpunkte von jeweils kleinsten Querschnittsflächen, die sich entlang einer Längsrichtung ergeben, oder eine gemittelte Verbindungslinie durch diese.

Weiterhin weist die elektrische Schaltvorrichtung 1 ein Betätigungsteil oder eine Betätigungsplatte 20 auf, das sich quer zur Dickenrichtung Z erstreckt und das in der Dickenrichtung Z gesehen auf dem Grundkörper 10 an der Seite von dessen erster Oberfläche 10a angeordnet ist. Das Betätigungsteil 20 kann insbesondere als Betätigungsplatte ausgeführt sein. Dabei kann das Betätigungsteil 20, wie es in der Ausführungsform der Figur 1 dargestellt ist, in der Draufsicht oder in der Z-Richtung gesehen rechteckförmig oder zumindest im Wesentlichen rechteckförmig gestaltet sein. Unter dem Ausdruck "im Wesentlichen rechteckförmig" wird hierin eine Form verstanden, bei der die jeweils entlang zueinander verlaufenden Randlinien parallel oder in etwa parallel verlaufen und zumindest einer der Eckbereiche abgerundete Ecklinien-Abschnitte haben kann. Ein Verlaufen von Randlinien "in etwa parallel" zueinander soll hierin bedeuten, dass die jeweiligen Randlinien derart zueinander verlaufen, dass zwischen den Tangenten an die jeweiligen Randlinien an einander gegenüber liegenden Punkten der jeweiligen Randlinien maximal ein Winkel von 20 Grad besteht. Das Betätigungsteil 20 kann in der Draufsicht oder in der Z-Richtung gesehen auch oval oder kreisförmig gestaltet sein.

Weiterhin weist die erfindungsgemäße Schaltvorrichtung eine Gehäusevorrichtung H auf, die aus dem plattenförmigen Grundkörper 10 mit der Anschluss-Oberfläche 10a, die einer Betätigungsseite S1 der elektrischen Schaltvorrichtung 1 zugewandt ist, und einem Gehäuseteil H1 gebildet ist.

Das Betätigungsteil 20 weist eine Betätigungsoberfläche 20a, die der Betätigungsseite S1 der elektrischen Schaltvorrichtung 1 zugewandt ist, und eine entgegen gesetzt zu dieser gelegenen und der Anschluss-Oberfläche 10a des Grundkörpers 10 zugewandte Anschluss-Oberfläche 20b auf. Die Betätigungsoberfläche 20a ergibt sich in der Draufsicht auf das Betätigungsteil 20 insbesondere in der Dickenrichtung oder der Z-Richtung.

Der Grundkörper 10 kann insbesondere als Leiterplatten-Anordnung ausgeführt sein, die eine Leiterplatte 10L aus einem Leiterplattenmaterial und mit dieser integrierte elektronische Komponenten aufweist. In der Darstellung der Figur 2 sind mehrere elektronische Komponenten K an der unteren Oberfläche 10b des Grundkörpers 10 angeordnet, die an Leiterbahnen der Leiterplatte 10L angeschlossen sind. Die elektronischen Komponenten K können auch in anderer Weise als dargestellt realisiert sein.

Weiterhin weist die elektrische Schaltvorrichtung 1 eine Verbindungsvorrichtung 30 mit wenigstens einer Verbindungsschicht aus einem elastischen Material auf. Dabei kann vorgesehen sein, dass die Verbindungsvorrichtung 30 aus zumindest einer Verbindungsschicht besteht, dass also die Schaltvorrichtung 1 kein weiteres Verbindungsmittel aufweist. Dabei kann jede der zumindest einen Verbindungsschicht in ihrer flächigen Erstreckung kontinuierlich zusammenhängend ausgebildet sein. Bei anderen Ausführungsformen der Schaltvorrichtung 1 kann vorgesehen sein, dass die zumindest eine Verbindungsschicht oder eine einzelne der zumindest einen Verbindungsschicht eine sich in deren Dickenrichtung Z erstreckende und die Verbindungsschicht in deren ganzen Dicke durchgehende Ausnehmung aufweist bzw. aufweisen. Die zumindest eine Verbindungsschicht der Verbindungsvorrichtung 30 oder die Verbindungsvorrichtung 30 ist generell mit einer ersten Oberfläche 30a an einem Verbindungsbereich oder in der Z-Richtung gesehen inneren Bereich 20c der Anschluss-Oberfläche 20b des Betätigungsteils 20 und mit einer zweiten Oberfläche 30b an einem inneren Bereich 10c der Anschluss-Oberfläche 10a des Grundkörpers 10 befestigt oder mit dem jeweiligen inneren Bereich 10c, 20c verbunden.

Bei der Ausführungsform der Figur 1 besteht die Verbindungsvorrichtung 30 aus einer Verbindungsschicht 31, die mit einer ersten Oberfläche 31a an einem Verbindungsbereich oder in der Dickenrichtung Z gesehen inneren Bereich 20c der Anschluss-Oberfläche 20b des Betätigungsteils 20 und mit einer zweiten Oberfläche 31b an einem in der Dickenrichtung Z gesehen inneren Bereich 10c der Anschluss-Oberfläche 10a des Grundkörpers 10 befestigt oder mit dem jeweiligen inneren Bereich 10c, 20c verbunden ist.

Das elastische Material kann - insbesondere bei jeder der hierin genannten Ausführungsformen - ein selbsthaftendes Material sein, so dass die Verbindungsschicht 31 an den inneren Bereichen 10c, 20c anhaftet. Dazu alternativ oder zusätzlich kann, wie es beispielartig in der Figur 16 dargestellt ist, vorgesehen sein, dass die Verbindungsschicht 31 mittels einer Klebeschicht an einem der inneren Bereiche 10c, 20c oder an beide der inneren Bereiche 10c, 20c angeklebt ist. Insbesondere kann dabei vorgesehen sein, dass die Verbindungsvorrichtung 30 aus einer Verbindungsschicht 31, einer ersten Klebeschicht 30i, die zwischen der Verbindungsschicht 31 und der Anschluss-Oberfläche 10a des Grundkörpers 10 gelegen ist, und einer ersten Klebeschicht 30i, die zwischen der Verbindungsschicht 31 und der Anschluss-Oberfläche 10a des Grundkörpers 10 gelegen ist, gebildet ist oder aus diesen Schichten besteht. Das Klebermaterial kann insbesondere ein elastisches Material sein.

Bei der Ausführungsform der Schaltvorrichtung mit einer zentralen Verbindungsschicht 31, wie sie in den Figuren 1 bis 3 gezeigt ist, kann sich die Verbindungsschicht 31 über die gesamte Anschlussoberfläche 10b oder die gesamte Anschlussoberfläche 20b erstrecken, falls eine der Anschlussoberflächen zumindest in einer Erstreckungsrichtung größer ist als die jeweils andere und je nach dem, welche der Anschlussoberflächen größer ist. Alternativ dazu kann die Größe der inneren Bereiche 10c, 20c, wie es in den Figuren 1 bis 3 dargestellt ist, auch derart definiert sein, dass die diese flächenmäßig maximal 75 % der Größe der Anschluss-Oberfläche 20b des Betätigungsteils 20 beträgt oder innerhalb einer Kreistes glegen ist, dessen Fläche maximal 75 % der Größe der Anschluss-Oberfläche 20b des Betätigungsteils 20 beträgt. Alternativ oder zusätzlich kann definiert sein, dass der Flächenschwerpunkt FS der Betätigungsoberfläche 20a des Betätigungsteils 20 in ihrer flächigen Erstreckung gesehen innerhalb des inneren Bereichs 20c der Anschluss-Oberfläche 20b des Betätigungsteils 20 und innerhalb der Verbindungsschicht 31 gelegen ist.

Bei der Ausführungsform der Schaltvorrichtung nach den Figuren 1 bis 3 ragt das Betätigungsteil 20 vom Flächenschwerpunkt FS aus gesehen über die Verbindungsschicht 31 hinaus, so dass die Schaltvorrichtung 1 einen den Verbindungsbereich oder inneren Bereich 20c der Anschluss-Oberfläche 20b in der flächigen Erstreckung des Grundkörpers 10 gesehen vorstehenden Bereich 20d aufweist. Dabei kann insbesondere vorgesehen sein, dass der vorstehende Bereich 20d den Verbindungsbereich oder inneren Bereich 20c oder die Verbindungsschicht 31 vollständig umgibt, also den Verbindungsbereich oder inneren Bereich 20c oder die Verbindungsschicht 31 umschließt. Der überstehende Bereich ist mit dem Bezugszeichen 20d bezeichnet. Dieser ist in der Ausführungsform der Figur 1 die Verbindungsschicht 31 umlaufend ausgeführt. Danach ist die Anschluss-Oberfläche 20b des Betätigungsteils 20 aus dem Verbindungsbereich 20c und dem überstehende Bereich 20d gebildet.

Das Material der Verbindungsschicht 31 ist insofern elastisch, als diese auf ein Zusammendrücken eine Rückstellkraft erzeugt. Das Material der Verbindungsschicht 31 kann insbesondere aus einem Acrylmaterial gebildet sein. Insbesondere kann das Material ein schaumförmiges Acrylmaterial sein. Insbesondere kann ein sowohl beidseitig selbstklebendes als auch elastisches Material aus dem Bereich der industriellen Klebetechnik verwendet werden, wie es beispielsweise unter der Produktbezeichnung "ACXplus" von der Firma "tesa SE" angeboten wird. Die Verbindungsschicht 31 kann auch aus Silikon oder einem Schaum-Material gebildet sein. Auch kann die Verbindungsschicht 31 aus einem Schaum-Material mit Acrylanteilen bestehen. Insbesondere in dem Fall, dass in dem Grundkörper 10 ein Display angeordnet ist und das Display in der Dickenrichtung Z gesehen zumindest teilweise innerhalb der Verbindungsschicht 31 gelegen ist, kann die Verbindungsschicht 31 aus einem optisch durchsichtigen Material gebildet sein, so dass hinter der Verbindungsschicht 31 liegende Anzeigeelemente sichtbar sind.

Die Dicke der Verbindungsschicht 31 in der Z-Richtung kann zwischen 0,2 mm und 10 mm, jedoch vorzugweise zwischen 0,2 mm und 5 mm betragen.

Das Gehäuseteil H1 der Gehäusevorrichtung H weist auf: eine Seitenwand H4, die die Verbindungsvorrichtung 30, soweit dieses Teil der Schaltvorrichtung 1 ist, und das Betätigungsteil 20 in der Dickenrichtung Z gesehen zumindest abschnittsweise umgibt, und ein Randabschnitt H5, der sich zu der Betätigungsseite S1 hin an der Seitenwand H4 anschließt und eine zentrale Öffnung H7 ausbildet, in der sich zumindest abschnittsweise das Display 80 erstreckt.

Die Seitenwand H4 erstreckt sich entlang der Z-Richtung und kann als das Betätigungsteil 20 kontinuierlich umlaufende Wand ausgebildet sein. Auch kann die Seitenwand H4 derart ausgeführt sein, dass diese das Betätigungsteil 20 entlang seines Umfangs abschnittsweise umgibt, also z.B. mehrere entlang des Umfangs des Betätigungsteils 20 verteilt angeordnete Ausnehmungen aufweist. Dabei kann die Seitenwand H4 z.B. seitlich von dem Betätigungsteil 20 ausgehen und insbesondere sich an die sich in der Z-Richtung gesehen ergebende Außenfläche 14 anschließen.

Auch kann, wie es in den Figuren 2 und 3 dargestellt ist, das Gehäuseteil H1 eine Haltevorrichtung H9 aufweisen, von der der Grundkörper 10 aufgenommen ist und an der der Grundkörper 10 befestigt sein kann. Die Haltevorrichtung H9 kann als Sockel oder gemäß der Figur 2 als Haltearm ausgeführt sein.

Das Gehäuseteil H1 weist nach einer Ausführungsform ein Bodenteil H10 und ein Abdeckungsteil H20 auf. Dabei kann die Haltevorrichtung H10 als Anbauteil des Bodenteils H10 ausgeführt sein. Das Bodenteil H10 und das Abdeckungsteil G20 können zusammen aus einem Stück hergestellt sein, z.B. durch ein Gießverfahren und insbesondere ein Kunststoff-Spritzgussverfahren. In der Darstellung der Figuren 1 bis 3 ist das Gehäuse als zweiteiliges Gehäuse ausgeführt, wobei der das Bodenteil H10 als ein erstes Teil und das Abdeckungsteil H20 als ein zweites Teil ausgebildet sind und das Abdeckungsteil H20 auf dem Bodenteil H10 aufgesetzt und an diesem fixiert ist, so dass das Gehäuse insgesamt ein Teil bildet. Das Bodenteil H10 und das Abdeckungsteil G20 können jeweils insbesondere schalenförmig gebildet sein. Auch kann das Gehäuseteil H1 derart ausgebildet sein, dass nur das Bodenteil H10 oder nur das Abdeckungsteil G20 können jeweils insbesondere schalenförmig gebildet sein.

Bei der Ausführungsform der Figuren 1 bis 3 ist die Seitenwand H4 in der Dickenrichtung Z gesehen zumindest teilweise außerhalb des Betätigungsteils 20 gelegen. Dabei kann die Seitenwand H4 den Grundkörper 10 entlang dessen Umfang umgeben. An die Seitenwand H4 schließt sich in Richtung zur Betätigungsseite S1 ein Randabschnitt H5 des Gehäuseteils H1 an, der eine in der Z-Richtung gesehen innere zentrale Öffnung H7 aufweist. Der Außenrand der Betätigungsplatte 20 verläuft entlang dem die Öffnung H7 ausbildenden Innenrand H8.

Bei einer Ausführungsform der Schaltvorrichtung 1 kann derart ausgeführt sein, dass der äußere Randabschnitt 21 der Betätigungsplatte 20 in der Z-Richtung gesehen innerhalb des Innenrands Randabschnitt H5 des Gehäuseteils H1 gelegen ist, so dass das Betätigungsteil 20 in der Z-Richtung gesehen innerhalb der Öffnung H7 gelegen ist (Figur 2).

Generell, aber insbesondere in dieser Ausführungsform kann eine Dichtung G40 zwischen dem Randabschnitt H5 des Gehäuseteils H1 und einem Randabschnitt des Betätigungsteils 20 gelegen sein, die diese Randabschnitte miteinander verbindet (Figur 16), insbesondere um den Innenraum des Gehäuseteils H1 nach außen abzudichten. In diesem Fall kann die Dichtung G40 Teil der Verbindungsvorrichtung 30 sein. Dabei kann die Dichtung G40 aus einem elastischen Material gebildet sein, so dass diese die Rückstellfähigkeit der Verbindungsschicht 31 unterstützt. Die Dichtung kann auch abschnittsweise entlang des Umfangs des Randabschnitts H5 gelegen sein.

Auch kann in der Z-Richtung gesehen ein Abstand zwischen dem äußeren Randabschnitt 21 der Betätigungsplatte 20 und dem Innenrand Randabschnitt H5 des Gehäuseteils H1 bestehen (Figur 34), wobei eine Dichtungsvorrichtung oder ein Abdeckungsvorrichtung G50 z.B. in Form eine Abdeckungsrings oder einer Abdeckungsmembran die äußere Randabschnitt 21 der Betätigungsplatte 20 und den Randabschnitt H5 des Gehäuseteils H1 verbinden, um den Innenraum des Gehäuseteils H1 nach außen abzudichten. Bei einer weiteren Ausführungsform kann die Schaltvorrichtung 1 bei dem Vorhandensein der Dichtung G40 ohne Verbindungsschicht 31 ausgeführt sein, so dass die Dichtung G40 die Verbindungsvorrichtung 30 bildet.

Eine weitere Ausführungsform der Schaltvorrichtung 1 kann derart ausgeführt sein, dass der äußere Randabschnitt 21 der Betätigungsplatte 20 in der Z-Richtung gesehen über den Innenrand Randabschnitt H5 des Gehäuseteils H1 hinausragt, so dass sich das Betätigungsteil 20 und der äußere Randabschnitt 21 der Betätigungsplatte 20 in der Z-Richtung gesehen überlappen (Figur 16). Gemäß den Figuren 54 bis 57 kann bei einer weiteren Ausführungsform der elektrischen Schaltvorrichtung 1 vorgesehen sein, dass der umlaufende Randabschnitt H5 des Gehäuseteils H1 mit dem Betätigungsteil 20 und insbesondere mit einem Außenrand desselben verbunden ist. Dabei kann vorgesehen sein, dass die Schaltvorrichtung 1 keine Verbindungsschicht aufweist und der Randabschnitt H5 des Gehäuseteils H1 als Rückstellvorrichtung für das Betätigungsteil 20 ausgeführt ist, indem dieses elastisch verformbar ist.

Die Verbindungsschicht 31 kann, jedoch muss nicht aus einem elastischen und somit das Betätigungsteil 20 rückstellbare Material sein, wenn die Verbindungsvorrichtung 30 ein weiteres das Betätigungsteil 20 rückstellbares Bauteil aufweist, z.B. eine Dichtung H40 oder eine Verbindung eines Randabschnitts H5 des GehäuseteilsBetätigungsteils 20.

Auch weist die elektrische Schaltvorrichtung 1 zumindest einen Sensor oder zumindest zwei Sensoren auf, der bzw. die zwischen dem Grundkörper 10 und dem Betätigungsteil 20 gelegen sowie in der Dickenrichtung Z gesehen seitlich der Verbindungsschicht 31 gelegen ist bzw. sind, wobei sich das Betätigungsteil 20 quer zur Dickenrichtung Z und in der Erstreckung der X-Y-Ebene gesehen über die Verbindungsschicht 31 und über jeden des jeweiligen Sensors hinaus erstreckt.

Bei der Ausführungsform der Verbindungsvorrichtung 30 mit der Verbindungsschicht 31 gemäß der Figur 1 ist jeder des zumindest einen Sensors ist in der Dickenrichtung Z gesehen von dem Flächenschwerpunkt des Betätigungsteils 20 aus gesehen hinter der Verbindungsvorrichtung 31 gelegen.

Aufgrund der jeweiligen Lage des zumindest einen Sensors oder der Sensoren kann jeweils eine Position eines jeweils an diesem gelegenen Bereichs der zweiten Oberfläche in der Dickenrichtung Z erfasst oder ermittelt werden. Insbesondere kann aufgrund der Lage der Sensoren der Abstand zwischen der Anschluss-Oberfläche 10a des Grundkörpers 10 und der Anschluss-Oberfläche 20b des Betätigungsteils 20 in der Dickenrichtung Z gesehen an der Position des jeweiligen Sensors in der X-Y-Ebene gesehen erfasst oder ermittelt werden.

Die Schaltvorrichtung 1 kann eine Sensor-Vorrichtung 40 aufweisen, die den zumindest einen Sensor sowie eine Positionsermittlungs-Vorrichtung mit einer Positionsermittlungs-Funktion aufweist, die Positionsermittlungs-Funktion funktional mit dem jeweiligen Sensor verbunden ist. Die Positionsermittlungs-Funktion kann in einer der elektronischen Komponenten K des Grundkörpers 10 integriert sein.

Die Ausführungsform der elektrischen Schaltvorrichtung 1, die in der Figur 1 gezeigt ist, weist vier Sensoren 41, 42, 43, 44 auf. Diese sind entlang der den Außenumfang der Randlinie gleichmäßig verteilt angeordnet. Dabei sind jeweils zwei Sensoren, nämlich jeweils die Sensoren 41 und 43 und die Sensoren 42 und 44 in Bezug auf den Flächenschwerpunkt F der Betätigungsoberfläche 20a einander gegenüber liegend angeordnet. Mit jedem Sensor 41, 42, 43, 44 kann jeweils eine Position eines jeweils an diesem gelegenen Bereich der zweiten Oberfläche in der Dickenrichtung Z erfasst werden.

Der zumindest eine Sensor oder die Sensoren können jeweils als Sensor zur berührungslosen Erfassung des Abstands von dem jeweiligen Sensor zu der diesem gegenüber liegenden Stelle der Anschluss-Oberfläche 20b des Betätigungsteils 20 ausgeführt sein. Die Figur 3 eine Schnittdarstellung der Ausführungsform der elektrischen Schaltvorrichtung nach der Figur 1 entlang der in der Figur 1 eingetragenen Linie L3-L3, wobei berührungslose Sensoren in Form von optischen Sensoren verwendet werden. Die Figur 4 zeigt eine Schnittdarstellung der Ausführungsform der elektrischen Schaltvorrichtung nach der Figur 1 entlang der in der Figur 1 eingetragenen Linie L3-L3, wobei berührungslose Sensoren in Form von induktiven Sensoren verwendet werden. Bei der in der Figur 2 dargestellten Schaltvorrichtung 1 ist somit jeder der Sensoren 41, 42, 43, 44 als ein optischer Sensor ausgeführt.

Nach einer Ausführungsform sind Sensoren 41, 42, 43, 44 vorgesehen, die jeweils berührungslos den Abstand von demselben zu der dem jeweiligen Sensor gegenüber liegenden Stelle der Anschluss-Oberfläche 20b des Betätigungsteils 20 erfasst.

Die Sensoren können nicht nur berührungslos arbeitende Sensoren wie z.B. optische Sensoren sein, sondern auch magnetisch empfindliche oder den piezoelektrischen Effekt ausnutzende Sensoren sein.

Nach einer weiteren Ausführungsform In den Figuren 15 und 16 ist eine Ausführungsform der Sensoren 41, 42, 43, 44 dargestellt, bei der jeder der Sensoren 41, 42, 43, 44 jeweils mechanische Sensoren sind, die z.B. als Schaltsensoren mit einer Schaltkomponente ausgeführt sind.

Nach einer Ausführungsform der elektrischen Schaltvorrichtung 1 kann diese ein Display 80 oder ein Anzeigepaneel aufweisen, so dass diese Ausführungsform eine Ein- und Ausgabevorrichtung bilden. Das Display 80 kann auf der Anschluss-Oberfläche 10a des Grundkörpers 10 oder auf der Betätigungsoberfläche 20a des Betätigungsteils 20 angeordnet und insbesondere gelegen sein. Bei Ausführungsformen der Schaltvorrichtung 1 kann das Display 80 zumindest teilweise in einer Ausnehmung gelegen sein, die durch die Anschluss-Oberfläche 10a des Grundkörpers 10 oder auf der Betätigungsoberfläche 20a des Betätigungsteils 20 geformt ist.

Generell kann die Schaltvorrichtung 1 eine Kameravorrichtung C aufweisen. In der Figur 92 ist eine Kameravorrichtung C schematisch durch eine in das Gehäuseteil H1 integrierte Linse dargestellt. Die Kameravorrichtung C kann insbesondere ein optisches System mit einer Linse und einer Kamera-Betätigungsvorrichtung sowie eine Bild-Erfassungsvorrichtung aufweisen. Die Bild-Erfassungsvorrichtung kann insbesondere eine Barcode-Erkennungsfunktion aufweisen, mit der ein mittels der Kamera erfasster Barcode hinsichtlich der in diesem enthaltenen Funktionen interpretiert werden kann.

Auch kann das Gehäuseteil G1 und insbesondere das Bodenteil H10 aus einem magnetischen Material gebildet sein, um das Gehäuseteil G1 in einem Anwendungsraum an ein metallisches Ausstattungsteil dieses Anwendungsraums anordnen zu können.

Insbesondere bei den in den Figuren 1 bis 3 und der Figur 90 gezeigten Ausführungsformen des Schaltvorrichtung 1 weist das Betätigungsteil 20 ein Display 80 oder Anzeigepaneel auf, das in einem in der Dickenrichtung Z gesehen inneren Display-Bereich 20e der Betätigungsoberfläche 20a des Betätigungsteils 20 gelegen ist. Durch die Anzeigevorrichtung wird ein Anzeigebereich und wird gegebenenfalls ein Bedienbereich für einen Benutzer bereitgestellt. Der Display-Bereich 20e kann, wie es in den Figuren 1 bis 3 und Figur 100 dargestellt ist, als an der Betätigungsoberfläche 20a geformte Vertiefung ausgeführt sein. Dabei kann das Display 80 in der Dickenrichtung Z gesehenen ganz oder teilweise, also zumindest teilweise in der Vertiefung gelegen sein.

Das Display 80 oder die Anzeigepaneel ist in funktionaler Hinsicht eine Ausgabevorrichtung. Das Display 80 kann insbesondere ein sich flächig ersteckendes Bilderzeugungsmodul 81 und eine in Richtung zu der Betätigungsseite S1 über diese gelegene Bildschirm-Abdeckplatte oder eine Trägerplatte 82 aufweisen. Das Bilderzeugungsmodul 81 kann insbesondere eine Bildausgabe-Vorrichtung mit einer Anzeigevorrichtung wie eine Flüssigkeitsanzeige-Vorrichtung sein.

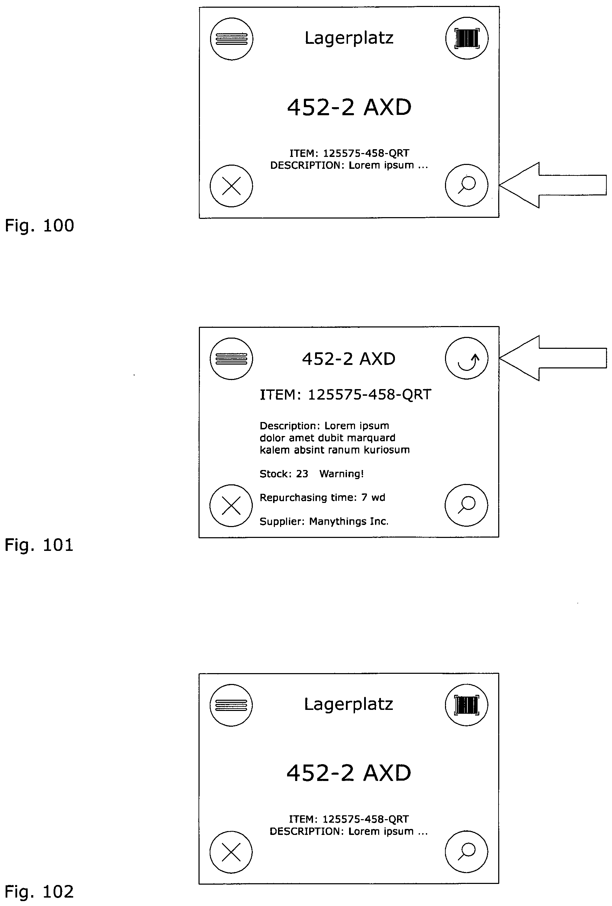

Das Display 80 kann in funktionaler Hinsicht zusätzlich eine Ausgabevorrichtung sein, die zusätzlich als Eingabevorrichtung und in diesem Fall somit als Ein- und Ausgabevorrichtung ausgeführt sein kann. Bei der Ausführung des Display 80 als Ein- und Ausgabevorrichtung kann dieses auch ein annäherungs- und/oder berührungssensitives Paneel oder ein Touch Paneel aufweisen. Das annäherungs- und/oder berührungssensitives Paneel kann insbesondere auf oder unter der Trägerplatte 81 ein annäherungs- und/oder berührungssensitives Paneel 84 oder ein Touch Paneel gelegen sein. In der Figur 100 ist eine Ausführungsform des Display 80 nach der Figur 100 dargestellt, in der das Display 80 ein annäherungs- und/oder berührungssensitives Paneel 84 aufweist.

In einer weiteren Ausführungsform des Schaltgeräts 1 kann dieses mit dem annäherungs- und/oder berührungssensitives Paneel 84, jedoch ohne der elastischen Verbindungsschicht 31 und die Sensoren zur Ermittlung eines einem Abstand entsprechenden Wertes zwischen dem Grundkörper 10 und dem Betätigungsteil 20 ausgeführt sein.

In Bezug auf die Bedienungs- und insbesondere Betätigungsfunktionen der Schaltvorrichtung 1 können auf der Betätigungsoberfläche 20a derselben in Abhängigkeit von der Stelle, an der in der flächigen Erstreckung der Schaltvorrichtung 1 oder entlang der X-Y-Ebene gesehen der jeweilige Sensor des zumindest einen Sensors gelegen ist, Betätigungsbereiche zugeordnet werden.

In der Figur 4 sind für die vier Sensoren 41, 42, 43, 44 und deren jeweils spezifischen Lage auf der Betätigungsoberfläche 20a der Schaltvorrichtung 1 nach der Figur 1 vier Betätigungsbereiche B41 bzw. B42 bzw. B43 bzw. B44 zugeordnet. Diese sind in entsprechenden Randbereichen des Betätigungsteils 20, in denen der jeweilige des zumindest einen Sensors angeordnet ist, gelegen. Die Betätigungsbereiche sind derart gelegen, dass eine Betätigung oder ein Ausüben einer Druckkraft F1, F2 mit einer Mindestgröße in einem jeweiligen Betätigungsbereich eine Verringerung des Abstands zwischen dem Grundkörper 10 und dem Betätigungsteil 20 nur in diesem jeweiligen Betätigungsbereich und somit nur an dem Sensor, der an dem jeweiligen Betätigungsbereich gelegen ist, auftritt. Bei einem durch eine Betätigungsbereich-Identifikationsfunktion 91 ermittelte Überschreiten eines Grenzwerts G1 aufgrund einer entsprechenden Druckkraft wird diese Bewegung als eine Betätigung bewertet der Schaltvorrichtung 1.

In den Figuren 5 bis 8 ist eine Betätigung eines Betätigungsbereichs B41 in mehreren Schritten dargestellt.

In den Schritten nach den Figuren 17 bis 20 ist dargesellt, dass mit zumindest zwei Grenzwerten G1, G2 an demselben Sensor und Betätigungsbereich B41 zwei Betätigungsmöglichkeiten und somit Auswahlmöglichkeiten realisierbar sind.

Mit der Ausführungsform nach der Figur 33 ist dazu alternativ oder zusätzlich gezeigt, dass an einem Betätigungsbereich z.B. dem Betätigungsbereich B41, mehrere Betätigungsmöglichkeiten und somit Auswahlmöglichkeiten realisierbar sind, wenn an zumindest einem Betätigungsbereich zwei Sensoren angeordnet sind, mit denen durch die Betätigungsbereich-Identifikationsfunktion 91 an demselben Betätigungsbereich das Überschreiten zumindest eines Grenzwertes G1, G3 ermittelt werden kann. Somit ist an jedem Sensor 41, 42, 43, 44 jeweils ein zusätzlicher in Bezug auf den Flächenschwerpunkt des Betätigungsteils 20 innerer Sensor 51, 52, 53, 54 angeordnet, der jeweils zwischen einem äußeren Sensor 41, 42, 43, 44 und dem Flächenschwerpunkt des Betätigungsteils 20 gelegen ist. Dabei ist, wie in den Figuren 35 bis 38 gezeigt ist, insbesondere vorgesehen, dass der Grenzwert G1 des vom Flächenschwerpunkt des Betätigungsteils 20 aus gesehen äußeren Sensors kleiner ist wie der Grenzwert G3 des jeweils zugeordneten inneren Sensors 51, 52, 53, 54, wobei insbesondere ein Faktor von mindestens 1,1 vorgesehen sein kann.

In der Figuren 44 bis 47 ist gezeigt, dass das Betätigungsteil derart in seiner flächigen Erstreckung elastisch ausgeführt sein kann, dass zumindest zwei entgegen gesetzt zueinander gelegene Betätigungsbereiche, z.B. diametral zueinander entgegen gesetzt gelegene Betätigungsbereiche (z.B. B41 und B42) oder an derselben Seitenkante des Betätigungsteils 20 gelegene Betätigungsbereiche (z.B. B41 und B43) oder optional auch drei oder vier Betätigungsbereiche (z.B, B41, B42, B43 und B44) eine ausreichende Abstandsverringerung an zwei Sensoren durch entsprechende Betätigung (F1, F2) unter Bereitstellung einer entsprechenden Rückstellfähigkeit des Betätigungsteils 20 gegeben sein kann.

Zur Realisierung der Betätigungsfunktion der Schaltvorrichtung 1 sind bei dem Vorhandensein von mehreren Sensoren einer Schaltvorrichtung 1 ist die flächige Relation der Betätigungsbereiche in der Dickenrichtung Z gesehen an Stellen gleich der räumlichen Relation der Stellen, an denen die S gelegen sind. Zusätzlich sind die Bereiche in der Dickenrichtung Z gesehen und die Stellen der Sensoren übereinander gelegen, so dass sich die jeweilige flächige Relation ergibt.

Unter der Bezeichnung "flächige Relation" wird hierin die relative Zuordnung der Betätigungsbereiche in der X-Y-Ebene verstanden. Unter der Bezeichnung "Stellen der Sensoren" wird hierin die Positionen der Sensoren in der in der X-Y-Ebene verstanden.

In den Figuren 58 bis 66 sind verschiedene Ausführungsformen einer in der Dickenrichtung Z gesehen und innerhalb der oberen Oberfläche oder Anschluss-Oberfläche 10a des Grundkörpers 10 zentral angeordneten Verbindungsvorrichtung 30 dargestellt.

In den Figuren 67, 79, 82 sind Ausführungsformen der Schaltvorrichtung 1 dargestellt, bei denen die Verbindungsschichten in einem äußeren Bereich der Anschluss-Oberfläche 20b des Betätigungsteils 20 und mit einer zweiten Oberfläche 30b an einem äußeren Bereich der Anschluss-Oberfläche 10a des Grundkörpers 10 befestigt sind.

Bei der Ausführungsform der Schaltvorrichtung 1 nach der Figur 79 weist deren Verbindungsvorrichtung 30 nicht eine zentrale Verbindungsschicht auf. Vielmehr ist die Verbindungsvorrichtung 30 aus mehreren Verbindungsschichten 61, 62, 63, 64 gebildet, die um den Flächenschwerpunkt des Betätigungsteils 20 entlang des äußeren Randabschnitts 21 des Betätigungsteils 20 über diesen verteilt angeordnet sind. Diese Anordnung von verteilt angeordneten Verbindungsschichten 61, 62, 63, 64 können auch bei anderen der hierin beschriebenen Ausführungsformen angeordnet sein. Die Verbindungsschichten 61, 62, 63, 64 sind länglich geformt.

Bei der Ausführungsform der Schaltvorrichtung 1 nach der Figur 79 ist das Display 80 in die Grundplatte 10 integriert, wobei das Display 80 an der ersten Oberfläche 10a der Grundplatte 10 gelegen sein kann. Dabei ist das Betätigungsteil aus einem transparenten Material gebildet, so dass Darstellungen des Displays 80 an der Betätigungsseite S1 erkennbar sind.

Bei der Ausführungsform der Schaltvorrichtung 1 nach der Figur 82 weist eine Verbindungsvorrichtung 30 auf, die ebenfalls keine zentrale Verbindungsschicht aufweist, sondern gegenüber der Schaltvorrichtung 1 nach der Figur 79 kreisförmige Verbindungsschichten 61, 62, 63, 64 aufweist, die um den Flächenschwerpunkt des Betätigungsteils 20 entlang des äußeren Randabschnitts 21 des Betätigungsteils 20 über diesen verteilt angeordnet sind. Auch bei der Ausführungsform der Schaltvorrichtung 1 nach der Figur 82 ist das Display 80 in die Grundplatte 10 integriert.

Die Schaltvorrichtung 1 nach der Figur 79 oder 82 kann eine zusätzliche am Flächenschwerpunkt des Betätigungsteils 20 gelegene, zentrale Verbindungsschicht 31 z.B. gemäß der Figur 1 aufweisen.

In den Figuren 88 und 89 sind beispielartig verschiedene Ausführungsformen einer elektrischen Anbindung des Display 80 an elektrische Komponenten K der Bodenplatte 10 mittels einer Verbindungsvorrichtung V dargestellt. Bei der in der Figur 88 dargestellten Ausführungsform weist die Schaltvorrichtung 1 einen Kabelstrang von Leitungen auf, die einerseits mit elektrischen Komponenten des Displays 80 und andererseits mit elektrischen Komponenten K der Bodenplatte 10 verbunden sind. Dabei wird der Kabelstrang durch eine zentrale Öffnung des Betätigungsteils 20 und, bei einer zentral angeordneten Verbindungsschicht 31, eine zentrale Öffnung der Verbindungsschicht 31 hindurch erstreckt. Bei der in der Figur 89 dargestellten Ausführungsform weist die Schaltvorrichtung 1 wird ein solcher Kabelstrang an einer Seite der Schaltvorrichtung 1, also seitlich außerhalb des Betätigungsteils 20 und der Verbindungsvorrichtung 30 geführt und an derselben Seite seitlich zu der Grundplatte geführt, von wo eine Verdrahtung der Leitungen mit elektrischen Komponenten K der Bodenplatte 10 realisiert ist.

Generell und insbesondere bei dem Vorhandensein von mehreren Sensoren einer Schaltvorrichtung 1 sind die Betätigungsbereiche derart gelegen, dass eine Betätigung oder ein Ausüben einer Druckkraft mit einer Mindestgröße in einem jeweiligen Betätigungsbereich
- in Abhängigkeit der Ausführung der Verbindungsvorrichtung und insbesondere der Gestalt, Anzahl und Lage oder Anordnung der zumindest einen Verbindungsschicht
- in Richtung von der Betätigungsseite S1 zum Grundkörper 10 hin
eine ausreichende Verringerung des Abstands zwischen dem Grundkörper 10 und dem Betätigungsteil 20 nur in diesem jeweiligen Betätigungsbereich und somit nur an dem Sensor 40, der an dem jeweiligen Betätigungsbereich oder Steuerungsfeld gelegen ist, auftritt. Dabei ist der Sensor 40 und eine mit diesem funktional verbundene Funktions-Verarbeitungsvorrichtung oder Auswertungsvorrichtung 90 (Figuren 106 und 107) derart ausgeführt, dass bei einer solchen Aktion mittels einer Aktivierungs-Identifikationsfunktion 91 die Betätigung des jeweiligen Betätigungsbereichs erfasst wird.

Bei Vorhandensein eines annäherungssensitiven und/oder berührungssensitiven Paneels 82, das z.B. auf einem plattenförmigen Bilderzeugungsmodul 81 angeordnet ist, kann mittels eines Bilderzeugungs-Generators 97 sichtbar gemacht werden. Dabei wird ein jeweilige Steuerungsfeld im Anzeigebereich eines Anzeigepaneels bzw. im z.B. plattenförmigen Bilderzeugungsmodul 81 des Displays 80 durch Generierung mittels des Bilderzeugungs-Generators 97 sichtbar gemacht. Es können in Bezug auf die Lage der Sensoren 40 an weiteren Stellen Steuerungsfelder zur Anzeige gebracht werden.

Die Auswertungsvorrichtung 90 kann derart ausgeführt sein, dass die Aktivierungs-Identifikationsfunktion 91 von dem zumindest einen Sensor der Schaltvorrichtung 1 über eine Funktionsleitung 91e Signale erhält, die einer ausreichenden Verringerung des Abstands zwischen dem Grundkörper 10 und dem Betätigungsteil 20 entsprechen, bei der die Betätigungsbereich-Identifikationsfunktion 91 eine Betätigung identifiziert. Auf diese Weise kann die Erfassung mittels eines Sensors 40 durch die Aktivierungs-Identifikationsfunktion 91 bestätigt werden.

Bei Vorhandensein eines annäherungssensitiven und/oder berührungssensitiven Paneels 82 kann das jeweils Steuerungsfeld, das in seiner Lage der relativen Lage eines Display-Betätigungsbereichs entsprechen kann und insbesondere in diesem gelegen sein kann, durch ein Menü-Steuerungsmodul 96 und einen mit diesem funktional verbundenen Bildgenerator 97 mittels des mit diesem funktional verbundenen Bilderzeugungsmoduls 81 oder in dem Bilderzeugungsmodul 81, also im Display 80, an einem Display-Betätigungsbereich sichtbar gemacht werden. Mittels der Aktivierungs-Identifikationsfunktion 91, die über die Leitung 97a mit dem annäherungssensitiven und/oder berührungssensitiven Paneel 82 funktional verbunden ist, kann erfasst werden, ob das jeweils im Display 80 sichtbar gemachte Steuerungsfeld durch eine manuelle Geste betätigt worden ist.

Durch das Menü-Steuerungsmodul 96 werden je nach den bereitgestellten Benutzerfunktionen und einem mit diesen jeweils zur Ansicht auf dem Display 80 gebrachten Menüformat dem jeweiligen Steuerungsfeld Bedeutungen zugeordnet, die insbesondere im Zusammenhang mit zu erfüllenden Aufgaben einer externen Arbeitseinrichtung E und insbesondere von Teilnehmern T oder einem Zentralsystem Z stehen.

Generell und insbesondere bei einer Ausführungsform des Schaltgeräts 1 mit dem annäherungs- und/oder berührungssensitives Paneel 84 und ohne der Verbindungsvorrichtung mit einer insbesondere elastischen Verbindungsschicht 31, dabei optional ohne Betätigungsteil 20, und ohne Sensor-Vorrichtung 40 kann das Schaltgerät 1 derart ausgeführt sein, dass die Betätigung eines Steuerfelds in einer Menüauswahl durch Auswahl einer in dem Steuerbereich angegebenen Option mittels Berührung oder Berührungsannäherung des Fingers eines Schaltgerät-Benutzers einer solchen Option, die im Anzeigebereich des Display 80 verfügbar gemacht wird, erfolgen kann.

Generell und insbesondere bei einer Ausführungsform des Schaltgeräts 1 ohne einem annäherungs- und/oder berührungssensitives Paneel 84 und ohne der elastischen Verbindungsschicht 31, dabei optional ohne Betätigungsteil 20, und Sensoren 40 kann das Schaltgerät 1 derart ausgeführt sein, dass die Betätigung eines Steuerfelds in einer Menüauswahl durch herkömmliche Aktivierung oder Auswahl einer in dem Steuerbereich angegebenen Option, die im Anzeigebereich des Display 80 verfügbar gemacht wird, erfolgen kann, also z.B. durch Tasten oder einer Computermaus oder einer anderen manuellen Eingabevorrichtung.

Die Betätigung eines Steuerfelds in einer Menüauswahl Berührung oder Berührungsannäherung und alternativ oder zusätzlich durch herkömmliche Aktivierung kann bei den auch bei der Ausführungsform mit der elastischen Verbindungsschicht 31 und Sensoren 40 gegeben sein.

Wie in den Figuren 100 und 101 gezeigt, werden bei einer Ausführungsform des Schaltgeräts 1 mit der elastischen Verbindungsschicht 31 und Sensoren 40 die von dem zumindest einen Sensor erzeugten Sensorsignale, die in Abhängigkeit einer am jeweiligen Betätigungsbereich ausgeübten Betätigungskraft F1, F2 Abstandswerten für Abstände zwischen dem Grundkörper 10 und dem Betätigungsteil 20 entsprechen, über mit jeweils einem Sensor verbundene Funktionsleitungen 91e der Betätigungsbereich-Identifikationsfunktion 91 zugeführt. Diese ermittelt aus diesen Sensorsignalen an Hand von vorgegebenen Betätigungs-Mindestwerten, ob aufgrund der jeweils ausgeübten Betätigungskraft F1, F2 eine Betätigung eines Betätigungsbereichs, bei der Ausführungsform der Figur 1 einer der Betätigungsbereiche B41 bzw. B42 bzw. B43 bzw. B44, gegeben ist. Die Betätigungsbereich-Identifikationsfunktion 91 ermittelt an Hand von zumindest einem vorgegebenen Betätigungs-Mindestwert, der jeweils einem Sensor zugeordnet ist, ob der Abstand zwischen dem Grundkörper 10 und dem Betätigungsteil 20 am Ort des Sensors, der jeweils an einem durch eine Betätigungskraft F1, F2 bewegten Betätigungsbereichs gelegen ist, einen vorgegebenen Betätigungs-Mindestwert überschreitet. Wenn dieser Vergleich eine solche Überschreitung feststellt, stellt die Betätigungsbereich-Identifikationsfunktion 91 fest, dass an dem jeweiligen Betätigungsbereich eine Betätigung des Betätigungsteils 20 gegeben ist. Dabei kann auch vorgesehen sein, dass mehrere Grenzwerte G1, G2 bzw. G1, G3 mit den Sensorwerten eines Sensors oder der Sensoren verglichen werden, so dass mehrere Kraftstufen einer Betätigungskraft F1, F2 als unterschiedliche Betätigungen an demselben Betätigungsbereich festgestellt werden können. Der zumindest eine Betätigungs-Mindestwert kann in der Betätigungsbereich-Identifikationsfunktion 91 als zumindest ein vorgegebener Wert abgespeichert sein. Alternativ oder zusätzlich dazu kann vorgesehen sein, dass der zumindest eine Betätigungs-Mindestwert über eine Schnittstelle 95 und mittels dem Menü-Steuerungsmodul 96 der Betätigungsbereich-Identifikationsfunktion 91 zugeführt ist, beispielsweise wiederum über eine Menüfunktion, die über die Betätigung eines Betätigungsbereichs in einer vorgegebenen Menüebene oder Menüauswahl ausgewählt werden kann.

Wenn die Betätigungsbereich-Identifikationsfunktion 91 feststellt, dass eine Betätigung eines Betätigungsbereichs aufgrund der voranstehend beschriebenen Weise oder auf andere Weise wie Berührung oder Annäherung gegeben ist, sendet die Betätigungsbereich-Identifikationsfunktion 91 diese Betätigungsinformation über eine Funktionsleitung 91b an ein Betätigungsmodul 92.

Je nach der Ausführungsform des Schaltgeräts 1 kann die Betätigungsinformation, die über eine Funktionsleitung 91b an ein Betätigungsmodul 92 übermittelt wird, auch anders erzeugt werden, z.B. durch Berührung oder Berührungsannäherung bei einer Eingabegeste des Fingers eines Schaltgerät-Benutzers einer in einem von dem Generator 97 in dem Bilderzeugungsmodul 81 erzeugten Steuerbereich oder steuerungsfeld, der im Anzeigebereich des Display 80 als Eingabeoption verfügbar gemacht wird, oder herkömmliche Aktivierung einer solchen Option durch Tasten oder einer Computermaus oder einer anderen manuellen Eingabevorrichtung, wird.

Eine Information über eine jeweils zu erfüllende Teilnehmer-Aufgabe, über die das Menü-Steuerungsmodul 96 in einem jeweiligen Steuerungsfeld eine logische Aufgabenfrage insbesondere in Form einer Option zur Verfügung stellt, wird dem Betätigungsmodul 92 über eine Funktionsleitung 96a zur Verfügung gestellt. Eine Option oder logische Frage kann z.B. sein: "Senden einer Anzahl N1 von Lagerobjekten O1 an einen Warenausgang".

Auch kann das Menü-Steuerungsmodul 96 derart ausgeführt sein, dass mit diesem die Auswahl einer Menü-Ebene oder eines Menüauswahl-Formats insbesondere mit einer Auswahlmöglichkeit über ein wählbares Auswahlformat im oder am Betätigungsbereich zur Anzeige gebracht wird, um eine zu erfüllende Teilnehmer-Aufgabe zu ermitteln und zur Anzeige zu bringen. Hierzu zeigt das Menü-Steuerungsmodul 96 über ein Menü eine Aufgabe oder eine Anfrage über ein Menü wie z.B. Anfrage über eine Menü-Ebene, also ein Menüauswahl-Format, auf dem Display 80 an. Die Auswahl eines Menüformats in einer dargestellten Menüauswahl erfolgt über eine mittels der Betätigungsbereich-Identifikationsfunktion 91 insbesondere aufgrund einer der hierin beschriebenen Optionen festgestellte Betätigung und indem aufgrund dieserBetätigung eine Betätigungsinformation über die Funktionsleitung 96a an das Menü-Steuerungsmodul 96 übermittelt wird, das daraufhin das ausgewählte Menüformat auf dem Display 80 zur Verfügung stellt.

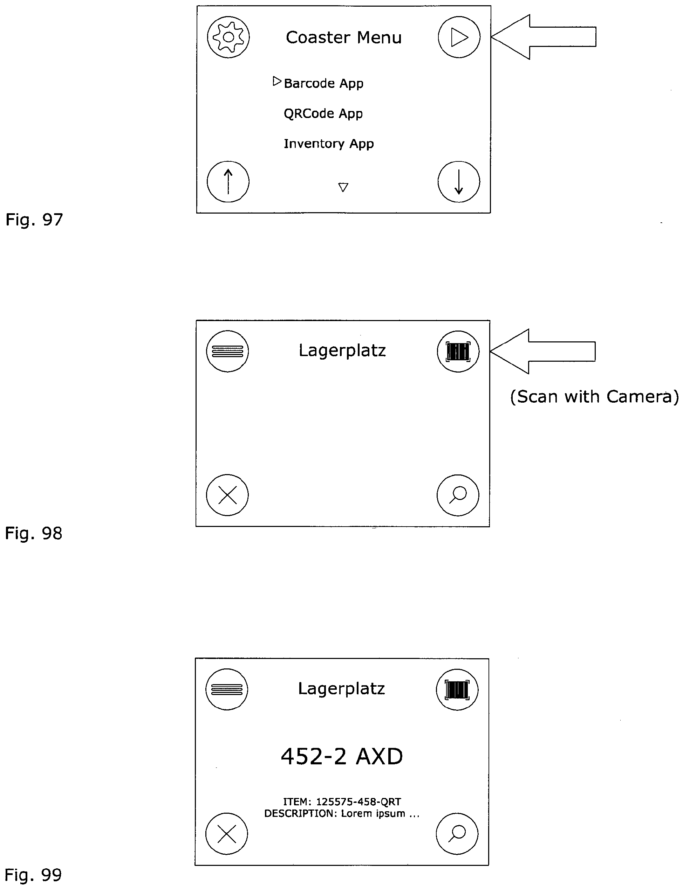

Das Menü-Steuerungsmodul 96 kann auch derart ausgeführt sein, dass auf diese Weise, also mit Auswahlmöglichkeiten über ein wählbares Auswahlformat, eine Anwendungsfunktion, die in der Figur 97 mit der Bezeichung "App" bezeichnet ist, oder eine von mehreren Anwendungsfunktionen, durch eine genannte Betätigung ausgewählt werden kann. Dabei kann vorgesehen sein, dass die Anwendungsfunktion "App" über die Schnittstelle 95 eine genannte Betätigung angewählt werden kann und übermittelt wird oder in dem Menü-Steuerungsmodul 96 verfügbar ist und angewählt werden kann.

Somit kann nach einer Ausführungsform des Arbeitsverfahrens in der ausgewählten Anwendungsfunktion App zumindest eine von einem oder mehreren Teilnehmern T; T1, T2, T3 des Arbeitssystems S zu erfüllende Teilnehmer-Aufgabe auf dem Display 80 auswählbar ist

Das Betätigungsmodul 92 ermittelt aus der Information über die angefragte Teilnehmer-Aufgabe und der Betätigungsinformation ein Aufgabendurchführungs-Kommando, das über eine Ausgangsleitung 92a an eine Ausgangsschnittstelle 93 übermittelt wird. Das Aufgabendurchführungs-Kommando ist ein Kommando für einen Teilnehmer T, eine Aufgabe TA durchzuführen. Die Ausgangsschnittstelle 93 übermittelt das Signal an eine externe Einheit wie z.B. dem Zentralsystem oder einem Teilnehmer T bzw. T1, T2, T3 des Arbeitssystems S.

Alternativ kann vorgesehen sein, dass die Information über die angefragte Teilnehmer-Aufgabe statt über die Funktionsleitung 96a über die Funktionsleitung 91a an das Betätigungsbereich-Identifikationsfunktion 91 gesendet wird, das die Information über die angefragte Teilnehmer-Aufgabe zusammen mit der Betätigungsinformation über die Funktionsleitung 91a an die Ausgangsschnittstelle 93 übermittelt.

Die Ausgangsschnittstelle 93 übermittelt das Aufgabendurchführungs-Kommando über einen Übertragungsweg 93a an das Zentralsystem Z oder einem oder mehreren Teilnehmern T bzw. T1, T2, T3 des Arbeitssystems S.

Die Ausgangsschnittstelle 93 kann insbesondere eine Übertragungsfunktion zum Übersenden des Aufgabendurchführungs-Kommandos generell über eine Netzwerkanbindung und dabei insbesondere per Funk aufweisen. Weiterhin kann die Ausgangsschnittstelle 93 derart ausgestaltet sein, dass die Aufgabendurchführungs-Kommando an das Zentralsystem Z und sämtliche Teilnehmer oder an sämtliche Teilnehmer und nicht an das Zentralsystem Z gesendet wird. Die Ausgangsschnittstelle 93 kann auch derart ausgeführt sein, dass diese Alternativen einzeln auswählbar sind aufgrund einer durch das Menü-Steuerungsmodul 96 angegebenen oder Menüauswahl in einer entsprechenden Menüebene.

Die zu den Figuren 104 und 105 beschriebenen Funktionen können auch auf andere Weise zusammengefasst und miteinander integriert sein, so dass insbesondere die angegebenen Funktionsverbindungen einfache funktonale Übergabestellen eines Programmsystems sein können.

Somit kann mit der Schaltvorrichtung nach einer der hierin beschriebenen Ausführungsformen kann eine von einem oder mehreren Teilnehmern T bzw. T1, T2, T3 des Arbeitssystems S zu erfüllende Teilnehmer-Aufgabe ermittelt, gegebenenfalls zur Anzeige gebracht werden, und als Aufgabendurchführungs-Kommando über einen Übertragungsweg 93a an das Zentralsystem Z oder einem oder mehreren Teilnehmern T bzw. T1, T2, T3 des Arbeitssystems S übermittelt werden.

Die hierin beschriebenen Funktionen der Auswertungsvorrichtung 90 können insbesondere in den Komponenten K des Grundkörpers 10 integriert und somit Bestandteil generell einer mobilen und insbesondere tragbaren Schaltvorrichtung und insbesondere der Schaltvorrichtung 1 nach einer Ausführungsform der Figuren 1 bis 88 sein. Jedoch können die beschriebenen Funktionen der Auswertungsvorrichtung 90 in einer Schaltvorrichtung integriert sein, die als Smartphone oder als Laptop und insbesondere als tragbarer Computer ausgeführt ist.

In der Figur 103 sind die Funktionen der Schaltvorrichtung in benutzerbezogener Weise dargestellt. Die Betätigung der Schaltvorrichtung in Verbindung mit einer in einem Steuerungsfeld von dem Menü-Steuerungsmodul 96 zur Anzeige gebrachten Menüauswahl ist mit dem Block "Physical Input" benannt. Die in einem Steuerungsfeld von dem Menü-Steuerungsmodul 96 durch eine zur Anzeige gebrachte Menüauswahl ist in dem mit dem Bezugszeichen "96" bezeichneten Block beispielsweise dargestellt.

In den Betätigungsbereichen können an der Display-Oberfläche 82a abschnittsweise zumindest ein räumlich ausgeprägter Oberflächenabschnitte 81r, 83r oder eine räumlich ausgeprägte Oberflächenstruktur zur haptischen Erfassung des jeweiligen Betätigungsbereichs ausgebildet sein. Die räumlich ausgeprägte Oberflächenabschnitte können gegenüber der flächigen Erstreckung der Display-Oberfläche 82a als vertiefte und/oder erhabene Stellen ausgeführt sein. Auf diese Weise kann ein Benutzer einen Betätigungsbereich innerhalb der ansonsten sich eben, also planar erstreckenden der Oberfläche 11a ertasten. Unter "räumlich ausgeprägter Struktur" wird hierin verstanden, dass diese eine plastische Formgebung hat, also eine Form hat, bei der die Oberflächenpunkte der Struktur nur mittels sämtlicher drei Raumkoordinanten definiert werden können.

In der Figur 103 sind Funktionen und Schritte einer Ausführungsform des Arbeitsverfahrens dargestellt. Generell können bei dem Arbeitsverfahren mehrere Schaltvorrichtungen und optional insbesondere gleichzeitig verwendet werden.

Nach einer Ausführungsform des Arbeitsverfahrens kann vorgesehen sein, dass für sämtliche oder einzelne verwendete Schaltvorrichtungen Berechtigungen für die Betätigung jeweils von Teilnehmern zu erfüllende Teilnehmer-Aufgaben oder für Aufgabenbereiche wie z.B. Lagerung, Produktion, Wareneingang, zu denen jeweils eine zu erfüllende Teilnehmer-Aufgabe gehört, bestehen. Dabei kann vorgesehen sein, dass zur Betätigung und Kommandierung der Durchführung einer zu erfüllenden Teilnehmer-Aufgabe oder zur Anwahl eines zugehörigen Aufgabenbereichs eine entsprechende Berechtigung freigeschaltet werden muss. Eine solche Sicherheitsfunktion kann in dem Zentralsystem bereitgestellt sein ("Vergabe Berechtigung"). Die Freischaltung kann über die Schnittsellen 93, 95 durch entsprechende Betätigung der Schaltvorrichtung in Verbindung mit einer in einem Steuerungsfeld von dem Menü-Steuerungsmodul 96 zur Anzeige gebrachten Menüauswahl erfolgen. Dabei kann auch vorgesehen sein, dass entsprechende Berechtigungen von dem Zentralsystem Z bereitgestellt werden, indem das Zentralsystem Z aufgrund des Empfangs eines Zugangscodes von einer Schaltvorrichtung freigegeben wird.

Nach einer Ausführungsform des Arbeitsverfahrens erfolgt nach Auswahl einer Teilnehmer-Aufgabe eine Übermittlung einer ausgewählten Teilnehmer-Aufgabe durch Betätigung der Schaltvorrichtung 1 an mehrere Teilnehmer T bzw. T1, T2, T3. Als Beispiele für einen Teilnehmer T sind ein Produktionsfahrzeug T1, eine Post-Fahrzeug T2 und eine Produktionsanlage T3 dargestellt.

Das Arbeitssystem S, in dem das Arbeitsverfahren erfolgt, kann insbesondere ein Lagersystem sein, wobei zumindest zwei Teilnehmer T; T1, T2, T3 Lagerbediengeräte wie z.B. Gabelstapler, Kräne, an einem Lagerregal bewegbare Fahrzeuge, oder eine Kombination zumindest einer Auswahl derselben sein.

Die Teilnehmer T bzw. T1, T2, T3 können jeweils ein Teilnehmer-System TS aufweisen, das eine Schnittstelle insbesondere zum Empfang eines von einer Ausgangsschnittstelle 93 übermittelten Aufgabendurchführungs-Kommandos auf. Weiterhin kann das Teilnehmer-System TS eine Prioritäten-Bewertungsfunktion aufweisen, mit der über einen Arbeitszeitraum empfangene Aufgabendurchführungs-Kommando jeweils eine Priorisierung der über einen vorgegebenen Arbeitszeitraum empfangenen Teilnehmer-Aufgaben erfolgt, die den empfangenen Aufgabendurchführungs-Kommandos entsprechen. Die Bedeutung und Inhalte von Aufgaben, die zu einem jeweiligen Aufgabendurchführungs-Kommando gehören, können in dem Teilnehmer T bzw. T1, T2, T3 verfügbar sein. Alternativ oder zusätzlich kann vorgesehen sein, dass diese gegebenenfalls insbesondere auf automatische Anfrage durch den jeweiligen Teilnehmer T bzw. T1, T2, T3 an das Zentralsystem Z von dem Zentralsystem Z dem jeweiligen Teilnehmer T bzw. T1, T2, T3 bereitgestellt wird.

In jedem oder in mehreren der Teilnehmer T bzw. T1, T2, T3 oder die eine Prioritäten-Bewertungsfunktion kann eine Funktion zur Konsistenzprüfung mit einem Vergleich der zu einem Zeitpunkt oder einem Zeitraum in den jeweils aktiven Teilnehmer T bzw. T1, T2, T3 erhaltenen Teilnehmer-Aufgaben, z.B. durch Bildung einer Gesamtliste der Teilnehmer-Aufgaben in jedem Teilnehmer-System TS, und ein Abgleich der Teilnehmer-Aufgaben zwischen den Teilnehmern T bzw. T1, T2, T3 derart erfolgt, dass vermieden wird, dass derselben Aufgabe die oberste Priorität zugewiesen wird. Alternativ oder zusätzlich kann eine solche Konsistenzprüfungs-Funktion auch im Zentralsystem Z vorgesehen sein. In einem Fall, in dem derselben Aufgabe die oberste Priorität zugewiesen worden ist, erfolgt ein Abgleich durch Verschiebung der Prioritäten z.B. nach einer vorbestimmten Priorisierung der jeweils betroffenen Teilnehmer, derart, dass vermieden wird, dass derselben Aufgabe die oberste Priorität zugewiesen wird.

Auf diese Weise erfolgt durch ein Steuerungssystem eine Abarbeitung der Aufgabe jeweils oberster Priorität durch den jeweiligen Teilnehmer T bzw. T1, T2, T3 derart, dass jeder Teilnehmer T bzw. T1, T2, T3 eine Aufgabe oberster Priorität erfüllt. Ein Steuerungssystem weist hierzu insbesondere eine Aufgaben-Durchführungsfunktion auf, mit der die inhaltliche Teilnehmer-Aufgaben, die zu einem jeweils empfangenen Aufgabendurchführungs-Kommando gehört, von dem jeweiligen Teilnehmer T bzw. T1, T2, T3 ausgeführt werden.

Dabei kann vorgesehen sein, dass dieses Arbeitsverfahren über einen längeren Zeitraum wie z.B. einen halben oder vollen Tag oder mehrere Tage abläuft, so dass also mehrere Teilnehmer-Aufgaben durchgeführt werden. Der Zeitraum kann dabei mindestens die dreifache der Zeitraums der zeitlich am kürzesten abzuarbeitenden Aufgabe sein.

## Patentansprüche

1. Verwendung einer Schaltvorrichtung (1) als Vorrichtung zur Eingabe von logistischen Daten in einem Lagerbereich, wobei die Schaltvorrichtung (1) aufweist:
- eine Gehäusevorrichtung (H) mit einem plattenförmigen Grundkörper (10) mit einer Anschluss-Oberfläche (10a), die einer Betätigungsseite (S1) der elektrischen Schaltvorrichtung (1) zugewandt ist, und mit einem Gehäuseteil (H1),
- ein in einer Dickenrichtung (Z) gesehen auf dieser angeordnetes plattenförmiges Betätigungsteil (20) mit einer der der Betätigungsseite (S1) zugewandten Betätigungsoberfläche (20a) und einer entgegen gesetzt zu dieser gelegenen Anschluss-Oberfläche (20b),
- ein in dem Betätigungsteil (20) integriertes Display (80) zur Anzeige von Darstellungen auf der Betätigungsseite (S1), wobei das Gehäuseteil (H1) aufweist: eine Seitenwand (H4), die die Verbindungsvorrichtung (30) und das Betätigungsteil (20) in der Dickenrichtung (Z) gesehen zumindest abschnittsweise umgibt, und einen Randabschnitt (H5), der sich zu der Betätigungsseite (S1) hin an der Seitenwand (H4) anschließt und eine zentrale Öffnung (H7) ausbildet, in der sich zumindest abschnittsweise das Display (80) erstreckt,
- eine Verbindungsvorrichtung (30) mit wenigstens einer Verbindungsschicht (31) aus einem elastischen Material, das an einem inneren Bereich (20c) der Anschluss-Oberfläche (20b) des Betätigungsteils (20) und mit einer zweiten Oberfläche (30b) an einem inneren Bereich (11) der Anschluss-Oberfläche (10a) des Grundkörpers (10) befestigt ist,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.

2. Verwendung einer Schaltvorrichtung (1) nach dem Anspruch 1, wobei die sich von dem Grundkörper (10) aus erstreckende Seitenwand (H4) das Betätigungsteil (20) in der Dickenrichtung (Z) gesehen zumindest abschnittsweise umgibt.

3. Verwendung einer Schaltvorrichtung (1) nach dem Anspruch 1, wobei der Randabschnitt (H5), der sich zu der Betätigungsseite (S1) hin an der Seitenwand (H4) anschließt, zumindest abschnittsweise entlang des Umfangs des Betätigungsteils (20) mit diesem verbunden ist und eine zentrale Öffnung (H7) ausbildet, in der sich zumindest abschnittsweise das Display (80) erstreckt.

4. Verwendung der Schaltvorrichtung (1) nach einem der vorstehenden Ansprüche,
- wobei das Betätigungsteil (20) ein Display (80) aufweist, das in einem in der Dickenrichtung (Z) gesehen inneren Bereich (20e) der Betätigungsoberfläche (20a) des Betätigungsteils (20) gelegen ist.
- wobei der innere Display-Bereich (20e) als an der Betätigungsoberfläche (20a) geformte Vertiefung ausgeführt ist und das Display (80) in der Dickenrichtung (Z) gesehenen zumindest teilweise in der Vertiefung gelegen ist.

5. Verwendung der Schaltvorrichtung (1) nach einem der voranstehenden Ansprüche, wobei die Schaltvorrichtung (1) als Vorrichtung zur Eingabe von logistischen Daten und zur Ausgabe von logistischen Daten jeweils in einem Lagerbereich verwendet wird.

6. Verwendung der Schaltvorrichtung (1) nach einem der voranstehenden Ansprüche, wobei die Schaltvorrichtung (1) als interaktive Mensch-Maschine-Schnittstelle in der Logistik und anderen industriellen Anwendungen, insbesondere in der Lagerbewirtschaftung und anderen Materialflusssystemen, verwendet wird,
- wobei auf dem Display (80) eine Anzahl aufgabenbezogener Alternativen anzeigbar ist,
- wobei über eine Eingabe des Benutzers, die auf Sensoren (41 bis 44) wirkt, eine Auswahl aus den angezeigten Alternativen erfolgt, worauf über die WLAN-Anbindung aus der zentralen Datenbank die nächste Aktion bzw. die nächste zu treffende Auswahl angezeigt wird.

7. Verwendung der Schaltvorrichtung (1) nach einem der voranstehenden Ansprüche,
- wobei die Schaltvorrichtung (1) zur menügeführten Auswahl einer Aufgabe in der Lagerlogistik und in anderen industriellen Anwendungen verwendet wird,
- wobei in der zentralen Datenbank für eine Mehrzahl von Aufgaben Apps verfügbar gehalten werden, die über die Netzwerkanbindung auf dem Display (80) wiedergebbare Handlungsabfolgen, Alternativen zur aufgabenbezogenen Auswahl und/oder zu notwendigen Eingaben von Informationen anzeigbar machen,
- wobei der Benutzer die zur anstehenden Aufgabe entsprechende App auswählt und diese interaktiv unter Verwendung der Eingabemöglichkeiten über die Sensoren (41, 42, 43, 44) sowie unter Beachtung der Darstellungen auf dem Display (80) abarbeitet.

8. Verwendung einer Schaltvorrichtung (1) nach dem Anspruch 1 mit Eingabemitteln und einem Display zur menügeführten Auswahl einer Aufgabe in einem Arbeitssystem (S) und insbesondere in einer Lagersystem oder einer Produktionsanlage oder anderen industriellen Anwendungen, wobei in einer zentralen Datenbank für eine Mehrzahl von Aufgaben Anwendungsfunktionen (App) verfügbar gehalten werden, die über eine Netzwerkanbindung auf dem Display (80) wiedergebbare Handlungsabfolgen, Alternativen zur aufgabenbezogene Auswahl und/oder zu notwendigen Eingaben von Informationen anzeigbar machen, wobei der Benutzer die zur anstehenden Aufgabe entsprechende Anwendungsfunktionen (App) auswählt und diese interaktiv unter Verwendung der Eingabemittel sowie unter Beachtung der Darstellungen auf dem Display (80) abarbeitet.

9. Arbeitssystem mit zumindest einer Schaltvorrichtung (1), einem Zentralsystem und mehrere Arbeitsbereich-Teilnehmern (T), wobei die Schaltvorrichtung (1) aufweist:
- eine Gehäusevorrichtung (H) mit einem plattenförmigen Grundkörper (10) mit einer Anschluss-Oberfläche (10a), die einer Betätigungsseite (S1) der elektrischen Schaltvorrichtung (1) zugewandt ist, und mit einem Gehäuseteil (H1),
- ein in einer Dickenrichtung (Z) gesehen auf dieser angeordnetes plattenförmiges Betätigungsteil (20) mit einer der der Betätigungsseite (S1) zugewandten Betätigungsoberfläche (20a) und einer entgegen gesetzt zu dieser gelegenen Anschluss-Oberfläche (20b),
- ein in dem Betätigungsteil (20) integriertes Display (80) zur Anzeige von Darstellungen auf der Betätigungsseite (S1), wobei das Gehäuseteil (H1) aufweist: eine Seitenwand (H4), die die Verbindungsvorrichtung (30) und das Betätigungsteil (20) in der Dickenrichtung (Z) gesehen zumindest abschnittsweise umgibt, und einen Randabschnitt (H5), der sich zu der Betätigungsseite (S1) hin an der Seitenwand (H4) anschließt und eine zentrale Öffnung (H7) ausbildet, in der sich zumindest abschnittsweise das Display (80) erstreckt,
- eine Verbindungsvorrichtung (30) mit wenigstens einer Verbindungsschicht (31) aus einem elastischen Material, das an einem inneren Bereich (20c) der Anschluss-Oberfläche (20b) des Betätigungsteils (20) und mit einer zweiten Oberfläche (30b) an einem inneren Bereich (11) der Anschluss-Oberfläche (10a) des Grundkörpers (10) befestigt ist,
- zumindest ein Sensor (41, 42, 43, 44), der zwischen dem Grundkörper (10) und dem Betätigungsteil (20) gelegen sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Bereichs der zweiten Oberfläche in der Dickenrichtung (Z) erfasst werden kann.
- eine Ausgangs-Schnittstelle (93), die aufgrund der Bereitstellung zumindest eines Steuerungsfelds mittels eines Menü-Steuerungsmodul (96) Aufgabenerfüllungs-Kommandos erzeugt und wahlweise
- an das Zentralsystem (Z),
- sämtlichen der mehreren Arbeitsbereich-Teilnehmern (T),
- einzelnen der mehreren Arbeitsbereich-Teilnehmern (T) übermittelt.

10. Arbeitssystem (S) nach dem Anspruch 9, wobei die sich von dem Grundkörper (10) aus erstreckende Seitenwand (H4) der Schaltvorrichtung (1) das Betätigungsteil (20) in der Dickenrichtung (Z) gesehen zumindest abschnittsweise umgibt.

11. Arbeitssystem (S) nach dem Anspruch 10, wobei der Randabschnitt (H5) der Schaltvorrichtung (1), der sich zu der Betätigungsseite (S1) hin an der Seitenwand (H4) der Schaltvorrichtung (1) anschließt, zumindest abschnittsweise entlang des Umfangs des Betätigungsteils (20) mit diesem verbunden ist und eine zentrale Öffnung (H7) ausbildet, in der sich zumindest abschnittsweise das Display (80) erstreckt.

12. Arbeitsverfahren mit Verwendung einer Schaltvorrichtung (1) nach Anspruch 1, die als Handgerät ausgeführt ist und Eingabemittel und ein Display zur menügeführten Auswahl und Ausführung einer Aufgabe in einem industriellen Arbeitssystem (S) aufweist,
- Bereitstellung einer Mehrzahl von Aufgaben-Anwendungsfunktionen (App) in einer zentralen Datenbank,
- über eine Netzwerkanbindung auf dem Display (80) der Schaltvorrichtung (1) Anzeige von wiedergebbaren Handlungsabfolgen, Teilnehmer-Aufgaben und/oder Alternativen zur aufgabenbezogene Auswahl und/oder zu notwendigen Eingaben von Informationen,
- durch einen Benutzer Auswahl von zur anstehenden Aufgabe entsprechenden Anwendungsfunktionen (App),
- Abarbeitung dieser Aufgaben interaktiv unter Verwendung der Eingabemittel sowie unter Beachtung der Darstellungen auf dem Display (80).

13. Arbeitsverfahren nach dem Anspruch 12,
wobei in der ausgewählten Anwendungsfunktion (App) zumindest eine von einem oder mehreren Teilnehmern (T; T1, T2, T3) des Arbeitssystems (S) zu erfüllende Teilnehmer-Aufgabe auf dem Display (80) auswählbar ist,
wobei nach Auswahl einer Teilnehmer-Aufgabe eine Übermittlung einer ausgewählten Teilnehmer-Aufgabe durch Betätigung der Schaltvorrichtung (1) an mehrere Teilnehmer (T; T1, T2, T3) erfolgt,
wobei bei den Teilnehmer (T; T1, T2, T3) jeweils eine Priorisierung der über einen vorgegebenen Arbeitszeitraum mittels Aufgabendurchführungs-Kommandos empfangenen Teilnehmer-Aufgaben erfolgt,
wobei eine Konsistenzprüfung und ein Abgleich der Teilnehmer-Aufgaben zwischen den Teilnehmern (T; T1, T2, T3) derart erfolgt, dass vermieden wird, dass derselben Aufgabe die oberste Priorität zugewiesen wird,
wobei eine Abarbeitung der Aufgabe jeweils oberster Priorität durch den jeweiligen Teilnehmer (T; T1, T2, T3) erfolgt, so dass jeder Teilnehmer (T; T1, T2, T3) eine Aufgabe oberster Priorität erfüllt.

14. Arbeitsverfahren nach dem Anspruch 12 oder 13, wobei das industrielle Arbeitssystem (S) ein Lagersystem ist und wobei zumindest zwei Teilnehmer (T; T1, T2, T3) Lagerbediengeräte sind.

15. Arbeitsverfahren nach einem der Ansprüche 12 bis 14, wobei über eine Ausgangs-Schnittstelle (95) der Schaltvorrichtung (1) in durch Betätigung der Schaltvorrichtung (1) auswählbaren Menüformaten Steuerungsfelder bereit gestellt werden, mittels eines Menü-Steuerungsmodul (96) Aufgabendurchführungs-Kommandos erzeugt werden und wahlweise
- an das Zentralsystem (Z),
- sämtlichen der mehreren Arbeitsbereich-Teilnehmer (T),
- einzelnen der mehreren Arbeitsbereich-Teilnehmer (T)
übermittelt werden.

## Claims

1. Use of a switch device (1) as device for entering logistical data in a storage area, the switch device (1) comprising:
- a housing device (H) with a plate-shaped body (10) with a connection surface (10a), which is facing an actuation side (S1) of the electrical switch device (1), and with a housing part (H1),
- a plate-shaped actuation part (20) arranged thereon, viewed in the thickness direction (Z), with an actuation surface (20a) facing the actuation side (S1) and a connection surface (20b) located opposite thereto,
- a display (80) integrated in the actuation part (20) for displaying images on the actuation side (S1), wherein the housing part (H1) comprises: a side wall (H4), which, viewed in the thickness direction (Z), surrounds the connection device (30) and the actuation part (20) at least in some sections and an edge section (H5) which adjoins to the side wall (H4) towards the actuation side (S1) and forms a central opening (H7), in which the display (80) extends, at least in some sections,
- a connection device (30) with at least one connection layer (31) made from an elastic material, which is attached to an inner area (20c) of the connection surface (20b) of the actuation part (20) and is fixed with a second surface (30b) to an inner area (11) of the connection surface (10a) of the main body (10),
- at least one sensor (41, 42, 43, 44), which is located between the main body (10) and the actuation part (20) and, viewed in the thickness direction (Z), is located at the lateral side of the connection device (30), so that each sensor (41, 42, 43, 44) can be used to detect a position of one region, arranged at said sensor, of the second surface in the thickness direction (Z).

2. Use of a switch device (1) according to claim 1, wherein the side wall (H4) which extends from the body (10) surrounds the actuation part (20), viewed in the thickness direction (Z), at least in some sections.

3. Use of a switch device (1) according to claim 1, wherein the edge section (H5), which adjoins to the side wall (H4) in direction towards the actuation side (S1), is connected to the same at least in sections along the circumference of the actuation part (20) and forms a central opening (H7) in which the display (80) extends, at least in sections.

4. Switch device (1) according to any one of the preceding claims,
- wherein the actuation part (20) comprises a display (80), which is located in an inner area (20e) of the actuation surface (20a) of the actuation part (20), viewed in the thickness direction (Z),
- wherein the internal display area (20e) is designed as a recess formed on the actuation surface (20a) and the display (80), viewed in the thickness direction (Z), is located at least partially in the recess.

5. Use of the switch device (1) according to any one of the preceding claims, wherein the switch device (1) is used as a device for entering logistic data and for outputting logistic data in each case in a storage area.

6. Use of the switch device (1) according to any one of the preceding claims, wherein the switch device (1) is used as an interactive human-machine interface in the logistics field and other industrial applications, in particular in warehouse management and other material flow systems,
- wherein a number of task-related alternatives can be displayed on the display (80),
- wherein via a user's input, which acts on sensors (41 to 44), a selection is made from the displayed alternatives, whereupon the next action, or the next selection to be made, is displayed from the central database via the WLAN link.

7. Use of the switch device (1) according to any one of the preceding claims,
- wherein the switch device (1) is used for menu-guided selection of a task in storage logistics and in other industrial applications,
- wherein apps are held available in the central database for a multiplicity of tasks, which present on the display (80) via the network link reproducible sequences of actions, alternatives to the task-related selection and/or to necessary inputs of information,
- wherein the user selects the app appropriate to the pending task and then processes this interactively using the input devices via the sensors (41, 42, 43, 44) and in observance of the representations on the display (80).

8. Use of a switch device (1) according to claim 1 which comprises input means and a display for the menu-guided selection of a task in an operating system (S) and in particular in a storage system or a production plant or other industrial applications, wherein application functions (apps) are held available in a central database for a multiplicity of tasks, which present on the display (80) via a network link sequences of actions, alternatives to the task-related selection and/or to necessary inputs of information that can be reproduced, wherein the user selects the application functions (apps) appropriate to the pending task and processes them interactively using the input devices and in observance of the representations on the display (80).

9. Operating system with at least one switch device (1), a central system and a plurality of work-area participants (T), the switch device (1) comprising:
- a housing device (H) with a plate-shaped body (10) with a connection surface (10a), which is facing an actuation side (S1) of the electrical switch device (1), and with a housing part (H1),
- a plate-shaped actuation part (20) arranged thereon, viewed in the thickness direction (Z), with an actuation surface (20a) facing the actuation side (S1) and a connection surface (20b) located opposite thereto,
- a display (80) integrated in the actuation part (20) for displaying images on the actuation side (S1), wherein the housing part (H1) comprises: a side wall (H4), which, viewed in the thickness direction (Z), surrounds the connection device (30) and the actuation part (20) at least in some sections and an edge section (H5) which adjoins to the side wall (H4) towards the actuation side (S1) and forms a central opening (H7), in which the display (80) extends, at least in some sections,
- a connection device (30) with at least one connection layer (31) made from an elastic material, which is attached to an inner area (20c) of the connection surface (20b) of the actuation part (20) and is fixed with a second surface (30b) to an inner area (11) of the connection surface (10a) of the main body (10),
- at least one sensor (41, 42, 43, 44), which is located between the main body (10) and the actuation part (20) and, viewed in the thickness direction (Z), is located at the lateral side of the connection device (30), so that each sensor (41, 42, 43, 44) can be used to detect a position of one region, arranged at said sensor, of the second surface in the thickness direction (Z),
- an output interface (93), which, due to the provision of at least one control field, generates task execution commands by means of a menu control module (96) and optionally transmits
- to the central system (Z),
- to all of the plurality of work-area participants (T),
- individual participants from the plurality of work-area participants (T).

10. Operating system (S) according to claim 9, wherein the side wall (H4) which extends from the body (10) surrounds the actuation part (20), viewed in the thickness direction (Z), at least in some sections.

11. Operating system (S) according to claim 10, wherein the edge section (H5) of the switch device (1), which adjoins to the side wall (H4) in direction towards the actuation side (S1), is connected to the same at least in sections along the circumference of the actuation part (20) and forms a central opening (H7) in which the display (80) extends, at least in sections.

12. Operating method using a mobile switch device (1) according to claim 1, which is designed as a hand-held device and comprises input means and a display for the menu-guided selection and execution of a task in an industrial operating system (S),
- provision of a multiplicity of task-application functions (apps) in a central database,
- via a network link display of reproducible action sequences, participant tasks and/or alternatives to the task-related selection and/or to the necessary inputs of information on the display (80) of the switch device (1),
- selection by a user of application functions (apps) appropriate to the pending task,
- processing of these tasks interactively using the input means and in observance of the representations on the display (80).

13. Operating method according to claim 12,
wherein in the selected application function (app), at least one participant task to be performed by one or more participants (T; T1, T2, T3) of the operating system (S) can be selected on the display (80),
wherein after selection of a participant task a selected participant task is transmitted to multiple participants (T; T1, T2, T3) by actuating the switch device (1),
wherein among each of the the participants (T; T1, T2, T3) a prioritization of the participant tasks received over a pre-defined work period takes place, by means of task execution commands,
wherein a consistency check and a reconciliation of the participant tasks between the nodes (T; T1, T2, T3) is effected, in such a way as to avoid the highest priority being assigned to the same task,
wherein the task with top priority in each case is processed by the respective participant (T; T1, T2, T3), so that each participant (T; T1, T2, T3) executes a top priority task.

14. Operating method according to Claim 12 or 13, wherein the industrial operating system (S) is a storage system, and wherein at least two participants (T; T1, T2, T3) are warehouse operating devices.

15. Operating method according to one of Claims 12 to 14, wherein control fields are provided via an output interface (95) of the switch device (1) in menu formats that are selectable by actuating the switch device (1), and by means of a menu control module (96), task execution commands are generated and optionally submitted
- to the central system (Z),
- to all of the plurality of work-area participants (T),
- individual participants from the plurality of work-area participants (T).

## Revendications

1. Utilisation d'un dispositif de commutation (1) en tant que dispositif pour l'entrée de données logistiques dans une zone d'entreposage, dans laquelle le dispositif de commutation (1) présente :
- un dispositif de boîtier (H) avec un corps de base en forme de plaque (10) avec une surface de raccordement (10a), laquelle est tournée vers un côté d'actionnement (S1) du dispositif de commutation électrique (1), et avec une partie de boîtier (H1),
- une partie d'actionnement (20) en forme de plaque, disposée sur celui-ci en vue dans le sens de l'épaisseur (Z), avec une surface d'actionnement (20a) tournée vers le côté d'actionnement (S1) et une surface de raccordement (20b) située en opposition à celle-ci,
- un écran (80) intégré dans la partie d'actionnement (20) pour l'affichage de représentations sur le côté d'actionnement (S1), dans laquelle la partie de boîtier (H1) présente : une paroi latérale (H4) qui entoure au moins partiellement le dispositif de liaison (30) et la partie d'actionnement (20) en vue dans le sens de l'épaisseur (Z), et une partie de bord (H5) qui est en jonction vers le côté d'actionnement (S1) avec la paroi latérale (H4) et forme une ouverture centrale (H7) dans laquelle l'écran (80) s'étend au moins partiellement,
- un dispositif de liaison (30) avec au moins une couche de liaison (31) en un matériau élastique qui est fixé au niveau d'une zone intérieure (20c) de la surface de raccordement (20b) de la partie d'actionnement (20) et est fixé avec une deuxième surface (30b) au niveau d'une zone intérieure (11) de la surface de raccordement (10a) du corps de base (10),
- au moins un capteur (41, 42, 43, 44), lequel est situé entre le corps de base (10) et la partie d'actionnement (20) ainsi que, en vue dans le sens de l'épaisseur (Z), est situé latéralement par rapport au dispositif de liaison (30) de sorte qu'avec chaque capteur (41, 42, 43, 44), il est possible de détecter respectivement une position d'une zone respectivement située au niveau de celle-ci de la deuxième surface dans le sens de l'épaisseur (Z).

2. Utilisation d'un dispositif de commutation (1) selon la revendication 1, dans laquelle la paroi latérale (H4) s'étendant à partir du corps de base (10) entoure au moins partiellement la partie d'actionnement (20) en vue dans le sens de l'épaisseur (Z).

3. Utilisation d'un dispositif de commutation (1) selon la revendication 1, dans laquelle la partie de bord (H5), laquelle est en jonction vers le côté d'actionnement (S1) avec la paroi latérale (H4), est reliée au moins partiellement à la partie d'actionnement (20) le long du pourtour de celle-ci et forme une ouverture centrale (H7) dans laquelle l'écran (80) s'étend au moins partiellement.

4. Utilisation du dispositif de commutation (1) selon l'une des revendications précédentes,
- dans laquelle la partie d'actionnement (20) présente un écran (80) qui est situé, en vue dans le sens de l'épaisseur (Z), dans une zone intérieure (20e) de la surface d'actionnement (20a) de la partie d'actionnement (20),
- dans laquelle la zone d'écran intérieure (20e) est réalisée en tant que creux formé au niveau de la surface d'actionnement (20a) et l'écran (80) est situé au moins partiellement dans le creux en vue dans le sens de l'épaisseur (Z).

5. Utilisation du dispositif de commutation (1) selon l'une des revendications précédentes, dans laquelle le dispositif de commutation (1) est utilisé en tant que dispositif pour l'entrée de données logistiques et pour la sortie de données logistiques respectivement dans une zone d'entreposage.

6. Utilisation du dispositif de commutation (1) selon l'une des revendications précédentes, dans laquelle le dispositif de commutation (1) est utilisé en tant qu'interface homme-machine interactive pour la logistique et d'autres applications industrielles, en particulier pour la gestion de l'entreposage et d'autres systèmes de flux de matériaux,
- dans laquelle il est possible d'afficher sur l'écran (80) un certain nombre d'alternatives en fonction des tâches,
- dans laquelle, via une entrée de l'utilisateur, laquelle agit sur des capteurs (41 à 44), une sélection à partir des alternatives affichées s'effectue après quoi, via la connexion WLAN, on affiche, à partir de la base de données centrale, l'action suivante ou la sélection suivante à effectuer.

7. Utilisation du dispositif de commutation (1) selon l'une des revendications précédentes,
- dans laquelle le dispositif de commutation (1) est utilisé pour la sélection guidée par menu pour la logistique d'entreposage et d'autres applications industrielles,
- dans laquelle des apps sont gardées à disposition dans la base de données centrale pour une pluralité de tâches, lesquelles rendent affichables à l'écran (80), via la connexion réseau, des séquences d'action reproductibles, des alternatives pour la sélection en fonction des tâches et/ou pour des entrées nécessaires d'informations,
- dans laquelle l'utilisateur sélectionne l'app correspondant à la tâche en suspens et exécute celle-ci interactivement en utilisant les possibilités d'entrée via les capteurs (41, 42, 43, 44) ainsi qu'en tenant compte des représentations à l'écran (80).

8. Utilisation d'un dispositif de commutation (1) selon la revendication 1 avec des moyens d'entrée et un écran pour la sélection guidée par menu d'une tâche dans un système de travail (S) et en particulier dans un système d'entreposage ou une installation de production ou d'autres applications industrielles, dans laquelle, dans une base de données centrale, des fonctions applicatives (app) pour une pluralité de tâches sont gardées à disposition, lesquelles rendent affichables sur l'écran (80), via une connexion réseau, des séquences d'action reproductibles, des alternatives pour la sélection en fonction des tâches et/ou pour des entrées nécessaires d'informations, dans laquelle l'utilisateur sélectionne la fonction applicative (app) correspondante pour la tâche en suspens et exécute celle-ci interactivement en utilisant les moyens d'entrée ainsi qu'en tenant compte des représentations sur l'écran (80).

9. Système de travail avec au moins un dispositif de commutation (1), un système central et plusieurs participants de zone de travail (T), dans lequel le dispositif de commutation (1) présente :
- un dispositif de boîtier (H) avec un corps de base en forme de plaque (10) avec une surface de raccordement (10a), laquelle est tournée vers un côté d'actionnement (S1) du dispositif de commutation électrique (1), et avec une partie de boîtier (H1),
- une partie d'actionnement en forme de plaque (20) disposée sur celui-ci en vue dans le sens de l'épaisseur (Z), avec une surface d'actionnement (20a) tournée vers le côté d'actionnement (S1) et une surface de raccordement (20b) située en opposition à celle-ci,
- un écran (80) intégré dans la partie d'actionnement (20) pour l'affichage de représentations sur le côté d'actionnement (S1), dans laquelle la partie de boîtier (H1) présente : une paroi latérale (H4) qui entoure au moins partiellement le dispositif de liaison (30) et la partie d'actionnement (20) en vue dans le sens de l'épaisseur (Z), et une partie de bord (H5) qui est en jonction vers le côté d'actionnement (S1) avec la paroi latérale (H4) et forme une ouverture centrale (H7) dans laquelle l'écran (80) s'étend au moins partiellement,
- un dispositif de liaison (30) avec au moins une couche de liaison (31) en un matériau élastique qui est fixé au niveau d'une zone intérieure (20c) de la surface de raccordement (20b) de la partie d'actionnement (20) et est fixé avec une deuxième surface (30b) au niveau d'une zone intérieure (11) de la surface de raccordement (10a) du corps de base (10),
- au moins un capteur (41, 42, 43, 44), lequel est situé entre le corps de base (10) et la partie d'actionnement (20) ainsi que, en vue dans le sens de l'épaisseur (Z), est situé latéralement par rapport au dispositif de liaison (30) de sorte qu'avec chaque capteur (41, 42, 43, 44), il est possible de détecter respectivement une position d'une zone respectivement située au niveau de celle-ci de la deuxième surface dans le sens de l'épaisseur (Z),
- une interface de sortie (93) laquelle, en raison de la mise à disposition d'au moins un champ de commande, génère, au moyen d'un module de commande de menu (96), des instructions d'accomplissement de tâches et peut les transmettre au choix
- au système central (Z),
- à l'ensemble des plusieurs participants de zone de travail (T),
- à des participants individuels des plusieurs participants de zone de travail (T).

10. Système de travail (S) selon la revendication 9, dans lequel la paroi latérale (H4), s'étendant à partir du corps de base (10), du dispositif de commutation (1) entoure la partie d'actionnement (20) au moins partiellement en vue dans le sens de l'épaisseur (Z).

11. Système de travail (S) selon la revendication 10, dans lequel la partie de bord (H5) du dispositif de commutation (1), laquelle est en jonction vers le côté d'actionnement (S1) avec la paroi latérale (H4) du dispositif de commutation (1), est reliée au moins partiellement à la partie d'actionnement (20) le long du pourtour de celle-ci et forme une ouverture centrale (H7) dans laquelle l'écran (80) s'étend au moins partiellement.

12. Procédé de travail avec l'utilisation d'un dispositif de commutation (1) selon la revendication 1, lequel est réalisé en tant qu'appareil portable et présente des moyens d'entrée et un écran pour la sélection guidée par menu d'une tâche dans un système de travail industriel (S),
- la mise à disposition d'une pluralité de fonctions applicatives de tâches (app) dans une base de données centrale,
- via une connexion réseau, l'affichage sur l'écran (80) du dispositif de commutation (1) de séquences d'action reproductibles, de tâches de participants et/ou d'alternatives pour la sélection en fonction d'une tâche et/ou pour des entrées nécessaires d'informations,
- la sélection par un utilisateur de fonctions applicatives (app) correspondant à la tâche en suspens,
- le traitement interactif de ces tâches en utilisant les moyens d'entrée ainsi qu'en tenant compte des représentations sur l'écran (80).

13. Procédé de travail selon la revendication 12,
dans lequel, dans la fonction applicative sélectionnée (app), au moins une tâche de participant à accomplir par un ou plusieurs participants (T; T1, T2, T3) du système de travail (S) est sélectionnable à l'écran (80),
dans lequel, après la sélection d'une tâche de participant, il y a une transmission d'une tâche de participant sélectionnée à plusieurs participants (T; T1, T2, T3) par actionnement du dispositif de commutation (1),
dans lequel il y a, au niveau des participants (T; T1, T2, T3), respectivement une priorisation des tâches de participant réceptionnées sur une période de travail prescrite au moyen d'instructions d'exécution de tâches,
dans lequel une vérification de cohérence et un équilibrage des tâches de participants entre les participants (T; T1, T2, T3) ont lieu de manière à éviter d'attribuer la plus haute priorité à la même tâche,
dans lequel un traitement de la tâche respectivement de priorité la plus élevée par le participant respectif (T; T1, T2, T3) a lieu, de sorte que chaque participant (T; T1, T2, T3) accomplit une tâche de priorité la plus élevée.

14. Procédé de travail selon la revendication 12 ou 13, dans lequel le système de travail industriel (S) est un système d'entreposage et dans lequel au moins deux participants (T; T1, T2, T3) sont des appareils de commande d'entreposage.

15. Procédé de travail selon l'une des revendications 12 à 14, dans lequel, via une interface de sortie (95) du dispositif de commutation (1), dans des formats de menu sélectionnables par actionnement du dispositif de commutation (1), des champs de commande sont mis à disposition, au moyen d'un module de commande de menu (96) des instructions d'exécution de tâches sont générées et sont transmises au choix
- au système central (Z),
- à l'ensemble des plusieurs participants de zone de travail (T),
- à des participants individuels des plusieurs participants de zone de travail (T).
